(19)

Europäisches Patentamt
European Patent Office
Office européen des brevets

(11) **EP 1 299 950 B1**

(12) **EUROPÄISCHE PATENTSCHRIFT**

(45) Veröffentlichungstag und Bekanntmachung des Hinweises auf die Patenterteilung:
**21.05.2008 Patentblatt 2008/21**

(21) Anmeldenummer: **00940689.3**

(22) Anmeldetag: **13.07.2000**

(51) Int Cl.:
**H03K 17/567** (2006.01)

(86) Internationale Anmeldenummer:
**PCT/IB2000/000949**

(87) Internationale Veröffentlichungsnummer:
**WO 2002/007315 (24.01.2002 Gazette 2002/04)**

(54) **VERFAHREN UND VORRICHTUNG ZUR ZUSTANDSABHÄNGIGEN REGELUNG DES TRANSIENTEN VERHALTENS VON LEISTUNGSHALBLEITERSCHALTERN**

METHOD AND DEVICE FOR A CONDITION-DEPENDENT CONTROL OF THE TRANSIENT BEHAVIOR OF POWER SEMICONDUCTOR SWITCHES

PROCEDE ET DISPOSITIF POUR LE REGLAGE, EN FONCTION DE L'ETAT, DU COMPORTEMENT TRANSITOIRE DE COMMUTATEURS A SEMI-CONDUCTEUR DE PUISSANCE

(84) Benannte Vertragsstaaten:
**AT BE CH CY DE DK ES FI FR GB GR IE IT LI LU MC NL PT SE**

(43) Veröffentlichungstag der Anmeldung:
**09.04.2003 Patentblatt 2003/15**

(73) Patentinhaber: **CT-Concept Technologie AG**
**2504 Biel (CH)**

(72) Erfinder: **THALHEIM, Jan**
**CH-8912 Obfelden (CH)**

(74) Vertreter: **Blum, Rudolf Emil**
**E. BLUM & Co. AG**
**Patent- und Markenanwälte VSP**
**Vorderberg 11**
**8044 Zürich (CH)**

(56) Entgegenhaltungen:
EP-A- 0 797 301 DE-A- 4 429 733
DE-A- 19 744 848 US-A- 4 894 568

• RÜEDI H: "Intelligent interfaces between power and control: Gate drivers for IGBTs" COMPONENTS, Bd. XXXI, Nr. 3, 1996, Seiten 8-11, XP002162535
• RÜEDI H, KÖHLI P: "Dynamic Gate Controller (DGC) - A new IGBT Gate Unit for High Current / High Voltage IGBT Modules" INTERNATIONAL POWER CONVERSION - JUNE 1995 PROCEEDINGS, Juni 1995 (1995-06), Seiten 241-249, XP000991349 Nürnberg in der Anmeldung erwähnt

## Beschreibung

Die Erfindung bezieht sich auf das Gebiet der Leistungs-elektronik. Sie geht aus von einem Verfahren und einer Vorrichtung zur Regelung des transienten Verhaltens von Leistungshalbleiterschaltern gemäss Oberbegriff der unabhängigen Ansprüche.

Ein derartiges Verfahren ist in dem Artikel von H. Rüedi et al., "Dynamic Gate Controller (DGC) - A new IGBT Gate Unit for High Current/High Voltage Modules", PCIM'95 (Official Proceedings of the International Power Conversion), p. 241-249, Nürnberg, Germany, 1995 offenbart. Ein IGBT wird mit einem dynamischen Gatekontroller (DGC) so angesteuert, dass konstant vorgegebene Werte der zeitlichen Ableitungen der Kollektor-Emitter-Spannung über dem IGBT (Spannungsgradient $dv_{CE}/dt$) und des Stroms durch die Freilaufdiode oder den IGBT (Kollektorstromgradient $di_C/dt$) beim Schalten unabhängig vom Laststrom und der DC-Bus-Spannung eingehalten werden. Hierfür werden zum Spannungs- und Stromgradienten proportionale Signale auf den Eingang des Gate-Treibers zurückgeführt. Als Signal für den Stromgradienten $di_C/dt$ dient die Spannung über der Emitter-Hilfsemitter Induktivität eines IGBT-Moduls oder das Signal einer Feldprobe an einem Leistungsterminal eines IGBT-Moduls.

Mit dem DGC kann zwar eine aufwendige Beschaltung mit einem Snubber-Netzwerk vermieden werden. Jedoch ist der DGC für Reihenschaltungen von IGBTs wenig geeignet. Obwohl der Stromgradient $di_C/dt$ für jedes reihengeschaltete IGBT-Modul identisch ist, führen Unterschiede zwischen den individuellen Transferfaktoren in den IGBT-Regelkreisen zu Abweichungen vom idealen Gatestrom. Diese Fehler verursachen eine unterschiedliche Aufladung der äquivalenten Ausgangskapazitäten der IGBTs und damit einen unkontrollierten Anstieg der individuellen Kollektor-Emitter-Spannungen einzelner IGBTs. Infolgedessen können in Serie angeordnete IGBTs nicht mit hinreichender Genauigkeit synchron geschaltet werden. Die seriellen Kollektor-Emitter Spannungen sind dann nur dadurch symmetrisierbar, dass die Einschaltgeschwindigkeit auf Kosten höherer transienter Verluste verringert wird.

Darüberhinaus ist die DGC-Steuerung aufgrund der konstanten und zum Teil gegensätzlich wirkenden Sollwertvorgaben für den Spannungs- und Stromgradienten nicht geeignet, das stark nichtlineare Verhalten von IGBTs besonders beim schnellen Einschalten zuverlässig zu regeln. Vor allem bleibt das Ablöseverhalten der beiden Regelkreise für den Stromgradienten $di_C/dt$ und den Spannungsgradienten $dv_{CE}/dt$ unkontrolliert. Im Extremfall geht durch ein oszillierendes Ablöseverhalten die Steuerbarkeit des IGBTs während des Schaltvorgangs verloren.

Ein weiteres Problem ergibt sich aus dem Trend zur Verringerung der Emitter-Hilfsemitter Induktivität. Die dadurch erforderliche hohe Signalverstärkung führt zu einer stark eingeschränkten Regelungsdynamik. Aufgrund der endlichen Anstiegsgeschwindigkeiten der Regelkreise wird jedoch u. a. das Problem der mangelnden Steuerbarkeit im Ablösebereich weiter verschärft.

In der EP 0 797 301 wird ein Einschaltvorgang eines IGBTs dadurch gesteuert, dass ein Gatestrom als Stellgrösse zur Regelung einer Gatespannung verwendet wird. Dabei wird darauf vertraut, dass zwischen der Gatespannung oberhalb der Schwellenspannung und dem Laststrom ein quadratischer Zusammenhang besteht. Ein IGBT-Regelkreis mit einer Rückkopplung von Zustandsvariablen, die den leistungsseitigen Zustand des IGBTs charakterisieren, zum Gate-Treiber ist nicht vorgesehen. Ein nur gateseitiger Regelkreis ist aber zur Steuerung des nichtlinearen Schaltverhaltens von IGBTs unzureichend.

Es ist Aufgabe der Erfindung, ein Verfahren und eine Vorrichtung zur aktiven Regelung des transienten Schaltvorgangs von Leistungshalbleiterschaltern anzugeben, das besonders zur Synchronisierung des Schaltverhaltens serieller Leistungshalbleiterschalter geeignet ist.

In einem ersten Aspekt der Erfindung wird ein Regelverfahren für transiente Schaltvorgänge eines Leistungshalbleiterschalters vorgeschlagen, wobei der Schalter mindestens einen durch einen Gate-Treiber gesteuerten Steueranschluss oder ein Gate, einen ersten Leistungsanschluss oder Kollektor und einen zweiten Leistungsanschluss oder Emitter umfasst, wobei in Serie zum Leistungshalbleiterschalter eine Freilaufdiode angeordnet ist, wobei ferner für mindestens eine primäre Zustandsvariable des Leistungshalbleiterschalters mindestens ein Istwert bestimmt oder approximiert und zum Gate-Treiber zurückgeführt wird und der Istwert und ein Sollwert der Zustandsvariablen als Eingangsgrössen zur Erzeugung eines Stellsignals für den Steueranschluss verwendet werden, derart, dass in einer Phase A, in welcher die Freilaufdiode in einem leitfähigen Zustand ist, ein Kollektorstromgradient des Leistungshalbleiterschalters geregelt wird und in einer Phase B, in welcher die Freilaufdiode in einem Sperrzustand ist, ein Kollektor-Emitter-Spannungsgradient des Leistungshalbleiterschalters geregelt wird. Beide Gradienten können direkte Regelgrössen des Regelkreises sein oder über andere Regelgrössen indirekt geregelt werden. Die primäre Zustandsvariable dient zur Charakterisierung des Zustands, insbesondere der elektrischen und/oder thermischen Belastung, des Leistungshalbleiterschalters im Leistungskreis. Sie kann z. B. eine Kollektorspannung, ein Kollektorstrom oder ein Gradient dieser Grössen sein. Aus Zustandsvariablen abgeleitete Grössen gelten dabei selber wieder als Zustandsvariablen.

Durch die erfindungsgemässe Verwendung eines 2-Phasenmodells für den Ladungszustand der seriellen Freilaufdiode zur Abgrenzung einer $di_C/dt$-Regelung von einer $dv_{CE}/dt$-Regelung des Leistungshalbleiterschalters wird erstmals eine zuverlässige Regelung des stark nichtlinearen transienten Verhaltens von Leistungshalbleiterschaltern realisierbar. Das Verfahren ist auf vollständige oder partielle Einschalt- oder Ausschaltvorgänge anwendbar. In Phase A wird durch die $di_C/dt$-Regelung die Haupttransiente des Kollektorstroms $i_C$ so geregelt, dass der Ladungszustand und damit die Leitfähigkeit der Freilaufdiode mit optimaler Geschwindigkeit umgeschaltet werden kann und zugleich beim Einschalten des Leistungshalbleiterschalters ein Überschwingverhalten des Kollektorstroms begrenzbar ist. In Phase B wird durch die $dv_{CE}/dt$-Regelung die Haupttransiente der Kollektor-Emitter Spannung $v_{CE}$ so geregelt, dass der Leistungshalbleiterschalter mit optimaler Dynamik geschlossen oder geöffnet werden kann und zugleich beim Ausschalten des Leistungshalbleiterschalters ein Überschwingen der Kollektorspannung begrenzbar ist. Die Steuerbarkeit bleibt jederzeit während der Transienten gewahrt, weil ein unkontrolliertes Ablöseverhalten beider Regelkreise und ein daraus resultierendes Schwingungsverhalten wirkungsvoll unterbunden werden.

In ersten Ausführungsbeispielen werden die Phasen bei einem Einschaltvorgang des Leistungshalbleiterschalters in der Reihenfolge A-B durchlaufen bzw. bei einem Ausschaltvorgang in der Reihenfolge B-A, wobei der Leistungshalbleiterschalter jeweils in einer vorangestellten Phase A0 bzw. B0 in einen regelbaren Zustand gesteuert wird, nämlich beispielsweise in Phase A0 durch Anheben einer Gate-Emitter Spannung über eine Schwellenspannung $v_T$ oder in Phase B0 durch Absenken der Gate-Emitter Spannung unter einen Grenzwert $v_T+i_C/g_m$ mit $g_m$=Transkonduktanz des Leistungshalbleiterschalters.

In einem zweiten Ausführungsbeispiel werden in Phase A der Kollektorstromgradient $|di_C/dt|$ und in Phase B der Kollektor-Emitter Spannungsgradient $|dv_{CE}/dt|$ betragsmässig vorübergehend erhöht und gegen Ende der Phasen verringert. Dadurch können der transiente Schaltvorgang beschleunigt und die Schaltverlustleistung zusätzlich reduziert werden.

In einem dritten Ausführungsbeispiel werden zur Verbesserung der Dynamik und Stabilität des Regelungsverfahrens für mindestens eine sekundäre Zustandsvariable des Leistungshalbleiterschalters, z. B. für eine Gatespannung, einen Gatestrom, deren Gradienten oder einen Kollektor-Emitter Spannungsgradienten, ein Istwert bestimmt oder approximiert und zu einer Ausgangsstufe des Verstärkers des Gate-Treibers zurückgeführt. Durch eine derartige umfassende Zustandsregelung mit Rückkopplung zu einer oder mehreren Verstärkerausgangsstufen können Resonanzfrequenzen des Regelkreises verschoben, Oszillationen gedämpft und insgesamt der Frequenzgang des Regelungsverfahrens entsprechend vorteilhaft modifiziert werden.

In einem vierten Ausführungsbeispiel werden gemessene Istwerte (Messwerte) und/oder approximierte Istwerte (Approximationswerte) für mindestens eine primäre und/oder sekundäre Zustandsvariable und/oder eine aus dieser abgeleitete Grösse bestimmt. Die Approximation kann beispielsweise durch Differentiation oder Mittelung von Messwerten, durch Extrapolation zur Bestimmung von Schätzwerten zukünftiger Istwerte, durch Umrechnung aus indirekten Messgrössen z. B. mittels vorbekannter Korrektur- oder Eichfaktoren oder durch Kombination solcher Verfahrensschritte erfolgen. Beispielsweise ist ein Kollektorstrom ermittelbar aus der Gate-Emitter Spannung oder aus einem Zeitintegral des Gatestroms oder der Induktionsspannung über einer Emitterinduktivität. Die Gate-Emitter Spannung kann aus einem Zeitintegral des Gatestroms bestimmt werden.

In fünften Ausführungsbeispielen werden eine zeitlich veränderliche Sollwertfunktion vorgegeben und/oder Istwerte einer Zustandsvariablen wiederholt während des transienten Schaltvorgangs gemessen. Desweiteren kann aufgrund einer berechneten oder geschätzten Regelabweichung zwischen Soll- und Istwert einer Zustandsvariablen ein modifizierter Sollwert für mindestens eine Phase A, B, A0, B0 des aktuellen oder eines darauffolgenden Schaltvorgangs vorgegeben werden. Auf diese Weise kann das Regelverfahren mit grosser Genauigkeit durchgeführt und an den aktuellen Systemzustand adaptiert werden.

In sechsten Ausführungsbeispielen wird als vorzugsweise alleinige primäre Zustandsvariable eine Kollektorspannung $v_C$, nämlich z. B. eine Kollektor-Emitter Spannung $v_{CE}$ oder näherungsweise eine Kollektor-Gate Spannung $v_{CG}$, gewählt. Vorzugsweise wird in einer zugehörigen Spannungs-Sollwertfunktion $v_{CE}^{ref}(t)$, $v_{CG}^{ref}(t)$ die Phase A durch einen Amplitudensprung proportional zum zu steuernden Kollektorstromgradienten $di_c/dt$ und die Phase B durch unmittelbare Vorgabe des zu steuernden Kollektor-Emitter Spannungsgradienten $dv_{CE}/dt$ realisiert. Mit einer derartigen $v_{CE}$-Regelung kann eine ausgezeichnete Dynamik und Stabilität des Regelkreises mit relativ einfachen Mitteln erreicht werden. Die $v_{CE}$-Regelung ist zudem zur Spannungssymmetrisierung reihengeschalteter Leistungshalbleiterschalter besonders gut geeignet. Varianten betreffen: ein mindestens zweifacher Wert eines mittleren Gradienten und/oder einer gesamten Amplitudenänderung der Spannungs-Sollwertfunktion in der Phase B gegenüber der Phase A, Adaption einer Amplitudenänderung in der Phase A als Funktion eines Laststroms, einer Form eines Zeitverlaufs des Kollektorstroms, einer Temperatur der Freilaufdiode und/oder eines Abrissverhaltens von Strom oder Spannung an der Freilaufdiode, mehrere Amplitudensprünge in Phase A zur Verkürzung des Schaltvorgangs, unterschiedliche Kollektor-Emitter-Spannungsgradienten in Phase B zur Begrenzung des erforderlichen Gatestroms, Implementierung einer Phase A0 durch Vorgabe eines vorausgehenden kleinen Amplitudensprungs der Spannungs-Sollwertfunktion, Initialisierung einer Phase B0 durch Vorgabe eines Minimalwerts der Spannungs-Sollwertfunktion, in der Phase A Bestimmung einer verbesserten modifizierten Spannungs-Sollwertfunktion durch adaptive, mittels Istwert-Rückkopplung gesteuerte oder gegebenenfalls durch fixe Sollwert-Modifikation beim Einschaltvorgang und/oder Ausschaltvorgang, und Bestimmung von Regelabweichungen mindestens für die Kollektorspannung und den Kollektorspannungsgradienten und Verwendung der maximalen Regelabweichung zur Erzeugung des Stellsignals.

In siebten Ausführungsbeispielen wird ein Ablösezeitpunkt zwischen den Phasen A und B insbesondere mit Hilfe eines Hauptkriteriums und/oder eines Zusatzkriteriums zur Validierung des Hauptkriteriums für eine gemessene oder approximierte Zustandsvariable detektiert.

In einem achten Ausführungsbeispiel wird ein Regelparameter des Regelungsverfahrens, z. B. eine Reglerverstärkung, Schranken für das Stellsignal, Rückführfaktoren oder eine Rückführfunktion, aufgrund von Mess- oder Approximationswerten einer Zustandsvariablen und/oder aufgrund eines erwarteten idealen Stellsignals in diskreten Schritten oder kontinuierlich angepasst. Beispielsweise werden eine Reglerverstärkung und/oder Schranken für das Stellsignal in den Randbereichen der Phasen A und/oder B gross und gegebenenfalls in den Phasen A0 oder B0 maximal gewählt und beim Übergang zwischen den Phasen A und B, d. h. bei grossen Kollektor-Emitter Spannungen und grossen Kollektorströmen, verringert. Durch die Adaption der Reglerverstärkung werden also die im ausgeschalteten Zustand verminderte Transkonduktanz und im eingeschalteten Zustand die erhöhte Gate-Kollektor oder Miller Kapazität des Leistungshalbleiterschalters kompensiert und durch Reduktion der Reglerverstärkung während des transienten Schaltvorgangs die Dynamik und Genauigkeit des Regelkreises optimiert. Dabei wird vorzugsweise die Reglerverstärkungsfunktion bei grosser Reglerverstärkung stufenförmig und bei kleiner Reglerverstärkung relativ kontinuierlich variiert. Durch die gleichsinnige Adaption einer oberen und unteren Schranke für das Stellsignal werden Oszillationen im Stellsignal aufgrund von Eigenschwingungen des nichtlinearen Regelkreises begrenzt und damit die Zuverlässigkeit des Regelverfahrens weiter erhöht. Als erwartetes ideales Stellsignal kann ein Zeitverlauf eines Betrags des Gatestroms in der Phase A proportional zu $t_A^{-0,5}$ und in der Phase B proportional zu $t_B^2$ angenommen werden, wobei $t_A$, $t_B$=Zeitvariablen für die Phasen A, B.

In einem neunten Ausführungsbeispiel wird ein Istwert einer primären Zustandsvariablen durch ein gepulstes Stell- oder Steuersignal innerhalb eines durch eine obere und untere Sollwertfunktion vorgegebenen Toleranzbands gehalten. Vorzugsweise wird bei einem Ausschaltvorgang nach der Phase A eine Phase C durchlaufen, in welcher ein Leistungshalbleiterschalter bei jedem Anstieg der Kollektorspannung über einen vorgebbaren Maximalwert durch einen gepulsten Gatestrom kurzzeitig partiell geschlossen wird, bis die Kollektorspannung auf einen vorgebbaren Minimalwert abgesunken ist.

In zehnten Ausführungsbeispielen wird eine $v_{CE}$-Regelung auf einen Ein- oder Ausschaltvorgang einer Serieschaltung von i=1...n Leistungshalbleiterschaltern angewendet, indem zumindest n-1 Schalter $v_{CE}$-geregelt werden. Bei einem Einschaltvorgang können für jeden Schalter die Phasen A0 individuell, insbesondere asynchron, eingeleitet werden, um alle Leistungshalbleiterschalter in den Bereich der Regelbarkeit zu bringen. In der Phase A kann einem einzelnen Leistungshalbleiterschalter ein Hauptteil des an der Streuinduktivität der Serieschaltung induzierten Gesamtspannungsabfalls zugewiesen werden, um einen steilen initialen Anstieg des Kollektorstromgradienten zu erzielen. Alternativ können Einschaltzeitpunkte für die Phase A dadurch weitgehend synchronisiert werden, dass ein Überschreiten eines Istwerts des Kollektorstromgradienten $di_C/dt$ und/oder des Kollektorstroms $i_C$ über einen Grenzwert detektiert wird. In jedem Fall ist durch die $v_{CE}$-Regelung ein weitgehend gemeinsamer Ablösezeitpunkt zwischen den Phasen A und B für alle Leistungshalbleiterschalter gewährleistet.

In einem elften Ausführungsbeispiel wird in einem Wechselrichter mit seriellen Leistungshalbleiterschaltern und dazu parallelen Freilaufdioden ein transienter Einschaltvorgang des ersten Brückenzweigs erfindungsgemäss geregelt und währenddessen im zweiten Brückenzweig eine Ausschalttransiente der Freilaufdioden durch partielles Einschalten paralleler Leistungshalbleiterschalter so geregelt, dass die Anoden-Kathoden Spannungen und/oder Verlustleistungen der Freilaufdioden symmetrisiert werden.

In einem zweiten Aspekt betrifft die Erfindung einen Gate-Treiber, der zur Ausführung des erfindungsgemässen Verfahrens ausgestaltet ist. Ein solcher Gate-Treiber umfasst Mess- und Auswertemittel für mindestens eine primäre Zustandsvariable eines Leistungshalbleiterschalters, einen Sollwertgenerator, ein Istwert-Sollwert Vergleichsglied und einen Verstärker zur Erzeugung eines Stellsignals für einen Steueranschluss oder ein Gate des Leistungshalbleiterschalters, wobei der Sollwertgenerator einen ersten Generator zur Erzeugung eines ersten Sollwerts umfasst, mit welchem in einer Phase A, in der eine zum Leistungshalbleiterschalter serielle Freilaufdiode in einem leitfähigen Zustand ist, das Stellsignal zur Regelung eines Kollektorstromgradienten $di_C/dt$ des Leistungshalbleiterschalters angepasst wird, wobei ferner der Sollwertgenerator einen zweiten Generator zur Erzeugung eines zweiten Sollwerts umfasst, mit welchem in einer Phase B, in der die Freilaufdiode in einem Sperrzustand ist, das Stellsignal zur Regelung eines Kollektor-Emitter Spannungsgradienten $dv_{CE}/dt$ des Leistungshalbleiterschalters angepasst wird.

In einem ersten Ausführungsbeispiel umfassen die Mess- und Auswertemittel eine Signalerfassung und einen Istwertgenerator für eine Kollektorspannung und einen Kollektorspannungsgradienten des Leistungshalbleiterschalters. Ferner sind der erste Generator zur Erzeugung einer Kollektorspannungs-Amplitudenänderung und der zweite Generator zur Erzeugung eines Kollektorspannungsgradienten ausgestaltet. Vorzugsweise weist der Sollwertgenerator Mittel zur Berechnung aller Sollwerte aus einer gemeinsamen vorgebbaren Spannungs-Sollwertfunktion auf.

In einem zweiten Ausführungsbeispiel umfasst der Istwertgenerator ein Differentiationsglied zur Gradientenbildung von Istwerten und ein Summationsglied zur gewichteten Addition von Istwerten und Istwertgradienten. Alternativ umfassen der Istwertgenerator und der Sollwertgenerator einen Extremalwertgenerator zur Bestimmung eines maximalen Betrags von normierten Regelabweichungen der Kollektorspannung und des Kollektorspannungsgradienten.

In einem dritten Ausführungsbeispiel weist der Gate-Treiber zur Bestimmung eines Ablösezeitpunkts zwischen den Phasen A und B Detektionsmittel auf, die insbesondere eine Signalerfassung und eine Recheneinheit mit einem Schwellwertschalter für ein Hauptkriterium sowie optional einen Generator für ein Zusatzkriterium und ein Validierungsglied umfassen.

In einem vierten Ausführungsbeispiel hat der Gate-Treiber zusätzlich eine Signalerfassung zur Zurückführung von Istwerten mindestens einer sekundären Zustandsvariablen zu mindestens einer Verstärkerausgangsstufe.

In einem fünften Ausführungsbeispiel weist der Gate-Treiber Mittel zur Adaption von Regelparametern, z.B. einer Reglerverstärkung, einer oberen oder unteren Schranke für das Stellsignal oder eines Rückführfaktors oder einer Rückführfunktion für eine Signalerfassung einer primären und/oder sekundären Zustandsvariablen, auf. Insbesondere sind die Mittel ausgelegt zur näherungsweisen Steuerung eines Gatestrombetrags in der Phase A proportional zu $t_A^{-0,5}$ und in der Phase B proportional zu $t_B^2$ und im Bereich eines Ablösezeitpunkts der Phasen A und B zur Steuerung durch ein Minimum.

In einem sechsten Ausführungsbeispiel ist der Verstärker ein Stromverstärker für ein Gatestrom-Stellsignal. Der Verstärker kann.mehrere Ausgangsstufen aufweisen.

In siebten Ausführungsbeispielen umfasst der Gate-Treiber einen Verstärker mit mindestens einer Ausgangsstufe zur Erzeugung eines Stellsignals für einen Steueranschluss oder ein Gate eines Leistungshalbleiterschalters, wobei die Ausgangsstufe mindestens eine linear steuerbare erste Stromquelle zur Erzeugung kleiner Gateströme mit einer geringen Regelabweichung und einer grossen Regelungsstabilität sowie mindestens eine parallel zuschaltbare nichtlinear oder stufenweise steuerbare zweite Stromquelle zur Erzeugung grosser Gateströme mit einer grossen Regelungsdynamik aufweist. Durch diese Struktur der Stromquelle ist es möglich, für den Beginn und das Ende des Schaltvorgangs starke Gateströme mit extrem kurzen Anstiegszeiten und in einem mittleren Bereich beim Übergang der Phasen A und B schwächere Gateströme mit exakter Regelbarkeit für den Steueranschluss des Leistungshalbleiterschalters zur Verfügung zu stellen.

In daran anschliessenden achten Ausführungsbeispielen ist die erste bzw. zweite Stromquelle in mehrere logische und/oder physikalische erste bzw. zweite Partitionen aufgeteilt. Ferner weist der Gate-Treiber eine Struktursteuerung zur Aktivierung der ersten und/oder zweiten Stromquelle und/oder von Partitionen der ersten und/oder zweiten Stromquelle auf. Die Struktursteuerung ist insbesondere so ausgestaltet, dass (i) im Verlauf der ersten Phase B oder A eines Schaltvorgangs die zweiten Partitionen sukzessive abschaltbar und dann die ersten Partitionen sukzessive runterregelbar und/oder abschaltbar sind und dass (ii) im Verlauf der zweiten Phase B oder A eines Schaltvorgangs die ersten Partitionen sukzessive raufregelbar und/oder zuschaltbar und dann die zweiten Partitionen sukzessive zuschaltbar sind. Zudem können in Phasen A0 und B0 alle Partitionen aktivierbar sein. Die Struktursteuerung kann auch so ausgestaltet sein, dass ein gepulster Gatestrom durch Zuschalten und Abschalten zweiter und/oder erster Partitionen erzeugbar ist.

In einem neunten Ausführungsbeispiel umfasst die erste Stromquelle eine lineare Kaskade von Stromspiegelanordnungen von Transistoren. Zudem kann die zweite Stromquelle eine Spiegelanordnung von Transistoren umfassen, wobei ein Gate eines Ausgangstransistors der Spiegelanordnung zwischen zwei Potentialen umschaltbar ist. Darüberhinaus kann ein Istwert-Sollwert Vergleichsglied zur schnellen Ansteuerung der Stromquellen eine Stromspiegelanordnung von Transistoren aufweisen und insbesondere in dritte Partitionen mehrerer Stromspiegelanordnungen aufgeteilt sein.

Desweiteren betrifft die Erfindung einen Leistungshalbleiterschalter oder eine Anordnung von Leistungshalbleiterschaltern mit mindestens einem erfindungsgemäss ausgestalteten Gate-Treiber. Als Leistungshalbleiterschalter sind IGBTs, MOSFETs und/oder BJTs geeignet. Die Anordnung kann eine Serieschaltung, eine Parallelschaltung, eine Serieschaltung von Parallelschaltungen und insbesondere ein Wechselrichter für Traktion, Hochspannungsgleichstromübertragung, Radiosender, induktives Erwärmen oder induktives Schweissen sein.

Weitere Ausführungen, Vorteile und Anwendungen der Erfindung ergeben sich aus den abhängigen Ansprüchen sowie aus der nun folgenden Beschreibung anhand der Figuren.


**KURZE BESCHREIBUNG DER ZEICHNUNGEN**

Es zeigen

Fig. 1 ein vereinfachtes Ersatzschaltbild für einen IGBT-Leistungshalbleiterschalter;

Fig. 2, 3 eine erfindungsgemässe $v_{CE}$-Regelung eines Ein- und Ausschaltvorgangs durch Vorgabe einer Sollwertfunktion $v_{CE}^{ref}(t)$ für die Kollektor-Emitter Spannung;

Fig. 4 einen erfindungsgemässen Gate-Treiber zur Implementierung der $v_{CE}$-Regelung;

Fig. 5, 6          modifizierte $v_{CE}$-Regelungen zur Verbesserung der Regelungsdynamik und Regelungsgenauigkeit;

Fig. 7          eine Toleranzbandregelung der Kollektorspannung $v_C$ mit gepulstem Stellsignal;

Fig. 8, 9          Anwendungen der $v_{CE}$-Regelung auf eine Serieschaltung von Leistungshalbleiterschaltern;

Fig. 10          eine $v_{CE}$-Regelung für einen Brückenzweig eines Wechselrichters in Kombination mit einer Regelung zur Symmetrisierung der Spannungsverteilung im anderen Brückenzweig;

Fig. 11          einen Gate-Treiber zur Ausführung des erfindungsgemässen Regelungsverfahrens;

Fig. 12          einen Gate-Treiber mit einer Rückkopplung sekundärer Zustandsvariablen;

Fig. 13, 15          Gate-Treiber mit erfindungsgemäss partitionierten Ein- und Ausgangsverstärkerstufen;

Fig. 14          einen idealen und einen erfindungsgemäss approximierten Gatestromverlauf während eines Schaltvorgangs; und

Fig. 16a, 16b, 16c          einen Aufbau einzelner Verstärkerpartitionen.

In den Figuren sind gleiche Teile mit gleichen Bezugszeichen versehen.

## WEGE ZUR AUSFÜHRUNG DER ERFINDUNG

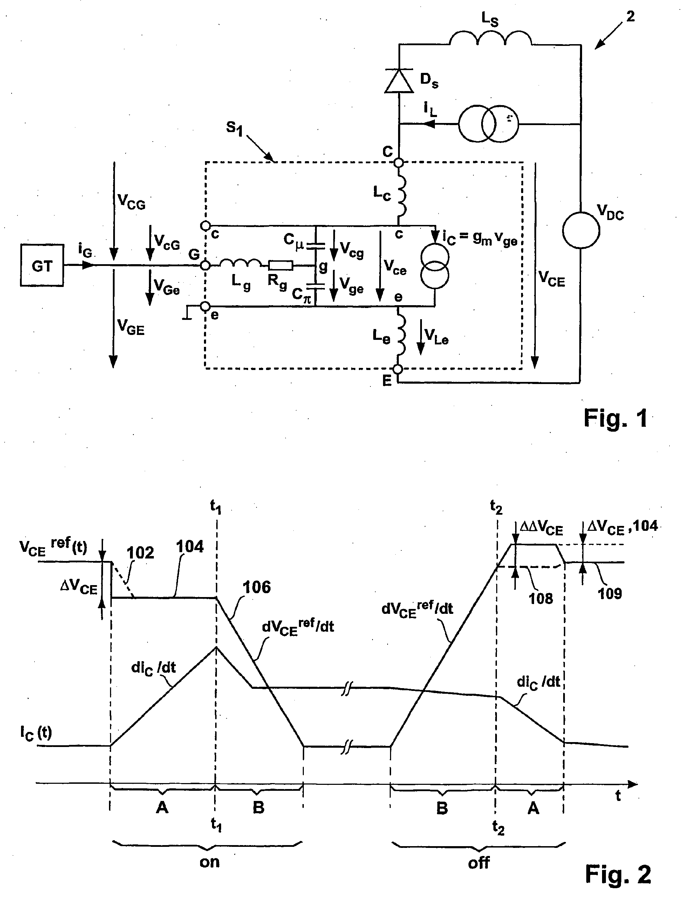

Fig. 1 zeigt einen Leistungshalbleiterschalter $S_1$, beispielhaft ein IGBT-Modul, zum Schalten eines Leistungskreises 2, der durch eine Gleichspannungsquelle $V_{DC}$, eine Stromquelle für den Laststrom $i_L$ und eine Induktivität $L_S$ modelliert ist. In Serie zum Leistungshalbleiterschalter $S_1$ liegt eine Freilaufdiode $D_S$. Zur Ansteuerung der Leistungsstrecke Kollektor C - Emitter E wird ein Steueranschluss G des Schalters $S_1$ von einem Gate-Treiber GT mit einem Gatestrom $i_G$ versorgt. Das vereinfachte Modell für den inneren Aufbau des Schalters $S_1$ umfasst eine Gateinduktivität $L_g$, einen Gatewiderstand $R_g$ und ein Hilfsgate g, eine Kollektorinduktivität $L_c$ und einen Hilfskollektor c, eine Hilfskollektor-Hilfsgate oder Miller Kapazität $C_\mu$, eine Emitterinduktivität $L_e$ und einen Hilfsemitter e sowie eine Hilfsgate-Hilfsemitter Kapazität $C_\pi$. Die Spannungen sind typischerweise durch Indizes zur Bezeichnung der Bezugspunkte charakterisiert. Zusammenfassend können die Spannungen $v_{CE}$, $v_{ce}$, $v_{CG}$, $v_{cg}$ oder z. B. auch $v_{Ce}$, $v_{cE}$, $v_{Cg}$, $v_{cG}$ als Kollektorspannung $v_C$ und die $v_{GE}$, $v_{ge}$ oder z. B. auch $v_{Ge}$, $v_{gE}$ als Gatespannung $v_G$ bezeichnet werden. $v_{Le}$ ist die Induktionsspannung über der Emitterinduktivität $L_e$. Für den Kollektorstrom $i_C$ gilt die Beziehung $i_C = g_m * v_{ge}$, wobei $g_m$=Transkonduktanz des Schalters $S_1$.

Fig. 2 zeigt ein Beispiel einer erfindungsgemässen 2-Phasenregelung für einen Ein- und Ausschaltvorgang des Schalters $S_1$. Beim Einschalten wird in der Phase A ein Sprung $\Delta v_{CE}$, 104 oder ein mehr oder weniger steiler Gradient 102 für einen Sollwert $v_{CE}^{ref}$ oder eine Sollwertfunktion $v_{CE}^{ref}(t)$ für die Kollektor-Emitter Spannung $v_{CE}$ vorgegeben. Aufgrund der näherungsweise herleitbaren Gleichung

$$\Delta v_{CE} = V_{DC} - v_{CE} \approx L_S * di_C/dt \qquad\qquad (G1)$$

wird durch die Induktivität $L_S$ proportional zur Amplitudenänderung $\Delta v_{CE}$ ein Kollektorstromgradient $di_C/dt$ induziert. Der in der Phase A durch das Ausräumverhalten der Freilaufdiode $D_S$ bedingte Stromgradient $di_C/dt$ durch die Leistungsterminals C, E wird also indirekt über die Spannung $v_{CE}$ zwischen den Leistungsterminals C, E geregelt. Am Ende der Phase A führt das "reverse recovery"-Verhalten der Diode $D_S$ zu einer Selbst-Passivierung der Kollektorstromtransiente. Sobald die Randzonen der Diode $D_S$ von Ladungsträgern ausgeräumt sind, kann die Diode $D_S$ Sperrspannung aufneh-men, $\Delta v_{CE}$ steigt an und die Kollektor-Emitter Spannung $v_{CE}$ sinkt unter den Sollwert $v_{CE}^{ref}$. Dann kann die Phase B eingeleitet werden, in welcher durch Vorgabe eines Sollwerts $dv_C^{ref}/dt$ oder einer Sollwertfunktion $dv_C^{ref}(t)/dt$ der Gradient der Kollektor-Emitter Spannung $dv_{CE}/dt$ gesteuert wird. Beim Ausschalten werden auf analoge Weise zuerst die Phase B und dann die Phase A durchlaufen.

Für die Gradienten des Kollektorstroms $di_C/dt$ und der Kollektor-Emitter Spannung $dv_{CE}/dt$ können auch direkt separate Sollwerte $di_C^{ref}/dt$ und $dv_{CE}^{ref}/dt$ oder Sollwertfunktionen $di_C^{ref}(t)/dt$ und $dv_{CE}^{ref}(t)/dt$ vorgegeben werden. In jedem Fall können die Gradienten nur indirekt durch eine Stellgrösse für das Gate G gesteuert werden. Als Stellgrössen sind ein Gatestrom $i_G$ oder eine Gatespannung $v_G$ geeignet: Für eine Rückführung in den Regelkreis sind $i_G$ oder $v_G$ oder eine Approximation für $i_G$ oder $v_G$ verwendbar, wobei die Approximation z. B. durch Differentiation, Integration, Kurzzeitmittelung, Schätzung o. ä. von zeitabhängigen Werten von $i_G$, $v_G$ oder anderen Zustandsvariablen des Schalters $S_1$ gewonnen werden kann. Beim erfindungsgemässen 2-Phasen Modell für Schaltvorgänge wird zudem ein geschlossener Regelkreis realisiert, indem mindestens ein Istwert einer primären Zustandsvariablen, insbesondere der Kollektorspannung $v_C$, des Kollektorstroms $i_C$ oder einer daraus abgeleiteten Grösse wie z. B. eines Gradienten, bestimmt oder approximiert und dem Gate-Treiber GT zugeführt wird. Aus der Regelabweichung von Istwert (auch Regelgrösse, "plant output", "output" oder "process variable" genannt) und Sollwert (auch Führungsgrösse oder "reference variable" genannt) wird die Stellgrösse (auch "plant input" oder "manipulated variable" genannt) bestimmt.

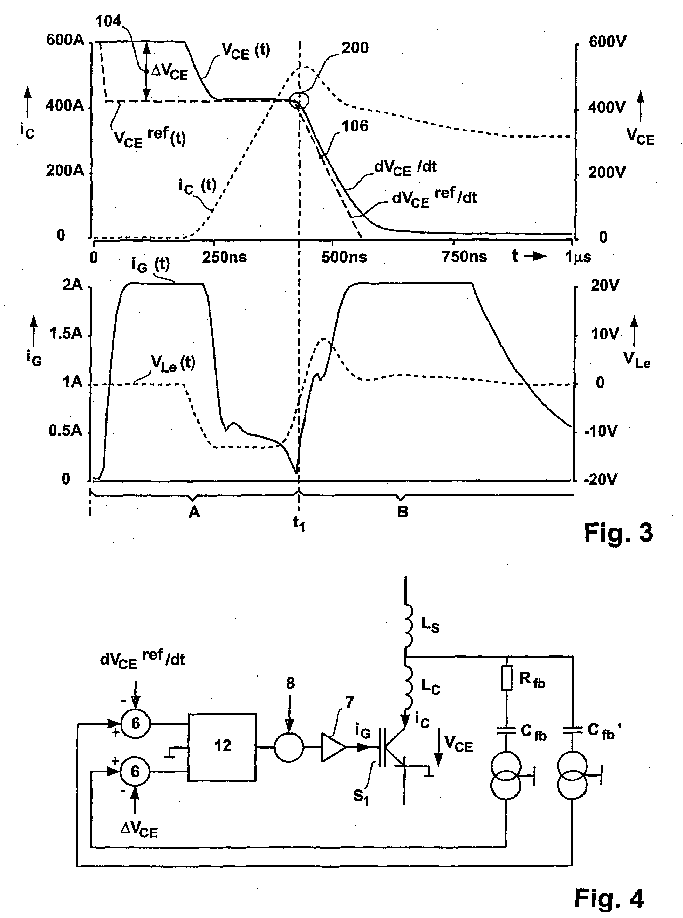

Fig. 3 zeigt für einen Einschaltvorgang einen tatsächlichen Gatestrombedarf $i_G(t)$ zur Realisierung der Phasen A und B. Dargestellt sind oben die Kollektor-Emitter Spannungssollwertfunktion $v_{CE}^{ref}(t)$, die Kollektor-Emitter Spannungsistwertfunktion $v_{CE}(t)$ und die Kollektorstromistwertfunktion $i_C(t)$ sowie unten der Gatestrom $i_G(t)$ und die zum Kollektorstromgradienten proportionale Istwertfunktion der Emitterinduktionsspannung $v_{Le}(t)$. Dabei sind gemäss einem vereinfachten Verhaltensmodell für einen

IGBT-Schalter $S_1$ die Nichtlinearitäten der Transkonduktanz $g_m$ als Funktion der Gate-Emitter Spannung $v_{ge}$ und die Miller Kapazität $C_\mu$ als Funktion der Gate-Emitter Spannung $v_{CE}$ durch die Gleichungen

$$g_m = di_C/dv_{ge} \approx T * (v_{ge}-v_T) \quad \text{für } v_{ce} > v_{ge} - v_T \qquad (G2)$$

$$C_\mu = konst * V_{CE}^{-0,5} \qquad (G3)$$

angenähert, wobei T=Transkonduktanzparameter, $v_T$=Gate-Schwellenspannung für Steuerbarkeit des IGBT $S_1$ und konst=Konstante. Die Transkonduktanz $g_m$ verläuft für grössere Werte von $v_{ge}$-$v_T$ (z. B. mehrere Volt) sublinear mit $V_{ge}$-$V_T$.

Zunächst wird durch Vorgabe eines Kollektorspannungssprungs $\Delta v_{CE}$, 104 der Gatestrom $i_G$ maximal ausgesteuert. Sobald die Steuerbarkeit des IGBT $S_1$ erreicht ist, wird Phase A dadurch eingeleitet, dass $v_{CE}(t)$ zu sinken und $i_C(t)$ zu steigen beginnt. Die Einleitung der Phase A ist besonders einfach anhand der betragsmässigen Zunahme der Emitterinduktionsspannung $v_{Le}(t)$ detektierbar. Sobald die Regelabweichung $v_{CE}(t)$-$v_{CE}^{ref}(t)$ klein wird, wird der Gatestrom $i_G(t)$ heruntergeregelt. Es kann gezeigt werden, dass ein idealer Gatestrom in der Phase A betragsmässig näherungsweise proportional zu $t_A^{-0,5}$ abnimmt, wobei $t_A$=eine Zeitvariable für die Phase A und näherungsweise $t_A$=0 bei Einleitung der Phase A gesetzt werden kann. In der Nähe des Maximalwerts des Kollektorstroms $i_C(t)$ befindet sich ein Bereich 200 des Ablösezeitpunkts $t_1$ der Phasen A und B. Dort kann der Kollektorstromgradient $di_C/dt$ nicht mehr aufrechterhalten werden, da die Randzonen der Freilaufdiode $D_S$ weitgehend leergeräumt sind. Die Spannungsgradientenregelung wird eingeleitet, die Emitterinduktionsspannung $v_{Le}(t)$ nimmt betragsmässig ab und der Betrag des Gatestroms $|i_G|$ wird durch ein Minimum gesteuert. Sein Wiederanstieg erfolgt idealerweise ungefähr proportional zu $t_B^2$, wobei $t_B$=eine Zeitvariable für die Phase B und näherungsweise $t_B$=0 bei Einleitung der Phase B gesetzt werden kann. Im tatsächlichen Verlauf des Gatestroms $i_G(t)$ können mehr oder weniger starke Abweichungen aufgrund des tatsächlichen, rückgekoppelten Verlaufs einer primären Zustandsvariablen (z. B. von $i_C(t)$) oder aufgrund der Regelungsdynamik auftreten.

Durch die Erfindung ist also erstmals eine vollständige Regelung des Ein- und Ausschaltvorgangs eines Leistungshalbleiterschalters $S_1$ insbesondere unter Berücksichtigung seiner stark nichtlinearen Transkonduktanz $g_m$ und Miller Kapazität $C_\mu$ und des stark nichtlinearen Entladeverhaltens der Randzonen der Freilaufdiode $D_S$ realisiert. Durch die 2-Phasenregelung wird in Phase A mit $di_C/dt$ als Regelgrösse die Haupttransiente des Kollektorstroms $i_C(t)$ und in Phase B mit $dv_{CE}/dt$ als Regelgrösse die Haupttransiente der Kollektorspannung $v_C(t)$ geregelt.

Fig. 4 zeigt eine einfache Anordnung zur Steuerung des Ablöseverhaltens der Regelungen in den Phasen A und B im Falle einer $v_{CE}$-Regelung gemäss Fig. 2 und 3. Istwerte für die Amplitudenänderung $\Delta v_{CE}$ und den Gradienten $dv_{CE}/dt$ der Kollektorspannung $v_C$ werden über einen Widerstand und Kondensatoren $R_{fb}$, $C_{fb}$ und $C_{fb}'$ ausgekoppelt und mit den zugehörigen Sollwerten $\Delta v_{CE}^{ref}$ und $dv_{CE}^{ref}/dt$ in Differenzgliedern 6 verglichen. Die Regelabweichungen werden normiert und die betragsmässig grössere normierte Regelabweichung wird von einem Maximalwertgenerator 12 in Abhängigkeit von einer Schaltanweisung 8 einem Stromverstärker 7 als Eingangsgrösse zur Erzeugung des Gatestroms $i_G$ zugeführt. Selbstverständlich ist dem Maximalwertgenerator 12 ein Minimalwertgenerator äquivalent, an dessen Eingängen jeweils eine Summe einer vorzeichenbehafteten Regelabweichung mit einer betragsmässig grösseren Schaltanweisungsspannung 8 mit entgegengesetztem Vorzeichen anliegt. In diesem Sinne bezeichnet 12 allgemein einen Extremalwertgenerator. Da in der Phase A durch Vorgabe des Amplitudensprungs $\Delta v_{CE}^{ref}$ die Regelabweichung

$\Delta v_{CE}$-$\Delta v_{CE}^{ref}$ und in der Phase B durch Vorgabe eines Kollektorspannungsgradienten $dv_{CE}^{ref}/dt$, der steiler als der Istwert ist, oder eines entsprechenden Kollektorspannungssprungs die Regelabweichung $dv_{CE}/dt$-$dv_{CE}^{ref}/dt$ dominiert, wird auf diese Weise immer die gewünschte Grösse geregelt und eine kontrollierte Ablösung zwischen den Phase A und Phase B gewährleistet.

Ein besonders einfacher Regelkreis mit Zurückführung der Kollektorspannung $v_{CE}$ und des Kollektorspannungsgradienten $dv_{CE}/dt$ kann auch durch gewichtete Summierung statt mit einem Maximalwertgenerator 12 realisiert werden. Für den Istwert $x_m(t)$ und den Sollwert $x_{ref}(t)$ der kombinierten Zustandsvariablen und für den Gatestrom $i_G$ gelten dann die Gleichungen

$$x_m(t) = c_1 * v_{CE}(t) + c_2 * dv_{CE}(t)/dt \quad \text{und} \qquad (G4)$$

$$x_{ref}(t) = c_1 * v_{CE}^{ref}(t) + c_2 * dv_{CE}^{ref}(t)/dt \quad \text{und} \qquad (G5)$$

$$i_G(t) = k_p * (x_m(t) - x_{ref}(t)), \qquad (G6)$$

wobei $k_p$=Reglerverstärkung. In einer weiteren Ausführungsform kann der Rückführfaktor $c_1$ null gesetzt werden, so dass der Kollektorspannungsgradient $dv_{CE}/dt$ direkt geregelt wird. Dadurch können Bauelemente im Leistungskreis eingespart werden. Um die Stabilität dieser Ausführung zu verbessern, kann in den Regelkeis ein zusätzliches Integrierglied eingefügt werden. Während des Schaltvorgangs sollte die Integration in den Phasen A0 und B0 verhindert oder eingeschränkt werden, um die Dynamik zu verbessern.

Beim erfindungsgemässen Regelungsverfahren kann zusätzlich ein Ablösezeitpunkt $t_1$, $t_2$ der Phasen A und B bestimmt werden. Für diesen Zweck werden insbesondere ein Hauptkriterium und gegebenenfalls ein Zusatzkriterium zur Validierung des Hauptkriteriums detektiert und zur aktiven Einleitung der zweiten Phase B bei einem Einschaltvorgang verwendet. Als Hauptkriterium sind beispielsweise eine oder mehrere der folgenden Ungleichungen geeignet:

$|V_{AK}| > \varepsilon_{AK}$, wobei $V_{AK}$=eine Spannung über der Freilaufdiode $D_S$ und $\varepsilon_{AK}$=ein vorgebbarer erster Schwellwert;

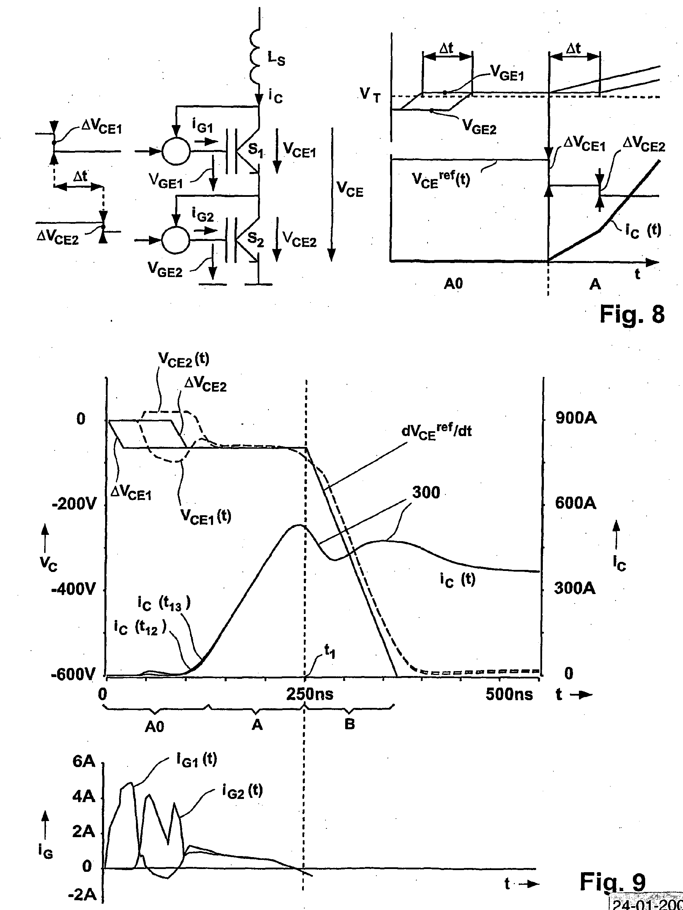

$|di_c/dt| < \varepsilon_{dic}$, insbesondere $|v_{Le}|/L_e < \varepsilon_{diC}$, wobei $\varepsilon_{diC}$=ein vorgebbarer zweiter Schwellwert, wobei insbesondere bei einer darauffolgenden Verletzung dieses Hauptkriteriums (z. B. durch Oszillationen 300 in Fig. 9) eine Detektion des Ablösezeitpunkts $t_1$, $t_2$ nicht widerrufen wird;

$|\Delta v_C| > \varepsilon_{vC}$, wobei $\varepsilon_{vCE}$=ein vorgebbarer dritter Schwellwert;

$|dv_C/dt| > \varepsilon_{dvC}$, wobei $\varepsilon_{dvCE}$=ein vorgebbarer vierter Schwellwert;

$|i_G| < \varepsilon_{iG}$, wobei $\varepsilon_{iG}$=ein vorgebbarer fünfter Schwellwert;

$|dv_G/dt| < \varepsilon_{dvG}$, wobei $dv_G/dt$=ein Gradient der Gatespannung und $\varepsilon_{dvG}$=ein vorgebbarer sechster Schwellwert;

$|v_G| < |v_{Gmax}|*\varepsilon_{vGmax}$, wobei $v_{Gmax}$=ein Maximalwert der Gatespannung und $\varepsilon_{vGmax}$=ein vorgebbarer siebter Schwellwert; und/oder

$t_1 > t_M$ oder $t_2 > t_M$, wobei $t_M$=eine Maximaldauer ab Einleitung des Schaltvorgangs und/oder

ab einer detektierbaren Veränderung von Zustandsvariablen $v_C$, $dv_C/dt$, $i_C$, $di_C/dt$, $i_G$, $v_G$, $di_G/dt$, $dv_G/dt$, insbesondere sobald gilt $|\Delta v_C| > \varepsilon_{vC} * \varepsilon_1$ mit $\varepsilon_1 < 1$.

Eine schnelle Bestimmung oder Approximation der Spannung $V_{AK}$ über der Freilaufdiode $D_S$ ist gemäss einer Gleichung $V_{AK}$=-$\delta v_{CE}$+$V_{AKf}$+$K*V_{Le}$ möglich, wobei $V_{Le}$ und eine Flussspannung $V_{AKf}$ der Freilaufdiode $D_S$ in einer der Phase A vorgelagerten Phase A0 gemessen oder geschätzt werden. $\delta v_{CE}$ bezeichnet eine Amplitudenänderung der Kollektor-Emitter Spannung in der Phase A relativ zur Phase A0 und K eine Proportionalitätskonstante. Insbesondere gilt K=-($L_\sigma$-$L_C$)/$L_e$, wobei $L_\sigma$=$L_C$+$L_e$+$L_S$=Gesamtinduktivität des Leistungskreises 2, $L_C$=Kollektorinduktivität, oder K ist eine gemäss einem Schätzwert für $V_{AK}$ (z. B. 0V < $V_{AK}$ < 4V) vorgebbare Proportionalitätskonstante.

Als Zusatzkriterium sind ein oder mehrere der folgenden Ungleichungen geeignet:

$|v_G| > \varepsilon_{vG}$ mit $\varepsilon_{vG} > v_T$, wobei $\varepsilon_{vG}$=ein vorgebbarer achter Schwellwert;

$|i_C| > \varepsilon_{iC}$, wobei $\varepsilon_{iC}$=ein vorgebbarer neunter Schwellwert; und/oder

$t_1 > t_m$ oder $t_2 > t_m$, wobei $t_m$=eine Mindestdauer ab Einleitung des Schaltvorgangs.

Mit Vorteil wird der Ablösezeitpunkt mit einer Genauigkeit besser als 10%, vorzugsweise 4%, besonders bevorzugt 2%, bezogen auf die Dauer der Phase A detektiert.

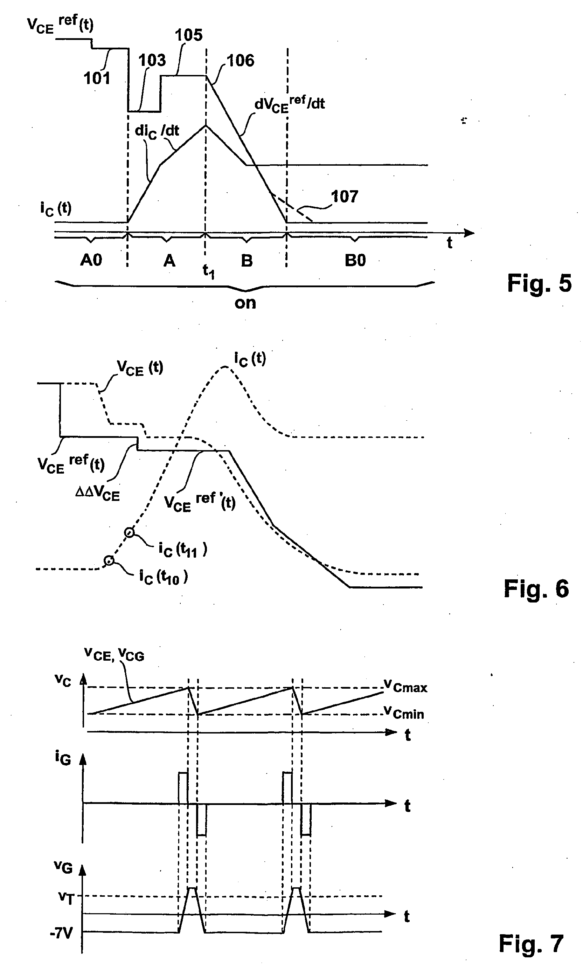

Fig. 5 zeigt für einen Einschaltvorgang, dass eine Phase A0 zur Erlangung der Steuerbarkeit der Kollektorstromtransienten als Funktion des Gatestroms $i_G$ durch einen kleinen Amplitudensprung 101 in der Spannungs-Sollwertfunktion $v_{CE}^{ref}(t)$ implementiert werden kann. Ausserdem kann die Phase A dadurch beschleunigt werden, dass zunächst ein grosser Amplitudensprung 103 und im Verlauf der Phase A ein entgegengesetzt gerichteter Amplitudensprung 105 in $v_{CE}^{ref}(t)$ vorgegeben wird. Ganz analog kann in der Phase B zwischenzeitlich ein erhöhter oder maximaler Spannungsgradient 106 und zum Ausklang der Phase B ein reduzierter Spannungsgradient 107 gefahren werden. Generell wird die Zeitabhängigkeit der Spannungs-Sollwertfunktion $v_{CE}^{ref}(t)$, $V_{CG}^{ref}(t)$ am einfachsten durch eine stückweise lineare oder trapezförmige Funktion vorgegeben. Anschliessend an die Phase B kann in einer Phase B0 ein Gatestrom $i_G(t)$ so geregelt werden, dass in der Phase B des darauffolgenden Ausschaltvorgangs die Steuerbarkeit, d. h. eine Gatespannung $V_{GE} < v_T+i_C/g_m$ mit $v_T$=Schwellenspannung, des Kollektor-Emitter Spannungsgradient $dv_{CE}/dt$ durch den Gatestrom $i_G$ gewährleistet ist.

Beispiele für Modifikationen der Sollwertfunktion $v_{CE}^{ref}(t)$ sind für einen Einschaltvorgang in Fig. 6 und für einen Ausschaltvorgang in Fig. 2 dargestellt. Beim Einschalten (Fig. 6) kann eine Regelabweichung $v_{CE}(t)$-$v_{CE}^{ref}(t)$ detektiert und durch Vorgabe einer modifizierten Spannungs-Sollwertfunktion $v_C^{ref'}(t)=v_C^{ref}(t) +\Delta\Delta v_{CE}$, hier also durch einen zusätzlichen kleinen Amplitudensprung $\Delta\Delta v_{CE}$, korrigiert werden. Zur Detektion der Regelabweichung kann der Istwert des Kollektorstromgradienten $di_C/dt$ z. B. durch Messen des Kollektorstroms $i_C$ zu mindestens zwei Zeitpunkten $t_{10}$ und $t_{11}$ bestimmt und mit einem Sollwert $di_C^{ref}/dt$ verglichen werden. Beim Ausschalten (Fig. 2) bezeichnet 109 den anzustrebenden stationären Sollwert für $v_{CE}$. In der Phase A müsste ein Amplitudensprung $\Delta v_{CE}$, 104 so vorgegeben werden, dass immer ein Spannungswert 108 grösser als der stationäre Sollwert 109 vorliegt, um die Induktionsspannung über $L_S$ zu steuern. Darüberhinaus kann jedoch ein Überschwingen der Kollektor-Emitter Spannung $v_{CE}$ dadurch verhindert werden, dass zeitweilig ein um eine Korrekturgrösse $\Delta\Delta v_{CE}$, 108 erniedrigter Amplitudensprung $\Delta v_{CE}$, 104 als modifizierter Sollwert $v_{CE}^{ref'}$ vorgegeben wird. Dadurch kann insbesondere der Spannungswert 108 unter dem stationären Sollwert 109 zu liegen kommen.

Fig. 7 zeigt eine Toleranzbandregelung anhand einer Kollektorspannung $v_C$ als primärer Zustandsvariable. Dabei wird ein Toleranzband durch Vorgabe eines Maximalwerts $v_{Cmax}$ und eines Minimalwerts $v_{Cmin}$ für $v_C$ vorgegeben und ein Istwert von $v_C$ durch ein vorzugsweise gepulstes Stellsignal $i_G$, $v_G$ innerhalb des Toleranzbands $v_{Cmax}$, $v_{Cmin}$ gehalten. Insbesondere wird durch einen positiven und einen darauffolgenden verzögerten negativen Strompuls $i_G(t)$ ein Gatespannungspuls $v_G > v_T$ erzeugt. Die Dauer des Gatespannungspulses $v_G > v_T$ wird durch die Verzögerung des negativen Strompulses $i_G(t)$ so angepasst, dass die Kollektorspannung $v_C$ auf einen vorgebbaren Wert innerhalb des Toleranzbands $v_{Cmax}$, $v_{Cmin}$ absinkt.

Fig. 8 und 9 zeigen eine vorteilhafte Anwendung der $v_{CE}$-Regelung in einer Serieschaltung mit beispielhaft zwei Leistungshalbleiterschaltern $S_1$, $S_2$. Dabei werden Kollektorspannungen $v_{C1}$ und $v_{C2}$, insbesondere $v_{CE1}$ und $v_{CE2}$, über jedem Leistungshalbleiterschalter $S_1$, $S_2$ wie oben beschrieben geregelt. Eine Synchronisierung der Phasen A0 ist nicht erforderlich. Wie in Fig. 8 dargestellt, können eine Zeitverzögerung $\Delta t$ und/oder unterschiedliche Referenzspannungssprünge $\Delta v_{CE1} > \Delta v_{CE2}$ vorgegeben werden, um einem einzelnen Leistungshalbleiterschalter $S_2$ einen Hauptteil des an der Streuinduktivität der Serieschaltung induzierten Gesamtspannungsabfalls $\Delta v_{CE1}+\Delta v_{CE2}$ zuzuweisen. Dadurch wird ein genau definierter steiler initialer Anstieg der Kollektorstromtransienten $i_C(t)$ bewirkt. Nach der Zeitverzögerung $\Delta t$ werden die übrigen Leistungshalbleiterschalter $S_2$ zugeschaltet und dadurch der Gradient des Kollektorstroms $di_C/dt$ erhöht. Durch die bezüglich Zeitpunkt und Amplitude individuell vorgebbaren Referenzspannungssprünge $\Delta v_{CE1}$, $\Delta v_{CE2}$ kann auch für die Leistungshalbleiterschalter $S_1$, $S_2$ eine gewünschte Verteilung oder Symmetrisierung thermischer Verlustleistungen erreicht werden.

Fig. 9 zeigt ein Beispiel zur Synchronisierung der Phasen A nach einer asynchronen Einleitung der Phase A oder gegebenenfalls der Phase A0. Die für die $v_{CE}$-Regelungen erforderlichen Gatestromverläufe $i_{G2}(t)$ und $i_{G1}(t)$ sind bis zum Beginn der Phase B dargestellt. Der mit einem zeitverzögerten Spannungssprung $\Delta v_{CE2}$ angesteuerte Leistungshalbleiterschalter $S_2$ erfährt zunächst eine Überhöhung der Kollektorspannung $v_{CE2}(t)$. Sobald alle Regelabweichungen abnehmen oder die Steuerbarkeit für alle Leistungshalbleiterschalter $S_1$, $S_2$ erreicht ist, beginnt der Kollektorstrom $i_C(t)$ zu steigen und die Phase A wird ohne weiteren Synchronisierungsaufwand für alle Leistungshalbleiterschalter

$S_1$, $S_2$ eingeleitet. Im Fall vorgelagerter Phasen A0 kann die Phase A aktiv für alle Leistungshalbleiterschalter $S_1$ gemeinsam eingeleitet werden, sobald der Kollektorstrom $i_C$ oder der Kollektorstromgradient $di_C/dt$ einen vorgebbaren Schwellenwert überschreitet. Der Kollektorstrom $i_C$ ist z. B. aus einem Zeitintegral der Induktionsspannung $v_{Le}$ über der Emitterinduktivität $L_e$ bestimmbar. Der Kollektorstromgradient ist z. B. dadurch bestimmbar, das der Kollektorstrom $i_C$ zu verschiedenen Zeitpunkten $t_{12}$, $t_{13}$ gemessen und der Gradient $di_c/dt$ berechnet wird.

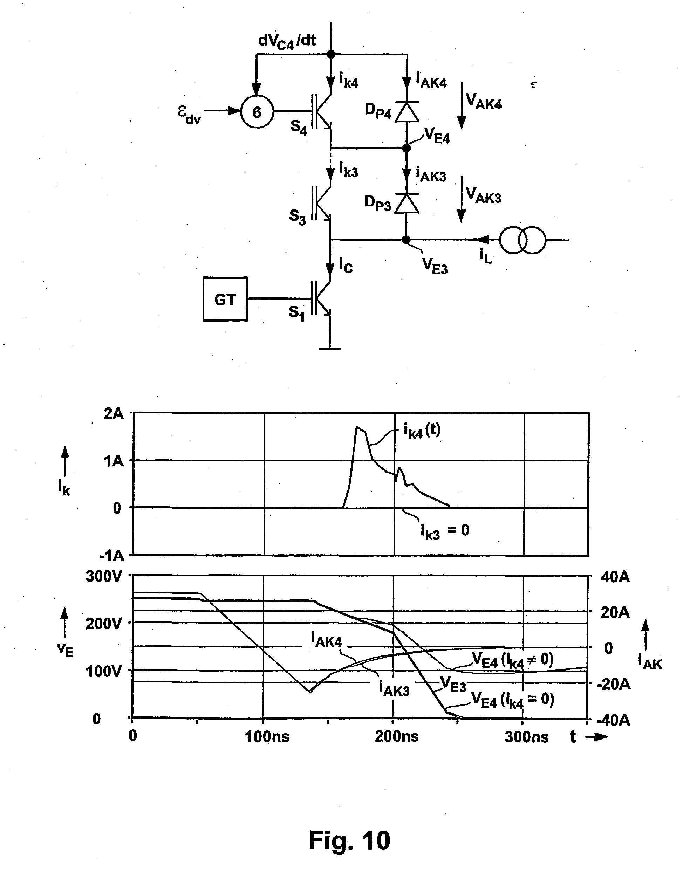

Fig. 10 zeigt für eine Halbbrücke eines Wechselrichters einen ersten Brückenzweig mit Leistungshalbleiterschaltern $S_3$, $S_4$ und parallelen Dioden $D_{P3}$ und $D_{P4}$ und einen zweiten Brückenzweig in vereinfachter Darstellung mit nur einem Einzelschalter $S_1$. Auf $S_1$ wird das erfindungsgemässe Regelverfahren und insbesondere die $v_{CE}$-Regelung auf einen Einschaltvorgang angewendet. Darüberhinaus können bei dem gleichzeitigen Ausschaltvorgang des zweiten Brückenzweigs Anoden-Kathoden Spannungen $V_{AK3}$, $V_{AK4}$ und/oder Verlustleistungen der Freilaufdioden $D_{P3}$, $D_{P4}$ des zweiten Brückenzweigs wenigstens teilweise dadurch begrenzt und insbesondere symmetrisiert werden, dass mindestens eine Freilaufdiode $D_{P4}$ mit überhöhtem Anoden-Kathoden Spannungsgradienten $dv_{AK4}/dt$ identifiziert und durch mindestens einen Regelbetrieb der zugehörige parallele Leistungshalbleiterschalter $S_4$ in Abhängigkeit vom Regelungsverfahren zeitweilig und/oder partiell geschlossen wird. Gemäss Fig. 10 gilt $v_{C3}=v_{AK3}$, $v_{C3}=v_{AK3}$ und $v_C=v_{C3}+v_{C4}$. Insbesondere wird der Regelbetrieb eingeleitet, sobald die Phase B im Regelungsverfahren detektiert wird. Beim Regelbetrieb kann auch ein Stellsignal $i_G$, $v_G$ so vorgegeben werden, dass ein Betrag des Kollektorspannungsgradienten $|dv_{C4}/dt|$ des zugehörigen Leistungshalbleiterschalters $S_4$ im zweiten Brückenzweig einen Grenzwert $\varepsilon_{dv}$ nicht überschreitet. Bevorzugt gilt $\varepsilon_{dv}=N/(n*(1+E))$ mit N=ein Betrag eines Erwartungswerts des Kollektorspannungsgradienten $|dv_C/dt|$ des ersten Brückenzweigs, n=eine Anzahl der Freilaufdioden $D_{P3}$, $D_{P4}$ des zweiten Brückenzweigs und E= $(dv_C/dt-dv_C^{ref}/dt)/dv_C^{ref}/dt$ eine normierte Regelabweichung des Regelbetriebs. Der Regelbetrieb darf nicht auf alle Freilaufdioden $D_{P3}$, $D_{P4}$ des zweiten Brückenzweigs gleichzeitig angewendet werden, um hohe Querströme in einem Brückenzweig zu vermeiden. Beispielsweise kann die Aktivierung des zur langsamsten Diode $D_{P3}$ gehörigen Leistungshalbleiterschalters $S_3$ verhindert werden. Die langsamste Diode $D_{P3}$ kann z. B. an der höchsten Anoden-Kathoden Spannung $V_{AK3}$ bzw. Kollektor-Emitter Spannung $v_{CE3}$ des zugehörigen Schalters $S_3$ unmittelbar nach Abschluss der Ausschalttransienten erkannt werden. Es ist ferner wünschenswert, dass für eine schnelle Einschaltbarkeit des zu aktivierenden Leistungshalbleiterschalters $S_4$ im zweiten Brückenzweig ein Mittelwert von dessen Transkonduktanz $g_m$ grösser als null eingehalten wird.

Der grosse Nutzen des Regelbetriebs ist aus Fig. 10, unterer Teil ersichtlich. Der Schalter $S_4$ wird partiell geschlossen, so dass ein geringer Kollektor-Korrekturstrom $i_{k4}(t)$ durch $S_4$ fliesst. Dadurch wird die Emitterspannung $v_{E4}$ von $S_4$ um ca. 100 V angehoben und somit eine symmetrischere Verteilung der Kollektorspannung $v_C$ im zweiten Brückenzweig erreicht. Im gezeigten Beispiel ist der Kollektor-Korrekturstrom $i_{k3}(t)$ durch $S_3$ null und die zugehörige Emitterspannung $v_{E3}$ bleibt unverändert.

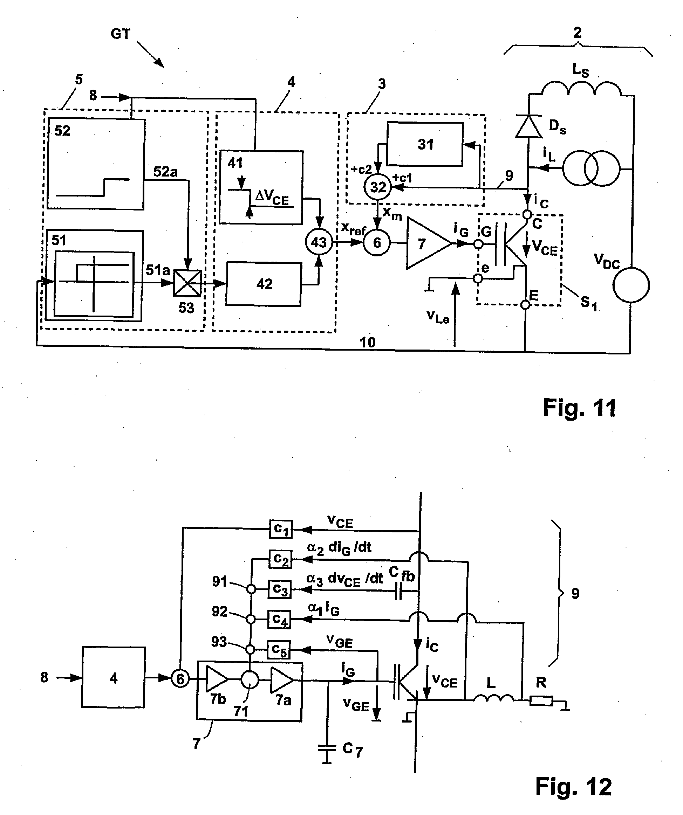

Fig. 11 zeigt ein Beispiel für einen Gate-Treiber GT zur Ausführung des erfindungsgemässen Regelungsverfahrens. Der Gate-Treiber GT umfasst eine Signalerfassung 9 und einen damit verbundenen Istwertgenerator 3 für eine primäre Zustandsvariable $v_C$, $dv_C/dt$, $i_C$, $di_C/dt$, einen Sollwertgenerator 4, ein Istwert-Sollwert Vergleichsglied 6 und einen Verstärker 7 zur Erzeugung eines Stellsignals $i_G$, $v_G$ für das Gate G. Der Sollwertgenerator 4 umfasst einen ersten Generator 41 zur Erzeugung eines ersten Sollwerts $v_C^{ref}$ zur Regelung eines Kollektorstromgradienten $di_C/dt$ in der Phase A und einen zweiten Generator 42 zur Erzeugung eines zweiten Sollwerts $dv_C^{ref}/dt$ zur Regelung eines Kollektor-Emitter-Spannungsgradienten $dv_{CE}/dt$ in der Phase B. Im folgenden werden bevorzugte Ausführungsbeispiele angegeben.

Der Istwertgenerator 3 kann ein Differentiationsglied 31 · zur Gradientenbildung von Istwerten und ein Summationsglied 32 zur gewichteten Addition von Istwerten und Istwertgradienten umfassen. Alternativ können der Istwertgenerator 3 und der Sollwertgenerator 4 einen Extremalwertgenerator 12 zur Bestimmung eines Maximums der Beträge der normierten Regelabweichungen für die Phasen A und B gemäss Fig. 4 umfassen.

Ferner kann der Gate-Treiber GT Mittel 5, 10 zur Detektion eines Ablösezeitpunkts $t_1$, $t_2$ zwischen den Phasen A und B aufweisen. Die Detektionsmittel 5, 10 weisen typischerweise eine Signalerfassung 10 und eine Recheneinheit 5 auf, wobei die Recheneinheit 5 einen Schwellwertschalter 51 für ein Hauptkriterium sowie optional einen Generator 52 für ein Zusatzkriterium aufweist. In einem Validierungsglied 53 wird das Hauptkriterium anhand des Zusatzkriteriums geprüft und für gut befunden oder verworfen. 51a und 52a bezeichnen Signalleitungen für das Hauptkriterium und Zusatzkriterium.

Fig. 12 zeigt einen Gate-Treiber GT mit einer Signalerfassung 9 zur Zurückführung von Istwerten mindestens einer sekundären Zustandsvariablen $i_G$, $v_G$, $di_G/dt$, $dv_G/dt$, $dv_C/dt$ zu mindestens einer Ausgangsstufe 7a, 7b des Verstärkers 7. Beispielhaft werden Signale proportional zur Kollektor-Emitter Spannung $v_{CE}$, zum Kollektor-Emitter Spannungsgradienten $\alpha_3*dv_{CE}/dt$, zur Gate-Emitter Spannung $v_{GE}$, zum Gatestrom $\alpha_1*i_G$ und/oder zum Gatestromgradienten $\alpha_2*di_G/dt$ zurückgeführt, wobei $\alpha_1$, $\alpha_2$ und $\alpha_3$ Proportionalitätskonstanten sind. Hierbei können wie auch an anderer Stelle und in den Ansprüchen im allgemeinen Grössen, die Bezug auf Kollektor C, Emitter E oder Gate G des Leistungshalbleiterschalters $S_1$-$S_4$ nehmen, zugleich auch als bezugnehmend auf Hilfskollektor c, Hilfsemitter e oder Hilfsgate g verstanden werden. $C_7$ bezeichnet die Ausgangskapazität des Verstärkers 7, R einen Messwiderstand, L eine Messinduktivität und $C_{fb}$ eine Auskoppelkapazität. Die Rückführfaktoren $c_1$-$c_5$ dienen zur Gewichtung der zurückgeführten Istwerte der primären und/oder sekundären Zustandsvariablen $v_C$, $dv_C/dt$, $i_C$, $di_C/dt$, $i_G$, $v_G$, $di_G/dt$, $dv_G/dt$. Sie können auch durch Rückführfunktionen f ersetzt sein. Die Istwerte werden in den Gliedern 91, 92, 93 addiert. Ferner kann der Gate-Treiber GT Mittel zur Adaption einer Reglerverstärkung $k_p$ oder einer oberen Schranke $S_M$ oder einer unteren Schranke $S_m$ für das Stellsignal $i_G$, $v_G$ aufweisen.

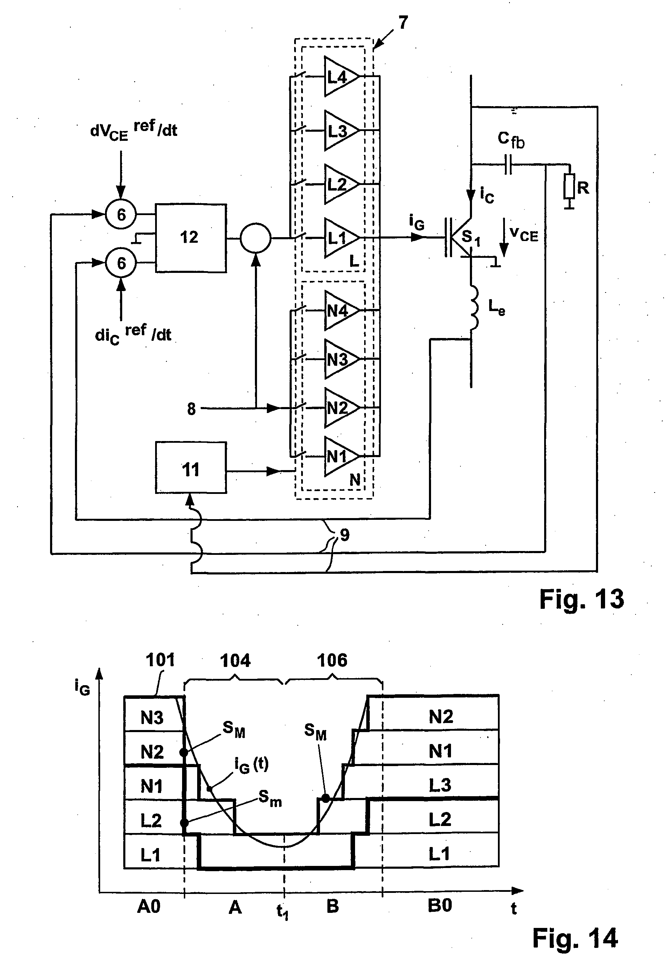

Fig. 13 zeigt einen Gate-Treiber GT mit dem bereits beschriebenen Extremalwertgenerator 12 und mit einer erfindungsgemäss partitionierten Ausgangsstufe des Verstärkers 7. Dieser umfasst eine linear steuerbare erste Stromquelle L mit parallel geschalteten Teilverstärkern oder ersten Partitionen L1-L4 und eine parallel zuschaltbare, nichtlinear oder stufenweise steuerbare zweite Stromquelle N mit parallel geschalteten Teilverstärkern oder zweiten Partitionen N1-N4. Ferner ist eine Struktursteuerung 11 zur Aktivierung der Stromquellen L, N und der Partitionen L1-L4, N1-N4 vorhanden. Die Partitionen L1-L4, N1-N4 können logisch und/oder physikalisch implementiert sein. Durch die Verwendung gewichteter Partitionen L1-L4, N1-N4 können die Transferfunktion des Leistungshalbleiterschalters $S_1$-$S_4$ kompensiert und zugleich die Gate-Treiber Bandbreite maximiert werden.

Fig. 14 zeigt die Funktionsweise des partitionierten Verstärkers 7. Dargestellt sind ein idealer Gatestromverlauf $i_G(t)$ und ein erfindungsgemäss mit Partitionen L1-L3, N1-N3 approximierter Gatestromverlauf. Der ideale Gatestrom $i_G$(t) ist z. B. wie zuvor diskutiert in der Phase A proportional zu $t_A^{-0.5}$ und in der Phase B proportional zu $t_B^2$. In der Phase A0 sind die Partitionen L1-L2 und N1-N3 aktiv. Zu Beginn der Phase A wird der Gatestrom $i_G$ erniedrigt, indem zunächst zweite Partitionen N3, N2, N1 abgeschaltet und danach erste Partitionen L2, L1 abgeschaltet und/oder heruntergeregelt werden. Beim Übergang zwischen den Phasen A und B wird der Gatestrom $i_G$ durch ein Minimum gesteuert und dann während der Phase B durch eine umgekehrte Reihenfolge der Massnahmen aus Phase A wieder erhöht. In der Phase B0 sind je nach Bedarf eine Mehrzahl oder alle der Partitionen L1-L3, N1-N2 aktiv. Durch eine grosse oder maximale Reglerverstärkung $k_p$ werden kurze Schaltzeiten erreicht.

Die fett gezogenen Linien geben eine obere Schranke $S_M$ und eine untere Schranke $S_m$ für den Gatestrom $i_G$ oder die zuschaltbaren Partitionen L1-L4, N1-N4 vor, um Oszillationen, insbesondere die Amplitude einer Eigenschwingung oder eines Grenzzyklus, des Gatestroms $i_G$ zu begrenzen. Die Schranken $S_M$, $S_m$ werden bei Durchlaufen der Phasen A, A0, B, B0 in Abhängigkeit vom idealen Gatestrombedarf angepasst, insbesondere näherungsweise nach Massgabe der diskutierten Zeitabhängigkeiten in der Phase A proportional zu $t_A^{-0.5}$ und in der Phase B proportional zu $t_B^2$. Durch die erste Stromquelle L sind kleine Gateströme $i_G$ mit einer grossen Schnelligkeit, Genauigkeit und Stabilität regelbar. Durch die zweite Stromquelle N sind grosse Gateströme $i_G$ mit sehr steilen Anstiegsflanken und allgemein mit grosser Dynamik regelbar.

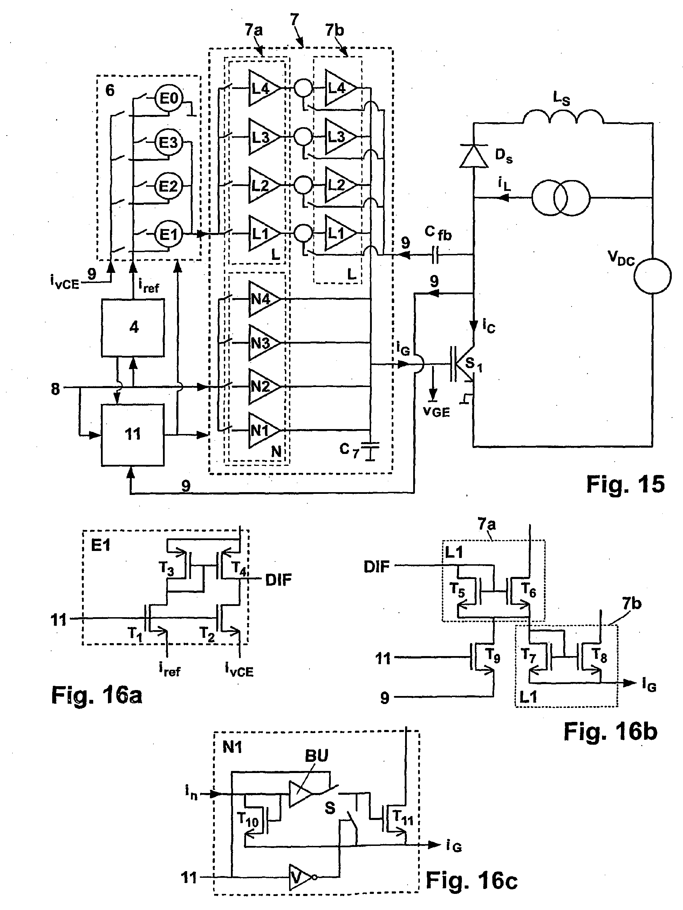

Fig. 15 zeigt eine erweiterte Form des Gate-Treibers GT mit erfindungsgemäss partitionierten Eingangs- und Ausgangsverstärkerstufen. Eingangsseitig ist das Vergleichsglied 6 für einen Istwertstrom $i_{vCE}$ und einen Sollwertstrom $i_{ref}$ für eine Kollektorspannung $v_C$ zur schnellen und präzisen Ansteuerung der Stromquellen L, N in parallel zueinander angeordnete dritte Partitionen E0-E3 aufgeteilt. Ausgangsseitig sind eine erste Verstärkerstufe 7a mit einer linearen oder regelbaren Stromquelle L bzw. L1-L4 und einer nichtlinearen oder stufenweise schaltbaren Stromquelle N bzw. N1-N4 und in Serie eine zweite Verstärkerstufe 7b ausschliesslich mit einer linearen Stromquelle L bzw. L1-L4 vorhanden. In der Struktursteuerung 11 wird durch mindestens einen Schwellwertschalter ein Steuersignal zur Aktivierung der Partitionen L1-L4, N1-N4 und E0-E3 generiert. Dem Schwellwertschalter kann als Eingangsgrösse mittels der Signalerfassung 9 ein Istwert und/oder vom Sollwertgenerator 4 ein Sollwert einer primären und/oder sekundären Zustandsvariablen $v_C$, $dv_C/dt$, $i_C$, $di_C/dt$, $i_G$, $v_G$, $di_G/dt$, $dv_G/dt$ zugeführt werden.

Die Fig. 16a, 16b und 16c zeigen den Aufbau der einzelnen Teilverstärker E0-E3, L1-L4 und N1-N4. Die ersten Partitionen L1-L4 umfassen eine lineare Kaskade von Stromspiegelanordnungen von Transistoren $T_5$-$T_8$. Die Rückführung 9 von Zustandsvariablen zur Stabilisierung des Regelkreises ist über einen Transistor $T_9$, an dessen Gate ein Ausgangssignal der Struktursteuerung 11 anliegt, mit dem Emitter der ersten Stromspiegelanordnung verbunden. Die zweiten Partitionen N1-N4 umfassen eine Spiegelanordnung von Transistoren $T_{10}$-$T_{11}$, wobei das Gate des Ausgangstransistors $T_{11}$ der Spiegelanordnung über einen linearen Buffer BU für Gatespannung zwischen dem Gatepotential des Eingangstransistors $T_{10}$ oder einem (nicht dargestellten) festen Potential und einem weiteren vorgebbaren Potential, insbesondere dem Emitterpotential der Spiegelanordnung, mittels mindestens eines Schalters S umschaltbar ist. Beispielsweise sind ein erster Schalter S direkt und ein zweiter Schalter S über einen Inverter V mit der Struktursteuerung 11 verbunden. $i_n$ bezeichnet den Stromspiegeleingangsstrom, $i_G$ den Gate-Ausgangsstrom für den Gate-Treiber GT. Die dritten Partitionen E0-E3 weisen einen differentiellen Eingang mit den Eingangstransistoren $T_1$, $T_2$ für den Ist- und Sollwertstrom $i_{vCE}$ und $i_{ref}$ der zugehörigen Ist- und Sollwerte der relevanten primären Zustandsvariablen $v_C$, $dv_C/dt$, $i_C$, $di_C/dt$ sowie eine Stromspiegelanordnung von Transistoren $T_3$, $T_4$ auf. Die Struktursteuerung 11 ist mit den Gateanschlüssen von $T_1$, $T_2$ verbunden. DIF bezeichnet das Ausgangssignal der als Vergleichsglied 6 wirksamen Partitionen E0-E3 und zugleich das Eingangssignal der linearen zweiten Partitionen L1-L4. In E0 ist das Ausgangssignal DIF auf ein lokales Bezugspotential abgeleitet, um die Reglerverstärkung zu verringern. In Abweichung von Fig. 15 kann jede erste Partition L1-L3 durch genau eine dritte Partition E1-E3 angesteuert werden. Dann erfolgt die Aktivierung der ersten Partitionen L1-L3 ohne Zwischenschalter direkt über die Aktivierung der dritten Partitionen E1-E3.

Die Erfindung betrifft auch einen Leistungshalbleiterschalter $S_1$-$S_4$ oder eine Anordnung von Leistungshalbleiterschaltern $S_1$-$S_4$ mit mindestens einem erfindungsgemässen Gate-Treiber GT. Insbesondere weist der oder jeder Leistungshalbleiterschalter $S_1$-$S_4$ Mittel zur Erfassung von Messwerten primärer und/oder sekundärer Zustandsvariablen $v_C$, $dv_C/dt$, $i_C$, $di_C/dt$, $i_G$, $v_G$, $di_G/dt$, $dv_G/dt$ auf. Als Leistungshalbleiterschalter sind besonders IGBTs ("insulated gate bipolar transistors"), MOSFETs ("metal oxide field effect transistors") und BJTs ("bipolar junction transistors") geeignet. Die Anordnung kann eine Serieschaltung, eine Parallelschaltung, eine Serieschaltung von Parallelschaltungen und insbesondere ein Schaltermodul wie z. B. ein Wechselrichter für Traktion, Hochspannungsgleichstromübertragung, Radiosender, induktives Erwärmen oder induktives Schweissen sein.

## Patentansprüche

1. Verfahren zur Regelung eines transienten Schaltvorgangs mindestens eines Leistungshalbleiterschalters ($S_1$-$S_4$), der mindestens einen Steueranschluss oder ein Gate (G) umfasst, der oder das durch einen Treiber oder Gate-Treiber (GT) gesteuert wird, und der einen ersten Leistungsanschluss oder Kollektor (C) und einen zweiten Leistungsanschluss oder Emitter (E) umfasst, wobei in Serie zum Leistungshalbleiterschalter ($S_1$-$S_4$) eine Freilaufdiode ($D_s$) angeordnet ist, wobei ferner

   a) für mindestens eine primäre Zustandsvariable ($v_C$, $dv_C/dt$, $i_C$, $di_C/dt$) des Leistungshalbleiterschalters ($S_1$, $S_2$) mindestens ein Istwert bestimmt oder approximiert und zum Gate-Treiber (GT) zurückgeführt wird und
   b) der Istwert und ein Sollwert der primären Zustandsvariablen ($v_C$, $dv_C/dt$, $i_C$, $di_C/dt$) als Eingangsgrössen zur Erzeugung eines Stellsignals ($i_G$, $v_G$) für den Steueranschluss (G) verwendet werden,
   **dadurch gekennzeichnet, dass**
   c) in einer Phase A, in welcher die Freilaufdiode ($D_s$) in einem leitfähigen Zustand ist, ein Kollektorstromgradient $di_C/dt$ des Leistungshalbleiterschalters ($S_1$-$S_4$) geregelt wird und
   d) in einer Phase B, in welcher die Freilaufdiode ($D_S$) in einem Sperrzustand ist, ein Kollektor-Emitter Spannungsgradient $dv_{CE}/dt$ des Leistungshalbleiterschalters ($S_1$-$S_4$) geregelt wird.

2. Verfahren nach Anspruch 1, **dadurch gekennzeichnet, dass**

   a) bei einem Einschaltvorgang die Phasen in der Reihenfolge A-B durchlaufen werden und der Phase A mindestens eine Phase A0 vorangestellt wird, in welcher die Zustandsvariable ($v_C$, $dv_C/dt$, $i_C$, $di_C/dt$) durch ein Steuersignal ($i_G$, $v_G$) für den Steueranschluss (G) in einen Wertebereich gebracht wird, in dem der Kollektorstromgradient $di_C/dt$ durch das Stellsignal ($i_G$, $v_G$) regelbar ist und
   b) insbesondere dass in der Phase A0 eine Gate-Emitter Spannung ($v_G$) auf einen Wert grösser als eine Schwellenspannung ($v_T$) gebracht wird.

3. Verfahren nach einem der vorangehenden Ansprüche, **dadurch gekennzeichnet, dass**

   a) bei einem Ausschaltvorgang die Phasen in der Reihenfolge B-A durchlaufen werden und der Phase B mindestens eine Phase B0 vorangestellt wird, in welcher die Zustandsvariable ($v_C$, $dv_C/dt$, $i_C$, $di_C/dt$) durch ein Steuersignal ($i_G$, $v_G$) für den Steueranschluss (G) in einen Wertebereich gebracht wird, in dem der Kollektor-Emitter Spannungsgradient $dv_{CE}/dt$ durch das Stellsignal ($i_G$, $v_G$) regelbar ist und
   b) insbesondere dass in der Phase B0 eine Gate-Emitter Spannung ($v_G$) auf einen Wert kleiner als einen Grenzwert ($v_T + i_C/g_m$) gebracht wird, wobei $v_T$ =Schwellenspannung, $i_C$=Kollektorstrom und $g_m$=Transkonduktanz des Leistungshalbleiterschalters ($S_1$-$S_4$).

4. Verfahren nach einem der vorangehenden Ansprüche, **dadurch gekennzeichnet, dass**

   a) die primäre Zustandsvariable ($v_C$, $dv_C/dt$, $i_C$, $di_C/dt$) des Leistungshalbleiterschalters ($S_1$-$S_4$) eine Kollektorspannung ($v_C$), ein Kollektorstrom ($i_C$) oder ein Gradient dieser Grössen ($dv_C/dt$, $di_C/dt$) ist und/oder
   b) das Stellsignal ($i_G$, $v_G$) oder ein Steuersignal ($i_G$, $v_G$) ein Gatestrom ($i_G$) oder eine Gatespannung ($v_G$), insbesondere eine Gate-Emitter Spannung ($V_{Ge}$), ist.

5. Verfahren nach einem der vorangehenden Ansprüche, **dadurch gekennzeichnet, dass** zur Erhöhung der Geschwindigkeit des transienten Schaltvorgangs

   a) in der Phase A der Betrag des Kollektorstromgradienten $|di_C/dt|$ vorübergehend erhöht und gegen Ende der Phase A verringert wird und/oder

b) in der Phase B der Betrag des Kollektor-Emitter Spannungsgradienten $|dv_{CE}/dt|$ vorübergehend erhöht und gegen Ende der Phase B verringert wird.

**6.** Verfahren nach einem der vorangehenden Ansprüche, **dadurch gekennzeichnet, dass** zur Verbesserung der Dynamik und Stabilität des Regelungsverfahrens

a) für mindestens eine sekundäre Zustandsvariable ($i_G$, $v_G$, $di_G/dt$, $dv_G/dt$, $dv_{CE}/dt$) des Leistungshalbleiterschalters ($S_1$, $S_2$) ein Istwert bestimmt oder approximiert und zu einer Ausgangsstufe (7a, 7b) des Verstärkers (7) (7a, 7b) des Gate-Treibers (GT) zurückgeführt wird und

b) insbesondere dass die sekundäre Zustandsvariable ($i_G$, $V_G$, $di_G/dt$, $dv_G/dt$, $dv_{CE}/dt$) eine Gatespannung ($v_G$), ein Gatestrom ($i_G$), eine daraus vorzugsweise durch Differentiation abgeleitete Grösse oder der Kollektor-Emitter Spannungsgradient $dv_{CE}/dt$ ist.

**7.** Verfahren nach einem der vorangehenden Ansprüche, **dadurch gekennzeichnet, dass**

a) für mindestens eine primäre und/oder sekundäre Zustandsvariable ($v_C$, $dv_C/dt$, $i_C$, $di_C/dt$, $i_G$, $v_G$, $di_G/dt$, $dv_G/dt$) und/oder eine aus dieser abgeleitete Grösse Istwerte durch Messwerte und/oder Approximationswerte bestimmt werden und/oder

b) Approximationswerte für Istwerte einer Zustandsvariablen ($v_C$, $dv_C/dt$, $i_C$, $di_C/dt$, $i_G$, $v_G$, $di_G/dt$, $dv_G/dt$) aus Messwerten der gleichen oder einer anderen Zustandsvariablen ($v_C$, $dv_C/dt$, $i_C$, $di_C/dt$, $i_G$, $v_G$, $di_G/dt$, $dv_G/dt$), z. B. durch Differentiation, Mittelung, vorzugsweise Bildung eines Kurzzeitmittelwerts, Extrapolation oder Umrechnung, gewonnen werden,

c) insbesondere dass ein Approximationswert für den Kollektorstrom ($i_c$) aus einer Gate-Emitter Spannung ($v_{GE}$, $v_{Ge}$), einem Zeitintegral eines Gatestroms ($i_G$) oder einem Zeitintegral einer Induktionsspannung ($V_{Le}$) über einer Emitterinduktivität ($L_e$) bestimmt wird und

d) insbesondere dass ein Approximationswert für eine Gate-Emitter Spannung ($v_{GE}$, $v_{ge}$) aus einem Zeitintegral eines Gatestroms ($i_G$) bestimmt wird.

**8.** Verfahren nach einem der vorangehenden Ansprüche, **dadurch gekennzeichnet, dass** zur Verringerung einer Regelabweichung zwischen einem Istwert und dem zugehörigen Sollwert einer primären Zustandsvariablen ($v_C$, $dv_C/dt$, $i_C$, $di_C/dt$)

a) aufgrund der Regelabweichung für mindestens eine Phase A, B, A0, B0 des aktuellen oder eines darauffolgenden Schaltvorgangs ein modifizierter Sollwert ($v_C^{ref'}$, $dv_C^{ref'}/dt$, $i_C^{ref'}$, $di_C^{ref'}/dt$) vorgegeben wird und

b) insbesondere dass ein Schätzwert für die Regelabweichung vorzugsweise aufgrund einer Reglerverstärkung ($k_P$) des Gate-Treibers (GT), einer Gate-Kollektor Kapazität ($C_\mu$), einer Transkonduktanz ($g_m$) des Leistungshalbleiterschalters ($S_1$-$S_4$) und einer Gesamtstreuinduktivität ($L_\sigma$) bestimmt wird.

**9.** Verfahren nach einem der vorangehenden Ansprüche, **dadurch gekennzeichnet, dass** zur Erzeugung des Stellsignals ($i_G$, $v_G$) für den Steueranschluss (G)

a) als Sollwert eine zeitlich veränderliche Sollwertfunktion ($v_C^{ref}(t)$, $dv_C^{ref}(t)/dt$, $i_C^{ref}(t)$, $di_C^{ref}(t)/dt$) verwendet wird und/oder

b) Messwerte einer primären und gegebenenfalls sekundären Zustandsvariablen ($v_C$, $dv_C/dt$, $i_C$, $di_C/dt$, $i_G$, $v_G$, $di_G/dt$, $dv_G/dt$) fortlaufend während des transienten Schaltvorgangs erfasst und zum Gate-Treiber (GT) zurückgeführt werden.

**10.** Verfahren nach einem der vorangehenden Ansprüche, **dadurch gekennzeichnet, dass**

a) die primäre Zustandsvariable ($v_C$, $dv_C/dt$, $i_C$, $di_C/dt$) des Leistungshalbleiterschalters ($S_1$-$S_4$) eine Kollektor-Emitter Spannung ($v_{CE}$; $v_{Ce}$, $v_{cE}$, $v_{ce}$) oder eine Kollektor-Gate Spannung ($v_{CG}$; $v_{Cg}$, $v_{cG}$, $v_{cg}$) ist und

b) ein zeitlicher Verlauf der zugehörigen Spannungs-Sollwertfunktion ($v_{CE}^{ref}(t)$, $v_{CG}^{ref}(t)$) so vorgegeben wird, dass in der Phase A der Kollektorstromgradient $di_C/dt$ und in der Phase B der Kollektor-Emitter Spannungsgradient $dv_{CE}/dt$ des Leistungshalbleiterschalters ($S_1$-$S_4$) geregelt werden und

c) insbesondere dass eine stückweise lineare und vorzugsweise trapezförmige Spannungs-Sollwertfunktion ($v_{CE}^{ref}(t)$, $v_{CG}^{ref}(t)$) vorgegeben wird.

**11.** Verfahren nach Anspruch 10, **dadurch gekennzeichnet, dass**

a) in der Phase A eine Amplitudenänderung ($\Delta v_{CE}$, 104) der Spannungs-Sollwertfunktion ($v_{CE}^{ref}(t)$, $v_{CG}^{ref}(t)$) proportional zum zu steuernden Kollektorstromgradienten $di_c/dt$ vorgegeben wird und

b) in der Phase B ein Maximalwert des Gradienten der Spannungs-Sollwertfunktion ($dv_{CE}^{ref}(t)/dt$, $dv_{CG}^{ref}(t)/dt$, 106) proportional zum zu steuernden Kollektor-Emitter Spannungsgradienten $dv_{CE}/dt$ vorgegeben wird.

**12.** Verfahren nach einem der Ansprüche 10-11, **dadurch gekennzeichnet, dass**

a) ein mittlerer Gradient und/oder eine gesamte Amplitudenänderung der Spannungs-Sollwertfunktion ($v_{CE}^{ref}(t)$, $v_{CG}^{ref}(t)$) in der Phase B mindestens zweimal so gross ist/sind wie in der Phase A und/oder

b) in der Phase A ein Betrag einer Amplitudenänderung (101-105, 108-109) der Spannungs-Sollwertfunktion ($v_{CE}^{ref}(t)$, $v_{CG}^{ref}(t)$) in Abhängigkeit von einem Laststrom ($i_L$) im Leistungskreis (2), einer Form eines Zeitverlaufs des Kollektorstroms ($i_C$), einer Temperatur der Freilaufdiode ($D_S$) und/oder eines Abrissverhaltens eines Strom oder einer Spannung ($V_{AK}$) an der Freilaufdiode ($D_S$) angepasst wird.

**13.** Verfahren nach einem der Ansprüche 10-12, **dadurch gekennzeichnet, dass**

a) zur Verkürzung des Einschaltvorgangs in der Phase A mindestens ein grosser Amplitudensprung (103) und nachfolgend ein entgegengesetzt gerichteter kleinerer Amplitudensprung (105) der Spannungs-Sollwertfunktion ($v_{CE}^{ref}(t)$, $v_{CG}^{ref}(t)$) vorgegeben werden und/oder

b) zur Begrenzung eines erforderlichen Gatestroms ($i_G$) bei einem Einschaltvorgang in der Phase B ein Betrag des Kollektor-Emitter Spannungsgradienten $|dv_{CE}/dt|$ in einem Bereich (107) geringer Kollektor-Emitter Spannungen ($v_{CE}$) reduziert wird gegenüber einem Bereich (106) hoher Kollektor-Emitter Spannungen ($v_{CE}$).

**14.** Verfahren nach einem der Ansprüche 10-13, **dadurch gekennzeichnet, dass**

a) eine Phase A0 gemäss Anspruch 2 durch Vorgabe eines kleinen Amplitudensprungs (101) der Spannungs-Sollwertfunktion ($v_{CE}^{ref}(t)$, $v_{CG}^{ref}(t)$) implementiert wird und/oder

b) eine Phase B0 gemäss Anspruch 3 durch Vorgabe eines Minimalwerts der Spannungs-Sollwertfunktion ($v_{CE}^{ref}(t)$, $v_{CG}^{ref}(t)$) initialisiert wird.

**15.** Verfahren nach einem der Ansprüche 10-14, **dadurch gekennzeichnet, dass**

a) bei einem Einschaltvorgang in der Phase A mindestens zwei in einem definierten Zeitabstand aufgenommene Istwerte des Kollektorstroms ($i_C$) gemessen oder approximiert werden und aus einer Regelabweichung zum Sollwert des Kollektorstromgradienten $di_C/dt$ eine Korrekturgrösse ($\Delta\Delta v_{CE}$) zur Bestimmung einer modifizierten Spannungs-Sollwertfunktion ($V_{CE}^{ref'}(t)$, $v_{CG}^{ref'}(t)$) berechnet wird und/oder

b) bei einem Ausschaltvorgang in der Phase A zur Verminderung eines Überschwingens der Kollektor-Emitter Spannung ($v_{CE}$) eine modifizierte Spannungs-Sollwertfunktion ($v_{CE}^{ref'}(t)$, $v_{CG}^{ref'}(t)$) mit einem zeitweilig verringerten Betrag ($\Delta\Delta v_{CE}$, 108) vorgegeben wird.

**16.** Verfahren nach einem der Ansprüche 10-15, **dadurch gekennzeichnet, dass**

a) ein erster Istwert proportional zur Kollektor-Emitter oder Kollektor-Gate Spannung ($v_{CE}$, $v_{CG}$) und mindestens ein zweiter Istwert proportional zum Kollektor-Emitter oder Kollektor-Gate Spannungsgradienten ($dv_{CE}/dt$, $dv_{CG}/dt$) bestimmt und zurückgeführt wird,

b) aus dem ersten Istwert und einem zugehörigen Sollwert eine normierte erste Regelabweichung und aus dem mindestens einen zweiten Istwert und einem zugehörigen Sollwert mindestens eine normierte zweite Regelabweichung bestimmt werden und

c) ein Maximum eines Betrags der Regelabweichungen zur Erzeugung des Stellsignals ($i_G$, $v_G$) verwendet wird.

**17.** Verfahren nach einem der vorangehenden Ansprüche, **dadurch gekennzeichnet, dass**

a) ein Ablösezeitpunkt ($t_1$, $t_2$) zwischen den Phasen A und B detektiert wird und

b) insbesondere dass zur Bestimmung des Ablösezeitpunkts ($t_1$, $t_2$) ein Hauptkriterium und optional ein Zusatzkriterium für eine gemessene oder approximierte primäre und/oder sekundäre Zustandsvariable ($v_C$, $dv_C/dt$, $i_C$, $di_C/dt$, $i_G$, $v_G$, $di_G/dt$, $dv_G/dt$) des Leistungshalbleiterschalters ($S_1$-$S_4$) ausgewertet wird.

**18.** Verfahren nach Anspruch 17, **dadurch gekennzeichnet, dass** bei einem Einschaltvorgang zur Bestimmung des Ablösezeitpunkts ($t_1$, $t_2$) als Hauptkriterium verwendet wird, dass

a) $|V_{AK}| > \varepsilon_{AK}$, wobei $V_{AK}$=eine Spannung über der Freilaufdiode ($D_s$) und $\varepsilon_{AK}$=ein vorgebbarer erster Schwellwert und/oder

b) $|di_C/dt| < \varepsilon_{diC}$, insbesondere $|v_{Le}|/L_e < \varepsilon_{diC}$, wobei $v_{Le}$=eine Induktionsspannung über einer Emitterinduktivität $L_e$ und $\varepsilon_{diC}$=ein vorgebbarer zweiter Schwellwert, insbesondere dass bei einer darauffolgenden Verletzung dieses Hauptkriteriums eine Detektion des Ablösezeitpunkts ($t_1$, $t_2$) nicht widerrufen wird, und/oder

c) $|\Delta v_C| > \varepsilon_{vC}$, wobei $\Delta v_C$=eine Amplitudenänderung der Kollektor-Emitter-Spannung ($v_{CE}$; $v_{Ce}$, $v_{cE}$, $v_{ce}$) und $\varepsilon_{vC}$=ein vorgebbarer dritter Schwellwert und/oder

d) $|dv_C/dt| > \varepsilon_{dvC}$, wobei $\varepsilon_{dvC}$=ein vorgebbarer vierter Schwellwert und/oder

e) $|i_G| < \varepsilon_{iG}$, wobei $i_G$=Gatestrom und $\varepsilon_{iG}$=ein vorgebbarer fünfter Schwellwert und/oder

f) $|dv_G/dt| < \varepsilon_{dvG}$, wobei $dv_G/dt$=ein Gradient einer Gate-Emitter Spannung ($v_{GE}$; $v_{Ge}$, $v_{gE}$, $v_{ge}$) und $\varepsilon_{dvG}$=ein vorgebbarer sechster Schwellwert und/oder

g) $|v_G| < |v_{Gmax}|*\varepsilon_{vGmax}$, wobei $v_{Gmax}$=ein Maximalwert der Gate-Emitter Spannung ($v_{CG}$; $v_{Cg}$, $v_{cG}$, $V_{cg}$) und $\varepsilon_{vGmax}$=ein vorgebbarer siebter Schwellwert und/oder

h) $t_1 > t_M$ oder $t_2 > t_M$, wobei $t_M$=eine Maximaldauer ab Einleitung des Schaltvorgangs und/oder

i) eine Änderung eines Istwerts einer Zustandsvariablen ($v_C$, $dv_C/dt$, $i_C$, $di_C/dt$, $i_G$, $v_G$, $di_G/dt$, $dv_G/dt$) detektierbar ist, insbesondere dass $|\Delta v_C| > \varepsilon_{vC}*\varepsilon_1$, wobei $\varepsilon_{vC}$=ein vorgebbarer dritter Schwellwert und $\varepsilon_1 < 1$ eine Konstante.

**19.** Verfahren nach Anspruch 2 und einem der Ansprüche 17-18, **dadurch gekennzeichnet, dass**

a) durch Messung oder Schätzung einer Induktionsspannung $V_{Le}$ über einer Emitterinduktivität $L_e$ und einer Flussspannung $V_{AKf}$ der Freilaufdiode ($D_S$) in der Phase A0 eine Spannung $V_{AK}$ über der Freilaufdiode ($D_s$) gemäss einer Gleichung $V_{AK}=-\delta v_{CE}+V_{AKf}+K*V_{Le}$ approximiert wird, wobei $\delta v_{CE}$=eine Amplitudenänderung der Kollektor-Emitter Spannung in der Phase A relativ zur.Phase A0 und K=eine Proportionalitätskonstante und

b) insbesondere dass $K=-(L_\sigma-L_C)/L_e$, wobei $L_\sigma=L_C+L_e+L_S$= Gesamtinduktivität eines Leistungskreises (2), $L_C$=Kollektorinduktivität, $L_e$=Emitterinduktivität und $L_S$=Streuinduktivität des Leistungskreises (2), oder dass K eine gemäss einem Schätzwert für $V_{AK}$ vorgebbare Proportionalitätskonstante ist.

**20.** Verfahren nach einem der Ansprüche 17-19, **dadurch gekennzeichnet, dass** als Zusatzkriterium zur Validierung des Hauptkriteriums für den Ablösezeitpunkt ($t_1$, $t_2$) verwendet wird, dass

a) $|v_G| > \varepsilon_{vG}$ mit $\varepsilon_{vG} > v_T$, wobei $v_G$=Gate-Emitter Spannung ($V_{GE}$; $v_{Ge}$, $v_{gE}$, $v_{ge}$), $v_T$=eine Schwellenspannung für eine Leitfähigkeit des Leistungshalbleiterschalters ($S_1$-$S_4$) und $\varepsilon_{vG}$=ein vorgebbarer achter Schwellwert und/oder

b) $|i_C| > \varepsilon_{iC}$, wobei $i_C$=ein Kollektorstrom und $\varepsilon_{iC}$=ein vorgebbarer neunter Schwellwert und/oder

c) $t_1 > t_m$ oder $t_2 > t_m$, wobei $t_m$=eine Mindestdauer ab Einleitung des Schaltvorgangs.

**21.** Verfahren nach einem der vorangehenden Ansprüche, **dadurch gekennzeichnet, dass**

a) ein Regelparameter ($k_p$, $c_1$-$c_5$, f, $S_M$, $S_m$) des Regelungsverfahrens aufgrund von Messwerten oder Approximationswerten einer primären und/oder sekundären Zustandsvariablen ($v_C$, $dv_C/dt$, $i_C$, $di_C/dt$, $i_G$, $v_G$, $di_G/dt$, $dv_G/dt$) und/oder aufgrund eines Erwartungswerts eines idealen Stellsignals ($i_G$, $v_G$) in diskreten Schritten oder kontinuierlich angepasst wird und

b) insbesondere dass der Regelparameter (kp, $S_M$, $S_m$, $c_1$-$c_5$, f) eine Reglerverstärkung (kp), eine obere Schranke ($S_M$) oder eine untere Schranke ($S_m$) für das Stellsignal ($i_G$, $v_G$) oder ein Rückführfaktor ($c_1$-$c_5$) oder eine Rückführfunktion (f) für die Istwert-Rückführung ist.

**22.** Verfahren nach einem der vorangehenden Ansprüche, **dadurch gekennzeichnet, dass** eine zeitlich veränderliche Reglerverstärkungsfunktion ($k_p(t)$) so vorgegeben oder gesteuert wird, dass

a) eine Reglerverstärkung ($k_p$) für das Stellsignal ($i_G$, $v_G$) während eines transienten Einschaltvorgangs zu Beginn der Phase A gross gewählt und dann verringert wird und/oder zu Beginn der Phase B klein gewählt und dann erhöht wird und/oder

b) eine Reglerverstärkung (kp) für das Stellsignal ($i_G$, $v_G$) während eines transienten Ausschaltvorgangs zu Beginn der Phase B gross gewählt und dann verringert wird und/oder zu Beginn der Phase A klein gewählt und dann erhöht wird.

**23.** Verfahren nach Anspruch 22, **dadurch gekennzeichnet, dass**

a) die Reglerverstärkungsfunktion ($k_p(t)$) bei grosser Reglerverstärkung ($k_p$) stufenförmig und bei kleiner Reglerverstärkung ($k_p$) vorzugsweise kontinuierlich variiert wird und/oder

b) die Reglerverstärkung ($k_p$) in einer Phase A0 oder B0 gemäss einem der Ansprüche 2-3 maximal gewählt wird.

**24.** Verfahren nach Anspruch 21 und einem der vorangehenden Ansprüche, **dadurch gekennzeichnet, dass** zur Begrenzung von Oszillationen des Stellsignals ($i_G$, $v_G$)

a) während eines transienten Einschaltvorgangs eine obere Schranke ($S_M$) und/oder eine untere Schranke ($S_m$) für einen Betrag des Stellsignals ($|i_G|$, $|v_G|$) zu Beginn der Phase A gross gewählt und dann verringert wird und/oder zu Beginn der Phase B klein gewählt und dann erhöht wird und/oder

b) während eines transienten Ausschaltvorgangs eine obere Schranke ($S_M$) und/oder eine untere Schranke ($S_m$) für einen Betrag des Stellsignals ($|i_G|$, $|v_G|$) zu Beginn der Phase B gross gewählt und dann verringert wird und/oder zu Beginn der Phase A klein gewählt und dann erhöht wird und

c) insbesondere dass die obere Schranke ($S_M$) und/oder die untere Schranke ($S_m$) in einer Phase A0 oder B0 gemäss einem der Ansprüche 2-3 maximal gewählt wird oder werden.

**25.** Verfahren nach Anspruch 24, **dadurch gekennzeichnet, dass**

a) ein Zeitverlauf für eine obere Schranke ($S_M$) und/oder für eine untere Schranke ($S_m$) eines Betrags eines Gatestroms ($|i_G|$) zumindest teilweise in der Phase A proportional zu $t_A^{-0,5}$ und in der Phase B proportional zu $t_B^2$ approximiert wird, wobei $t_A$, $t_B$=Zeitvariablen für die Phasen A, B, und

b) die obere Schranke ($S_M$) und/oder die untere Schranke($S_m$) im Bereich eines Ablösezeitpunkts ($t_1$, $t_2$) der Phasen A und B durch ein Minimum gesteuert wird.

**26.** Verfahren nach einem der vorangehenden Ansprüche, **dadurch gekennzeichnet, dass**

a) für mindestens eine primäre Zustandsvariable ($v_c$, $dv_c/dt$, $i_c$, $di_c/dt$) mit Hilfe einer oberen Sollwertfunktion und einer unteren Sollwertfunktion ein Toleranzband vorgegeben wird und

b) durch ein gepulstes Stellsignal und/oder Steuersignal ($i_G$, $v_G$) für den Steueranschluss (G) ein Istwert der Zustandsvariablen ($v_c$, $dv_c/dt$, $i_c$, $di_c/dt$) innerhalb des Toleranzbands gehalten wird.

**27.** Verfahren nach Anspruch 26, **dadurch gekennzeichnet, dass** bei einem Ausschaltvorgang nach der Phase A eine Phase C durchlaufen wird, in welcher bei einer Annäherung einer Kollektorspannung ($v_C$) an einen vorgebbaren Maximalwert ($v_{Cmax}$) eine Gatespannung ($v_G$) durch mindestens einen positiven und einen negativen Gatestromimpuls ($i_G$) für eine definierte Zeitdauer über eine Schwellenspannung ($v_T$) gehoben wird, bis die Kollektorspannung ($v_C$) auf einen vorgebbaren Minimalwert ($v_{Cmin}$) absinkt.

**28.** Verfahren nach einem der vorangehenden Ansprüche, **dadurch gekennzeichnet, dass** für einen Ein- oder Ausschaltvorgang einer Serieschaltung von i=1...n Leistungshalbleiterschaltern ($S_1$, $S_2$) mit mindestens einer seriell angeordneten Freilaufdiode ($D_S$) an mindestens n-1 Leistungshalbleiterschaltern ($S_1$, $S_2$) die Kollektor-Emitter Spannung ($v_{CE1}$, $v_{CE2}$) oder die Kollektor-Gate Spannung gemäss einem der Ansprüche 10-16 geregelt wird.

**29.** Verfahren nach Anspruch 28, **dadurch gekennzeichnet, dass** bei einem Einschaltvorgang der Serieschaltung für die Leistungshalbleiterschalter ($S_1$, $S_2$)

a) Phasen A0 gemäss Anspruch 2 individuell, insbesondere asynchron, eingeleitet werden und/oder

b) in der Phase A durch unterschiedliche Einschaltzeitpunkte und/oder unterschiedliche Amplitudenänderungen der Spannungs-Sollwertfunktionen ($v_{CE}^{ref}(t)$, $v_{CG}^{ref}(t)$) einem einzelnen Leistungshalbleiterschalter ($S_2$) ein Hauptteil eines an einer Streuinduktivität der Serieschaltung induzierten Gesamtspannungsabfalls zugewiesen wird oder

c) die Phase A zu einem gemeinsamen Einschaltzeitpunkt eingeleitet wird, wenn ein Istwert des Kollektorstromgradienten $di_C/dt$ und/oder des Kollektorstroms ($i_C$) einen Grenzwert überschreitet.

**30.** Verfahren zum Betrieb einer Serieschaltung von Leistungshalbleiterschaltern ($S_1$, $S_3$, $S_4$) und zu diesen parallel angeordneten Freilaufdioden ($D_{P3}$, $D_{P4}$) in zwei Brückenzweigen einer Halbbrücke eines Wechselrichters, **dadurch gekennzeichnet dass**

a) ein transienter Einschaltvorgang des ersten Brükkenzweigs durch das Regelungsverfahren gemäss einem der vorangehenden Ansprüche geregelt wird und

b) bei einem gleichzeitigen Ausschaltvorgang des zweiten Brückenzweigs Anoden-Kathoden Spannungen ($V_{AK}$) und/oder Verlustleistungen der Freilaufdioden ($D_{P3}$, $D_{P4}$) des zweiten Brückenzweigs wenigstens teilweise **dadurch** begrenzt und insbesondere symmetrisiert werden, dass mindestens eine Freilaufdiode ($D_{P4}$) mit überhöhtem Anoden-Kathoden Spannungsgradienten ($dv_{AK4}/dt$) identifiziert und in einem Regelbetrieb der zugehörige parallele Leistungshalbleiterschalter ($S_4$) in Abhängigkeit vom Regelungsverfahren zeitweilig und/oder partiell geschlossen wird.

**31.** Verfahren nach Anspruch 30, **dadurch gekennzeichnet, dass**

a) der Regelbetrieb eingeleitet wird, sobald die Phase B im Regelungsverfahren detektiert wird und/oder

b) beim Regelbetrieb ein Stellsignal ($i_G$, $v_G$) so vorgegeben wird, dass ein Betrag des Kollektorspannungsgradienten $|dv_{C4}/dt|$ des zugehörigen Leistungshalbleiterschalters ($S_4$) im zweiten Brückenzweig einen Grenzwert $\varepsilon_{dv}$ nicht überschreitet, wobei insbesondere $\varepsilon_{dv}=N/(n*(1+E))$ mit N=ein Betrag eines Erwartungswerts des Kollektorspannungsgradienten $|dv_C/dt|$ des ersten Brückenzweigs, n=eine Anzahl der Freilaufdioden ($D_{P3}$, $D_{P4}$) des zweiten Brükkenzweigs und E= ($dv_C/dt - dv_C^{ref}/dt$) /$dv_C^{ref}/dt$ eine normierte Regelabweichung des Regelbetriebs.

**32.** Verfahren nach einem der Ansprüche 30-31, **dadurch gekennzeichnet, dass**

a) der Regelbetrieb nicht auf alle Freilaufdioden ($D_{P3}$, $D_{P4}$) des zweiten Brückenzweigs gleichzeitig angewendet wird und/oder

b) für eine schnelle Einschaltbarkeit des zugehörigen Leistungshalbleiterschalters ($S_4$) im zweiten Brükkenzweig ein Mittelwert seiner Transkonduktanz ($g_m$) grösser als null eingehalten wird.

**33.** Gate-Treiber (GT) für einen Leistungshalbleiterschalter ($S_1$-$S_4$), **dadurch gekennzeichnet, dass** der Gate-Treiber (GT) Mittel zur Ausführung des Verfahrens gemäss einem der Ansprüche 1-32 aufweist.

**34.** Gate-Treiber (GT) für einen Leistungshalbleiterschalter ($S_1$-$S_4$), insbesondere geeignet zur Ausführung des Verfahrens nach einem der Ansprüche 1-32, umfassend Mess- und Auswertemittel (3, 9) für mindestens eine primäre Zustandsvariable ($v_C$, $dv_C/dt$, $i_C$, $di_C/dt$) eines Leistungshalbleiterschalters ($S_1$), einen Sollwertgenerator (4), ein Istwert-Sollwert Vergleichsglied (6) und einen Verstärker (7) zur Erzeugung eines Stellsignals ($i_G$, $v_G$) für einen Steueranschluss oder ein Gate (G) des Leistungshalbleiterschalters ($S_1$), **dadurch gekennzeichnet, dass**

a) der Sollwertgenerator (4) einen ersten Generator (41) zur Erzeugung eines ersten Sollwerts ($v_C^{ref}$) umfasst, mit welchem in einer Phase A, in der eine zum Leistungshalbleiterschalter ($S_1$) serielle Freilaufdiode ($D_S$) in einem leitfähigen Zustand ist, das Stellsignal ($i_G$, $v_G$) zur Regelung eines Kollektorstromgradienten $di_C/dt$ des Leistungshalbleiterschalters ($S_1$) angepasst wird und

b) der Sollwertgenerator (4) einen zweiten Generator (42) zur Erzeugung eines zweiten Sollwerts ($dv_C^{ref}/dt$) umfasst, mit welchem in einer Phase B, in der die Freilaufdiode ($D_S$) in einem Sperrzustand ist, das Stellsignal ($i_G$, $v_G$) zur Regelung eines Kollektor-Emitter Spannungsgradient $dv_{CE}/dt$ des Leistungshalbleiterschalters ($S_1$) angepasst wird.

**35.** Gate-Treiber (GT) nach Anspruch 34, **dadurch gekennzeichnet, dass**

a) die Mess- und Auswertemittel (3, 9) eine Signalerfassung (9) und einen Istwertgenerator (3) für eine Kollektorspannung ($v_{CE}$, $v_{CG}$) und einen Kollektorspannungsgradienten ($dv_{CE}/dt$, $dv_{CG}/dt$) des Leistungshalbleiterschalters ($S_1$) umfassen,

b) der erste Generator (41) zur Erzeugung einer Kollektorspannungs-Amplitudenänderung ($v_{CE}^{ref}$, $v_{CG}^{ref}$) und der zweite Generator (42) zur Erzeugung eines Kollektorspannungsgradienten ($dv_{CE}^{ref}/dt$, $dv_{CG}^{ref}/dt$) ausgestaltet ist und

c) insbesondere dass der Sollwertgenerator (4) Mittel zur Berechnung aller Sollwerte ($v_C^{ref}$, $dv_C^{ref}/dt$) aus einer gemeinsamen vorgebbaren Spannungs-Sollwertfunktion ($v_{CE}^{ref}(t)$, $v_{CG}^{ref}(t)$) aufweist.

**36.** Gate-Treiber (GT) nach einem der Ansprüche 34-35, **dadurch gekennzeichnet, dass**

a) der Istwertgenerator (3) ein Differentiationsglied (31) zur Gradientenbildung von Istwerten und ein Summationsglied (32) zur gewichteten Addition von Istwerten und Istwertgradienten umfasst oder

b) der Istwertgenerator (3) und der Sollwertgenerator (4) einen Extremalwertgenerator (12) zur Bestimmung eines Maximums von Beträgen normierter Regelabweichungen nach Anspruch 16 umfassen.

**37.** Gate-Treiber (GT) nach einem der Ansprüche 34-36, **dadurch gekennzeichnet, dass**

a) der Gate-Treiber (GT) Detektionsmittel (5, 10) zur Detektion eines Ablösezeitpunkts ($t_1$, $t_2$) zwischen den Phasen A und B gemäss einem der Ansprüche 17-20 aufweist und

b) insbesondere dass die Detektionsmittel (5, 10) eine Signalerfassung (10) und eine Recheneinheit (5) aufweisen, wobei die Recheneinheit (5) einen Schwellwertschalter (51) für ein Hauptkriterium gemäss Anspruch 18 sowie optional einen Generator (52) für ein Zusatzkriterium und ein Validierungsglied (53) gemäss Anspruch 20 umfasst.

**38.** Gate-Treiber (GT) nach einem der Ansprüche 34-37, **dadurch gekennzeichnet, dass**

a) der Gate-Treiber (GT) eine Signalerfassung (9) zur Zurückführung von Istwerten mindestens einer sekundären Zustandsvariablen ($i_G$, $v_G$, $di_G/dt$, $dv_G/dt$, $dv_c/dt$) zu mindestens einer Ausgangsstufe (7a, 7b) des Verstärkers (7) aufweist und/oder

b) der Gate-Treiber (GT) Mittel zur Adaption von Regelparametern (kp, $c_1$-$c_5$, f, $S_M$, $S_m$), insbesondere einer Reglerverstärkung (kp), einer oberen Schranke ($S_M$) oder einer unteren Schranke ($S_m$) für das Stellsignal ($i_G$, $v_G$) oder eines Rückführfaktors ($c_1$-$c_5$) oder einer Rückführfunktion (f) für eine Signalerfassung (9) einer primären und/oder sekundären Zustandsvariablen ($v_C$, $dv_C/dt$, $i_C$, $di_C/dt$, $i_G$, $v_G$, $di_G/dt$, $dv_G/dt$), gemäss einem der Ansprüche 21-25 aufweist.

**39.** Gate-Treiber (GT) nach einem der Ansprüche 34-38, **dadurch gekennzeichnet, dass** der Verstärker (7)

a) ein Stromverstärker (7) für einen Gatestrom ($i_G$) ist und/oder

b) mehrere Ausgangsstufen (7a, 7b) aufweist.

**40.** Gate-Treiber (GT) für einen Leistungshalbleiterschalter ($S_1$-$S_4$), insbesondere nach einem der Ansprüche 33-39, umfassend einen Verstärker (7) mit mindestens einer Ausgangsstufe (7a, 7b) zur Erzeugung eines Stellsignals ($i_G$, $v_G$) für einen Steueranschluss oder ein Gate (G) eines Leistungshalbleiterschalters ($S_1$), **dadurch gekennzeichnet, dass** die Ausgangsstufe (7a, 7b) des Verstärkers (7)

a) mindestens eine linear steuerbare erste Stromquelle (L) zur Erzeugung kleiner Gateströme ($i_G$) mit einer geringen Regelabweichung und einer grossen Regelungsstabilität aufweist und

b) mindestens eine parallel zuschaltbare nichtlinear oder stufenweise steuerbare zweite Stromquelle (N) zur Erzeugung grosser Gateströme ($i_G$) mit einer grossen Regelungsdynamik aufweist.

**41.** Gate-Treiber (GT) nach Anspruch 40, **dadurch gekennzeichnet, dass**

a) die erste Stromquelle (L) in mehrere logische und/oder physikalische erste Partitionen (L1-L4) aufgeteilt ist und/oder

b) die zweite Stromquelle (N) in mehrere logische und/oder physikalische zweite Partitionen (N1-N4) aufgeteilt ist und/oder

c) der Gate-Treiber (GT) eine Struktursteuerung (11) zur Aktivierung der ersten und/oder zweiten Stromquelle (L, N) und/oder von Partitionen (L1-L4, N1-N4) der ersten und/oder zweiten Stromquelle (L, N) aufweist und

d) insbesondere dass die Struktursteuerung (11) mit einer Signalerfassung (9) zur Rückführung eines Istwerts einer primären und/oder sekundären Zustandsvariablen ($v_C$, $dv_C/dt$, $i_C$, $di_C/dt$, $i_G$, $v_G$, $di_G/dt$, $dv_G/dt$) verbunden ist.

**42.** Gate-Treiber (GT) nach Anspruch 40, **dadurch gekennzeichnet, dass** die Struktursteuerung (11), insbesondere zur Ausführung des Verfahrens nach einem der Ansprüche 21-25, so ausgestaltet ist, dass

a) im Verlauf der ersten Phase B oder A eines Schaltvorgangs die zweiten Partitionen (N1-N4) sukzessive abschaltbar und dann die ersten Partitionen (L1-L4) sukzessive runterregelbar und/oder abschaltbar sind,

b) im Verlauf der zweiten Phase B oder A eines Schaltvorgangs die ersten Partitionen (L1-L4) sukzessive raufregelbar und/oder zuschaltbar und dann die zweiten Partitionen (N1-N4) sukzessive zuschaltbar sind und

c) insbesondere dass in Phasen A0 und B0 gemäss den Ansprüchen 2-3 alle Partitionen (L1-L4, N1-N4) aktivierbar sind.

**43.** Gate-Treiber (GT) nach einem der Ansprüche 41-42, **dadurch gekennzeichnet, dass** die Struktursteuerung (11) so ausgestaltet ist, dass

a) ein Zeitverlauf eines Betrags eines Gatestroms ($|i_G|$) näherungsweise in der Phase A proportional zu $t_A^{-0,5}$ und in der Phase B proportional zu $t_B^2$ gesteuert wird, wobei $t_A$, $t_B$=Zeitvariablen für die Phasen A, B,
b) der Betrag des Gatestroms ($|i_G|$) im Bereich eines Ablösezeitpunkts ($t_1$, $t_2$) der Phasen A und B durch ein Minimum gesteuert wird.

**44.** Gate-Treiber (GT) nach Anspruch 41, **dadurch gekennzeichnet, dass** die Struktursteuerung (11) insbesondere zur Ausführung des Verfahrens nach einem der Ansprüche 26-27 so ausgestaltet ist, dass ein gepulster Gatestrom ($i_G$) durch Zuschalten und Abschalten zweiter und/oder erster Partitionen (L1-L4, N1-N4) erzeugbar ist.

**45.** Gate-Treiber (GT) nach einem der Ansprüche 40-44, **dadurch gekennzeichnet, dass**

a) die erste Stromquelle (L1-L4) eine lineare Kaskade von Stromspiegelanordnungen von Transistoren ($T_5$-$T_8$) umfasst und/oder
b) die zweite Stromquelle (N1-N4) eine Spiegelanordnung von Transistoren ($T_{10}$-$T_{11}$) umfasst, wobei ein Gate eines Ausgangstransistors ($T_{11}$) der Spiegelanordnung zwischen zwei Potentialen umschaltbar ist und/oder
c) ein Istwert-Sollwert Vergleichsglied (6) gemäss einem der Ansprüche 33-39 zur schnellen Ansteuerung der Stromquellen (L, N) eine Stromspiegelanordnung von Transistoren ($T_3$, $T_4$) aufweist und insbesondere in dritte Partitionen (E0-E3) mehrerer Stromspiegelanordnungen aufgeteilt ist.

**46.** Leistungshalbleiterschalter ($S_1$-$S_4$) mit einem Gate-Treiber (GT) gemäss einem der Ansprüche 33-45 zur Ansteuerung eines Steueranschlusses oder eines Gates (G) des Leistungshalbleiterschalters ($S_1$-$S_4$).

**47.** Leistungshalbleiterschalter ($S_1$-$S_4$) nach Anspruch 46, **dadurch gekennzeichnet, dass** der Leistungshalbleiterschalter ($S_1$-$S_4$)

a) ein IGBT, ein MOSFET, ein BJT oder eine Kombination von IGBTs, MOSFETs und/oder BJTs ist und/oder
b) Mittel zur Erfassung von Messwerten primärer und/oder sekundärer Zustandsvariablen ($v_C$, $dv_C/dt$, $i_C$, $di_C/dt$, $i_G$, $v_G$, $di_G/dt$, $dv_G/dt$) aufweist.

**48.** Anordnung mehrerer Leistungshalbleiterschalter ($S_1$-$S_4$) gemäss einem der Ansprüche 46-47.

**49.** Anordnung mehrerer Leistungshalbleiterschalter ($S_1$-$S_4$) nach Anspruch 48, **dadurch gekennzeichnet, dass**

a) die Anordnung eine Serieschaltung, ein Parallelschaltung oder eine Serieschaltung von Parallelschaltungen ist und/oder
b) die Anordnung ein Schaltermodul, insbesondere ein Wechselrichter, für Traktion, Hochspannungsgleichstromübertragung, Radiosender, induktives Erwärmen oder induktives Schweissen ist.

**Claims**

**1.** Method for controlling a transient switching operation of at least one power semiconductor switch ($S_1$-$S_4$), which comprises at least one control contact or a gate (G), that is controlled by a driver or gate driver (GT), and which comprises a first power contact or collector (C) and a second power contact or emitter (E), wherein in series to the power semiconductor switch ($S_1$-$S_4$) a free-wheeling diode ($D_S$) is arranged, wherein further

a) for at least one primary state variable ($v_C$, $dv_C/dt$, $i_C$, $di_C/dt$) of the power semiconductor switch ($S_1$, $S_2$) at least one actual value is determined or approximated and fed back to the gate driver (GT) and
b) the actual value and a reference value of the primary state variables ($v_C$, $dv_C/dt$, $i_C$, $di_C/dt$) are used as input variables for generating an actuating signal ($i_G$, $v_G$) for the control contact (G),
**characterized in that**
c) in a phase A, in which the free-wheeling diode ($D_S$) is in a conductive state, a collector current gradient $di_C/dt$

of the power semiconductor switch ($S_1$-$S_4$) is controlled and

d) in a phase B, in which the free-wheeling diode ($D_S$) is in an off-state, a collector-emitter voltage gradient $dv_{CE}/dt$ of the power semiconductor switch ($S_1$-$S_4$) is controlled.

**2.** Method according to claim 1, **characterized in that**

a) during a switching-on operation the phases are run through in the sequence A-B and that the phase A is preceded by at least a phase A0, in which the state variable ($v_C$, $dv_C/dt$, $i_C$, $di_C/dt$) is brought by a control signal ($i_G$, $v_G$) for the control contact (G) into a value range, in which the collector current gradient $di_C/dt$ is controllable by the actuating signal ($i_G$, $v_G$) and

b) in particular that in the phase A0 a gate-emitter voltage ($v_G$) is brought to a value larger than a threshold voltage ($v_T$).

**3.** Method according to one of the preceding claims, **characterized in that**

a) during a switching-off operation the phases are run through in the sequence B-A and that the phases B is preceded by at least a phase B0, in which the state variable ($v_C$, $dv_C/dt$, $i_C$, $di_C/dt$) is brought by a control signal ($i_G$, $v_G$) for the control contact (G) into a value range, in which the collector-emitter voltage gradient $dv_{CE}/dt$ is controllable by the actuating signal ($i_G$, $v_G$) and

b) in particular that in the phase B0 a gate-emitter voltage ($v_G$) is brought to a value smaller than a threshold value ($v_T + i_C/g_m$), wherein $v_T$=threshold voltage, $i_C$=collector current and $g_m$=transconductance of the power semiconductor switch ($S_1$-$S_4$).

**4.** Method according to one of the preceding claims, **characterized in that**

a) the primary state variables ($v_C$, $dv_C/dt$, $i_C$, $di_C/dt$) of the power semiconductor switch ($S_1$-$S_4$) is a collector voltage ($v_C$), a collector current ($i_C$) or a gradient of these variables ($dv_C/dt$, $di_C/dt$) and/or

b) the actuating signal ($i_G$, $v_G$) or the control signal ($i_G$, $v_G$) is a gate current ($i_G$) or a gate voltage ($v_G$), in particular a gate-emitter voltage ($v_{GE}$).

**5.** Method according to one of the preceding claims, **characterized in that** for increasing the velocity of the transient switching operation

a) in the phase A the absolute value of the collector current gradient $|di_C/dt|$ is temporarily increased and towards the end of phase A decreased and/or

b) in the phase B the absolute value of the collector-emitter voltage gradient $|dv_{CE}/dt|$ is temporarily increased and towards the end of phase B decreased.

**6.** Method according to one of the preceding claims, **characterized in that**, for improving the dynamics and stability of the control method

a) for at least one secondary state variable ($i_G$, $v_G$, $di_G/dt$, $dv_G/dt$, $dv_{CE}/dt$) of the power semiconductor switch ($S_1$, $S_2$) an actual value is determined or approximated and fed back to an output stage (7a, 7b) of the amplifier (7) (7a, 7b) of the gate-driver (GT) and

b) in particular that the secondary state variable ($i_G$, $v_G$, $di_G/dt$, $dv_G/dt$, $dv_{CE}/dt$) is a gate voltage ($v_G$), a gate current ($i_G$), a variable that is derived therefrom preferably by differentiation or the collector-emitter voltage gradient $dv_{CE}/dt$.

**7.** Method according to one of the preceding claims, **characterized in that**

a) for at least one primary and/or secondary state variable ($v_C$, $dv_C/dt$, $i_C$, $di_C/dt$, $i_G$, $v_G$, $di_G/dt$, $dv_G/dt$) and/or a variable derived from that actual values and/or approximation values are determined and/or

b) approximation values for actual values of a state variable ($v_C$, $dv_C/dt$, $i_C$, $di_C/dt$, $i_G$, $v_G$, $di_G/dt$, $dv_G/dt$) are obtained from measured values of the same or another state variable ($v_C$, $dv_C/dt$, $i_C$, $di_C/dt$, $i_G$, $v_G$, $di_G/dt$, $dv_G/dt$), e.g. by differentiation, averaging, preferably generation of short term average mean value, extrapolation or conversion,

c) in particular that an approximation value for the collector current ($i_C$) is determined from a gate-emitter voltage ($v_{GE}$, $v_{Ge}$), a time integral of a gate current ($i_G$) or a time integral of an induction voltage ($V_{Le}$) over an emitter

inductivity ($L_e$) and

d) in particular that an approximation value for a gate-emitter voltage ($v_{GE}$, $v_{ge}$) is determined from a time integral of a gate current ($i_G$).

8. Method according to one of the preceding claims, **characterized in that** for reducing a control deviation between an actual value and the respective reference value of a primary state variable ($v_C$, $dv_C/dt$, $i_C$, $di_C/dt$)

   a) on the basis of the control deviation for at least one phase A, B, A0, B0 of the actual or a following switching operation a modified reference value ($v_C^{ref'}$, $dv_C^{ref'}/dt$, $i_C^{ref'}$, $di_C^{ref'}/dt$) is provided and

   b) in particular that an estimated value for the control deviation is determined preferably on the basis of a control gain ($k_P$) of the gate driver (GT), a gate-collector capacity ($C_\mu$), a transconductance ($g_m$) of the power semiconductor switch ($S_1$-$S_4$) and a total leakage inductance ($L_\sigma$).

9. Method according to one of the preceding claims, **characterized in that** for generating the actuating signal ($i_G$, $v_G$) for the control contact (G)

   a) as reference value a time-varying reference value function ($v_C^{ref}(t)$, $dv_C^{ref}(t)/dt$, $i_C^{ref}(t)$, $di_C^{ref}(t)/dt$) is used and/or

   b) measured values of a primary and if applicable secondary state variable ($v_C$, $dv_C/dt$, $i_C$, $di_C/dt$, $i_G$, $v_G$, $di_G/dt$, $dv_G/dt$) are recorded continuously during the transient switching operation and fed back to the gate-driver (GT).

10. Method according to one of the preceding claims, **characterized in that**

    a) the primary state variable ($v_C$, $dv_C/dt$, $i_C$, $di_C/dt$) of the power semiconductor switch ($S_1$-$S_4$) is a collector-emitter voltage ($v_{CE}$; $v_{Ce}$, $v_{cE}$, $v_{ce}$) or a collector-gate voltage ($V_{CG}$; $v_{Cg}$, $V_{cG}$, $V_{Cg}$) and

    b) a time progression of the respective voltage reference value function ($v_{CE}^{ref}(t)$, $v_{CG}^{ref}(t)$) is provided such, that in the phase A the collector current gradient $di_C/dt$ and in the phase B the collector-emitter voltage gradient $dv_{CE}/dt$ of the power semiconductor switch ($S_1$-$S_4$) are controlled and

    c) in particular that a piecewise linear and preferably trapezoidal voltage reference value function ($v_{CE}^{ref}(t)$, $v_{CG}^{ref}(t)$) is provided.

11. Method according to claim 10, **characterized in that**

    a) in the phase A an amplitude variation ($\Delta v_{CE}$, 104) of the voltage reference value function ($v_{CE}^{ref}(t)$, $v_{CG}^{ref}(t)$) is provided proportionally to the collector current gradient $di_c/dt$ to be controlled and

    b) in the phase B a maximum value of the gradient of the voltage reference value function ($dv_{CE}^{ref}(t)/dt$, $dv_{CG}^{ref}(t)/dt$, 106) is provided proportionally to the collector-emitter voltage gradient $dv_{CE}/dt$ to be controlled.

12. Method according to one of the claims 10-11, **characterized in that**

    a) a mean gradient and/or a total amplitude variation of the voltage reference value function ($v_{CE}^{ref}(t)$, $v_{CG}^{ref}(t)$) is/are in the phase B at least twice as large as in the phase A and/or

    b) in the phase A an absolute value of an amplitude variation (101-105, 108-109) of the voltage reference value function ($v_{CE}^{ref}(t)$, $v_{CG}^{ref}(t)$) is adjusted depending on a load current ($i_L$) within the power circuit (2), a shape of a time progression of the collector current ($i_C$), a temperature of the free-wheeling diode ($D_S$) and/or a break-away behaviour of a current or a voltage ($V_{AK}$) at the free-wheeling diode ($D_S$).

13. Method according to one of the claims 10-12, **characterized in that**

    a) for shortening the switching-on operation in the phase A at least one large amplitude jump (103) and subsequently an oppositely directed smaller amplitude jump (105) of the voltage reference value function ($v_{CE}^{ref}(t)$, $v_{CG}^{ref}(t)$) are provided and/or

    b) for limiting a required gate current ($i_G$) at the switching-on operation in the phase B an absolute value of the collector-emitter voltage gradient $|dv_{CE}/dt|$ is reduced in a range (107) of small collector-emitter voltages ($v_{CE}$) compared to a range (106) of high collector-emitter voltages ($v_{CE}$).

14. Method according to one of the claims 10-13, **characterized in that**

a) a phase A0 according to claim 2 is implemented by provision of a small amplitude jump (101) of the voltage reference value function ($v_{CE}^{ref}(t)$, $v_{CG}^{ref}(t)$) and/or
b) a phase B0 according to claim 3 is initialised by provision of a minimum value of the voltage reference value function ($v_{CE}^{ref}(t)$, $v_{CG}^{ref}(t)$).

15. Method according to one of the claims 10-14, **characterized in that**

a) at a switching-on operation in phase A at least two actual values of the collector current ($i_C$), which are recorded in a defined time interval, are measured or approximated and from a control deviation to the reference value of the collector current gradient $di_C/dt$ a correction variable ($\Delta\Delta v_{CE}$) for determining a modified voltage reference value function ($v_{CE}^{ref}(t)$, $v_{CG}^{ref}(t)$) is calculated and/or
b) at a switching-off operation in the phase A for reduction of an overshooting of the collector-emitter voltage ($v_{CE}$) a modified voltage reference value function ($v_{CE}^{ref}(t)$, $v_{CG}^{ref}(t)$) with a temporarily reduced absolute value ($\Delta\Delta v_{CE}$, 108) is provided.

16. Method according to one of the claims 10-15, **characterized in that**

a) a first actual value being proportional to the collector-emitter or collector-gate voltage ($v_{CE}$, $v_{CG}$) and at least one second actual value being proportional to the collector-emitter or collector-gate voltage gradient ($dv_{CE}/dt$, $dv_{CG}/dt$) are determined and fed back ,
b) from the first actual value and a respective reference value a normalized first control deviation and from the at least one second actual value and a respective reference value at least one normalized second control deviation are determined and
c) a maximum of an absolute value of the control deviations is used for generating the actuating signal ($i_G$, $v_G$).

17. Method according to one of the preceding claims, **characterized in that**

a) a transfer time ($t_1$, $t_2$) between the phases A and B is detected and
b) in particular that for determination of the transfer time ($t_1$, $t_2$) a main criterion and optionally an additional criterion for a measured or approximated primary and/or secondary state variable ($v_C$, $dv_C/dt$, $i_C$, $di_C/dt$, $i_G$, $v_G$, $di_G/dt$, $dv_G/dt$) of the power semiconductor switch ($S_1$-$S_4$) is evaluated.

18. Method according to claim 17, **characterized in that** at a switching-on operation for determination of the transfer time ($t_1$, $t_2$) as main criterion is used that

a) $|V_{AK}| > \varepsilon_{AK}$, wherein $V_{AK}$=a voltage over the free-wheeling diode ($D_S$) and $\varepsilon_{AK}$=a providable first threshold value and/or
b) $|di_C/dt| < \varepsilon_{diC}$, in particular $|v_{Le}|/L_e < \varepsilon_{diC}$, wherein $v_{Le}$=an induction voltage over an emitter inductivity $L_e$ and $\varepsilon_{diC}$=a providable second threshold value, in particular that at a following violation of this main criterion a detection of the transfer time ($t_1$, $t_2$) is not revoked, and/or
c) $|\Delta v_C| > \varepsilon_{vC}$, wherein $\Delta v_C$=an amplitude variation of the collector-emitter voltage ($v_{CE}$; $v_{Ce}$, $v_{cE}$, $v_{ce}$) and $\varepsilon_{vC}$=a providable third threshold value and/or
d) $|dv_C/dt| > \varepsilon_{dvC}$, wherein $\varepsilon_{dvC}$=a providable fourth threshold value and/or
e) $|i_G| < \varepsilon_{iG}$, wherein $i_G$=gate current and $\varepsilon_{iG}$=a providable fifth threshold value and/or
f) $|dv_G/dt| < \varepsilon_{dvG}$, wherein $dv_G/dt$=a gradient of a gate-emitter voltage ($v_{GE}$; $v_{Ge}$, $v_{gE}$, $v_{ge}$) and $\varepsilon_{dvG}$=a providable sixth threshold value and/or
g) $|v_G| < |v_{Gmax}|^*\varepsilon_{vGmax}$, wherein $v_{Gmax}$=a maximum value of the gate-emitter voltage ($v_{CG}$; $v_{Cg}$, $v_{cG}$, $v_{cg}$) and $\varepsilon_{vGmax}$=a providable seventh threshold value and/or
h) $t_1 > t_M$ oder $t_2 > t_M$, wherein $t_M$=a maximum period since initiation of the switching operation and/or
i) a variation of an actual value of a state variable ($v_C$, $dv_C/dt$, $i_C$, $di_C/dt$, $i_G$, $V_G$, $di_G/dt$, $dv_G/dt$) is detectable, in particular that $|\Delta v_C| > \varepsilon_{vC}^*\varepsilon_1$, wherein $\varepsilon_{vC}$=a providable third threshold value and $\varepsilon_1 < 1$ a constant.

19. Method according to claim 2 and one of the claims 17-18, **characterized in that**

a) by measuring or estimating an induction voltage $V_{Le}$ over an emitter inductivity $L_e$ and a flux voltage $V_{AKf}$ of the free-wheeling diode ($D_S$) in the phase A0 a voltage $V_{AK}$ over the free-wheeling diode ($D_S$) is approximated according to an equation $V_{AK}=-\delta v_{CE}+V_{AKf}+K^*V_{Le}$, wherein $\delta v_{CE}$=an amplitude variation of the collector-emitter voltage in the phase A relatively to the phase A0 and K=a proportionality constant and

b) in particular that $K=-(L_\sigma-L_C)/L_e$, wherein $L_\sigma=L_C+L_e+L_S$=total inductivity of a power circuit (2), $L_C$=collector inductivity, $L_e$=emitter inductivity and $L_S$=leakage inductivity of the power circuit (2), or that K is a proportionality constant which is providable according to an estimated value for $V_{AK}$.

20. Method according to one of the claims 17-19, **characterized in that** as additional criterion for validation of the main criterion for the transfer time ($t_1$, $t_2$) is used that

a) $|v_G| > \varepsilon_{vG}$ mit $\varepsilon_{vG} > v_T$, wherein $v_G$=gate-emitter voltage ($v_{GE}$; $v_{Ge}$, $v_{gE}$, $v_{ge}$), $v_T$=a threshold voltage for a conductivity of the power semiconductor switch ($S_1$-$S_4$) and $\varepsilon_{vG}$=a providably eighth threshold value and/or

b) $|i_C| > \varepsilon_{iC}$, wherein $i_C$=a collector current and $\varepsilon_{iC}$=a providable nineth threshold value and/or

c) $t_1 > t_m$ or $t_2 > t_m$, wherein $t_m$=a minimum period since initiation of the switching operation.

21. Method according to one of the preceding claims, **characterized in that**

a) a control parameter ($k_p$, $c_1$-$c_5$, f, $S_M$, $S_m$) of the control method is adjusted in discrete steps or continuously on the basis of measured values or approximation values of a primary and/or secondary state variable ($v_C$, $dv_C/dt$, $i_C$, $di_C/dt$, $i_G$, $v_G$, $di_G/dt$, $dv_G/dt$) and/or on the basis of an expected value of an ideal actuating signal ($i_G$, $v_G$) and

b) in particular that the control parameter ($k_p$, $S_M$, $S_m$, $c_1$-$c_5$, f) is a control gain ($k_p$), an upper limit ($S_M$) or a lower limit ($S_m$) for the actuating signal ($i_G$, $v_G$) or a feedback factor ($c_1$-$c_5$) or a feedback function (f) for the feedback of the actual value.

22. Method according to one of the preceding claims, **characterized in that** a time-varying control gain function ($k_P(t)$) is provided or controlled such, that

a) a control gain ($k_p$) for the actuating signal ($i_G$, $v_G$) during a transient switching-on operation is chosen large at the beginning of phase A and is then decreased and/or is chosen small at the beginning of the phase B and then increased and/or

b) a control gain (kp) for the actuating signal ($i_G$, $v_G$) during a transient switching-off operation is chosen large at the beginning of phase B and then decreased and/or is chosen small at the beginning of phase A and then increased.

23. Method according to claim 22, **characterized in that**

a) the control gain function ($k_p(t)$) is varied at a large control gain ($k_p$) stepwise and a a small control gain ($k_p$) preferably continuously and/or

b) the control gain ($k_p$) in a phase A0 or B0 according to one of the claims 2-3 is chosen maximum.

24. Method according to claim 21 and one of the preceding claims, **characterized in that** for limitation of oscillations of the actuating signal ($i_G$, $v_G$)

a) during a transient switching-on operation an upper limit ($S_M$) and/or a lower limit ($S_m$) for an absolute value of the actuating signal ($|i_G|$, $|v_G|$) is chosen large at the beginning of phase A and then decreased and/or is chosen small at the beginning of phase B and then increased and/or

b) during a transient switching-off operation an upper limit ($S_M$) and/or a lower limit ($S_m$) for an absolute value of an actuating signal ($|i_G|$, $|v_G|$) is chosen large at the beginning of phase B and then decreased and/or is chosen small at the beginning of phase A and then increased and

c) in particular that the upper limit ($S_M$) and/or the lower limit ($S_m$) in a phase A0 or B0 according to one of the claims 2-3 is or are chosen maximum.

25. Method according to claim 24, **characterized in that**

a) a time progression for an upper limit ($S_M$) and/or for a lower limit ($S_m$) of an absolute value of a gate current ($|i_G|$) is approximated at least partially in the phase A proportionally to $t_A^{-0,5}$ and in the phase B proportionally to $t_B^2$, wherein $t_A$, $t_B$=time variables for the phases A, B, and

b) the upper limit ($S_M$) and/or the lower limit ($S_m$) in the range of the transfer time ($t_1$, $t_2$) of the phases A and B is controlled by a minimum.

**26.** Method according to one of the preceding claims, **characterized in that**

a) for at least one primary state variable ($v_C$, $dv_C/dt$, $i_C$, $di_C/dt$) a tolerance band is provided by means of an upper reference value function and a lower reference value function and

b) by a pulsed actuating signal and/or control signal ($i_G$, $v_G$) for the control contact (G) an actual value of the state variable ($v_C$, $dv_C/dt$, $i_C$, $di_C/dt$) is held within the tolerance band.

**27.** Method according to claim 26, **characterized in that** during a switching-off operation after the phase A a phase C is run through, in which at a convergency of a collector voltage ($v_C$) to a providable maximum value ($v_{Cmax}$) a gate voltage ($v_G$) is lifted by at least one positive and one negative gate current pulse ($i_G$) for a defined time period above a threshold voltage ($v_T$), until the collector voltage ($v_C$) falls to a providable minimum value ($v_{Cmin}$).

**28.** Method according to one of the preceding claims, **characterized in that** for a switching-on or a switching-off operation of a serial connection of i=1...n power semiconductor switches ($S_1$, $S_2$) with at least one serially arranged free-wheeling diode ($D_s$) the collector-emitter voltage ($v_{CE1}$, $v_{CE2}$) or the collector-gate voltage according to one of the claims 10-16 is controlled at at least n-1 power semiconductor switches ($S_1$, $S_2$).

**29.** Method according to claim 28, **characterized in that** during a switching-on operation of the serial connection for the power semiconductor switches ($S_1$, $S_2$)

a) phases A0 according to claim 2 are initiated individually, in particular asynchronously, and/or

b) in the phase A through different switching-on times and/or different amplitude variations of the voltage reference value functions ($v_{CE}^{ref}(t)$, $v_{CG}^{ref}(t)$) one single power semiconductor switch ($S_2$) is assigned a main part of a total voltage fall being induced at a leakage inductivity of the serial connection or

c) the phase A is initiated at a common initiation time, if an actual value of the collector current gradient $di_C/dt$ and/or the collector current ($i_C$) exceeds a threshold value.

**30.** Method for operating a series connection of power semiconductor switches ($S_1$, $S_3$, $S_4$) and free-wheeling diodes ($D_{P3}$, $D_{P4}$) arranged in parallel to these in two bridge sections of a half-bridge of an inverter, **characterized in that**

a) a transient switching-on operation of the first bridge section is controlled by the control method according to one of the preceding claims and

b) during a concurrent switching-off operation of the second bridge section anode-cathode voltages ($V_{AK}$) and/or power loss of the free-wheeling diodes ($D_{P3}$, $D_{P4}$) of the second bridge section are at least partially thereby limited and in particular made symmetrical, that at least one free-wheeling diode ($D_{P4}$) with exaggerated anode-cathode voltage gradient ($dv_{AK4}/dt$) is identified and that in a control operation the respective parallel power semiconductor switch ($S_4$) is temporarily and/or partially closed depending on the control method.

**31.** Method according to claim 30, **characterized in that**

a) the control operation is initiated as soon as the phase B is detected in the control method and/or

b) during control operation an actuating signal ($i_G$, $v_G$) is provided such, that an absolute value of the collector voltage gradient $|dv_{C4}/dt|$ of the respective power semiconductor switch ($S_4$) in the second bridge section does not exceed a threshold value $\varepsilon_{dv}$, wherein in particular $\varepsilon_{dv}=N/(n*(1+E))$ with N=an absolute value of an expected value of the collector voltage gradient $|dv_C/dt|$ of the first bridge section, n=a number of the free-wheeling diodes ($D_{P3}$, $D_{P4}$) of the second bridge section and E= $(dv_C/dt-dv_C^{ref}/dt)/dv_C^{ref}/dt$ a normalized control deviation of the control operation.

**32.** Method according to one of the claims 30-31, **characterized in that**

a) the control operation is applied not to all free-wheeling diodes ($D_{P3}$, $D_{P4}$) of the second bridge section concurrently and/or

b) for a fast switching-on ability of the respective power semiconductor switch ($S_4$) in the secondd bridge section a mean value of its transconductance ($g_m$) is kept larger than zero.

**33.** Gate driver (GT) for a power semiconductor switch ($S_1$-$S_4$), **characterized in that** the gate driver (GT) has means for carrying out the method according to one of the claims 1-32.

**34.** Gate driver (GT) for a power semiconductor switch ($S_1$-$S_4$), in particular suitable for carrying out the method according to one of the claims 1-32, comprising measuring and evaluation means (3, 9) for at least one primary state variable ($v_C$, $dv_C/dt$, $i_C$, $di_C/dt$) of a power semiconductor switch ($S_1$), a reference value generator (4), an actual value-reference value comparison element (6) and an amplifier (7) for generating an actuating signal ($i_G$, $v_G$) for a control contact or a gate (G) of the power semiconductor switch ($S_1$), **characterized in that**

a) the reference value generator (4) comprises a first generator (41) for generating a first reference value ($v_C^{ref}$), by means of which in a phase A, in which a free-wheeling diode ($D_S$), which is serial to the power semiconductor switch ($S_1$), is in a conductive state, the actuating signal ($i_G$, $v_G$) for controlling a collector current gradient $di_C/dt$ of the power semiconductor switch ($S_1$) is adjusted and

b) the reference value generator (4) comprises a second generator (42) for generating a second reference value ($dv_C^{ref}/dt$), by means of which in a phase B, in which the free-wheeling diode ($D_S$) is in a cut-off state, the actuating signal ($i_G$, $v_G$) for controlling a collector-emitter voltage gradient $dv_{CE}/dt$ of the power semiconductor switch ($S_1$) is adjusted.

**35.** Gate driver (GT) according to claim 34, **characterized in that**

a) the measuring and evaluation means (3, 9) comprise a signal acquisition (9) and an actual value generator (3) for a collector voltage ($v_{CE}$, $v_{CG}$) and a collector voltage gradient ($dv_{CE}/dt$, $dv_{CG}/dt$) of the power semiconductor switch ($S_1$),

b) the first generator (41) is formed for generation of a collector voltage amplitude variation ($v_{CE}^{ref}$, $V_{CG}^{ref}$) and the second generator (42) is formed for generation of a collector voltage gradient ($dv_{CE}^{ref}/dt$, $dv_{CG}^{ref}/dt$) and

c) in particular that the reference value generator (4) has means for calculating all reference values ($v_C^{ref}$, $dv_C^{ref}/dt$) from a common providable voltage reference value function ($v_{CE}^{ref}(t)$, $v_{CG}^{ref}(t)$).

**36.** Gate driver (GT) according to one of the claims 34-35, **characterized in that**

a) the actual value generator (3) comprises a differentiation element (31) for gradient determination of actual values and a summation element (32) for weighted addition of actual values and actual value gradients or

b) the actual value generator (3) and the reference value generator (4) comprise an extremal value generator (12) for determining a maximum of the absolute values of normalized control deviations according to claim 16.

**37.** Gate driver (GT) according to one of the claims 34-36, **characterized in that**

a) the gate driver (GT) has detection means (5, 10) for detection of a transfer time ($t_1$, $t_2$) between the phases A and B according to one of the claims 17-20 and

b) in particular that the detection means (5, 10) have a signal acquisition (10) and a calculation unit (5), wherein the calculation unit (5) comprises a threshold value switch (51) for a main criterion according to claim 18 as well as optionally a generator (52) for an additional criterion and a validation element (53) according to claim 20.

**38.** Gate driver (GT) according to one of the claims 34-37, **characterized in that**

a) the gate driver (GT) has a signal acquisition (9) for feeding back actual values of at least one secondary state variable ($i_G$, $v_G$, $di_G/dt$, $dv_G/dt$, $dv_C/dt$) to at least one output stage (7a, 7b) of the amplifier (7) and/or

b) the gate driver (GT) has means for the adaption of control parameters (kp, $c_1$-$c_5$, f, $S_M$, $S_m$), in particular a control gain (kp), an upper limit ($S_m$) or a lower limit ($S_m$) for the actuating signal ($i_G$, $v_G$) or a feedback factor ($c_1$-$c_5$) or a feedback function (f) for a signal acquisition (9) of a primary and/or a secondary state variable ($v_C$, $dv_C/dt$, $i_C$, $di_C/dt$, $i_G$, $v_G$, $di_G/dt$, $dv_G/dt$), according to one of the claims 21-25.

**39.** Gate driver (GT) according to one of the claims 34-38, **characterized in that** the amplifier (7)

a) is a current amplifier (7) for a gate current ($i_G$) and/or

b) has several output stages (7a, 7b).

**40.** Gate driver (GT) for a power semiconductor switch ($S_1$-$S_4$), in particular according to one of the claims 33-39, comprising an amplifier (7) with at least one output stage (7a, 7b) for generating an actuating signal ($i_G$, $v_G$) for a control contact or a gate (G) of a power semiconductor switch ($S_1$), **characterized in that** the output stage (7a, 7b) of the amplifier (7)

a) has at least one linearly controllable first current source (L) for generating small gate currents ($i_G$) with a small control deviation and a large control stability and
b) has at least one parallel connectable nonlinearly or stepwise controllable second current source (N) for generating large gate currents ($i_G$) with large control dynamics.

**41.** Gate driver (GT) according to claim 40, **characterized in that**

a) the first current source (L) is partitioned into several logical and/or physical first partitions (L1-L4) and/or
b) the second current source (N) is partitioned into several logical and/or physical second partitions (N1-N4) and/or
c) the gate driver (GT) has a structure controller (11) for activating the first and/or the second current source (L, N) and/or the partitions (L1-L4, N1-N4) of the first and/or second current source (L, N) and
d) in particular that the structure controller (11) is connected to a signal acquisition (9) for feeding back an actual value of a primary and/or secondary state variable ($v_C$, $dv_C/dt$, $i_C$, $di_C/dt$, $i_G$, $v_G$, $di_G/dt$, $dv_G/dt$) .

**42.** Gate driver (GT) according to claim 40, **characterized in that** the structure controller (11), in particular for carrying out the method according to one of the claims 21-25, is formed such that

a) in the course of the first phase B or A of a switching operation the second partitions (N1-N4) successively can be switched off and then the first partitions (L1-L4) successively can be controlled down and/or can be switched off
b) in the course of the second phase B or A of a switching operation the first partitions (L1-L4) successively can be controlled up and/or can be switched on and then the second partitions (N1-N4) can successively be switched on and
c) in particular that in phases A0 and B0 according to claims 2-3 all partitions (L1-L4, N1-N4) can be activated.

**43.** Gate driver (GT) according to one of the claims 41-42, **characterized in that** the structure controller (11) is formed such that

a) a time progression of an absolute value of a gate current ($|i_G|$) approximately is controlled in the phase A proportionally to $t_A^{-0,5}$ and in the phase B proportionally to $t_B^2$, wherein $t_A$, $t_B$=time variables for the phases A, B,
b) the absolute value of the gate current ($|i_G|$) is controlled in the range of a transfer time ($t_1$, $t_2$) of the phases A and B by a minimum.

**44.** Gate driver (GT) according to claim 41, **characterized in that** the structure controller (11) is formed in particular for carrying out the method according to one of the claims 26-27 such that a pulsed gate current ($i_G$) can be generated by switching on and switching off second and/or first partitions (L1-L4, N1-N4).

**45.** Gate driver (GT) according to one of the claims 40-44, **characterized in that**

a) the first current source (L1-L4) comprises a linear cascade of current mirror arrangements of transistors ($T_5$-$T_8$) and/or
b) the second current source (N1-N4) comprises a mirror arrangement of transistors ($T_{10}$-$T_{11}$), wherein a gate of an output transistor ($T_{11}$) of the mirror arrangement can be switched between two potentials and/or
c) an actual value-reference value comparison element (6) according to one of the claims 33-39 has for faster control of the current sources (L, N) a current mirror arrangement of transistors ($T_3$, $T_4$) and is in particular in third partitions (E0-E3) of several current mirror arrangements partitioned.

**46.** Power semiconductor switch ($S_1$-$S_4$) with a gate driver (GT) according to one of the claims 33-45 for controlling a control contact or a gate (G) of the power semiconductor switch ($S_1$-$S_4$).

**47.** Power semiconductor switch ($S_1$-$S_4$) according to claim 46, **characterized in that** the power semiconductor switch ($S_1$-$S_4$)

a) is an IGBT, a MOSFET, a BJT or a combination of IGBTs, MOSFETs and/or BJTs and/or
b) has means for recording measured values of primary and/or secondary state variables ($v_C$, $dv_C/dt$, $i_C$, $di_C/dt$, $i_G$, $v_G$, $di_G/dt$, $dv_G/dt$).

**48.** Arrangement of several power semiconductor switches ($S_1$-$S_4$) according to one of the claims 46-47.

**49.** Arrangement of several power semiconductor switches ($S_1$-$S_4$) according to claim 48, **characterized in that**

a) the arrangement is a serial connection, a parallel connection or a serial connection of parallel connections and/or

b) the arrangement is a switch module, in particular an inverter, for traction, high voltage direct current transmission, radio transmitter, inductive heating or inductive welding.

**Revendications**

**1.** Procédé pour le réglage d'une opération de commutation transitoire d'au moins un commutateur de puissance à semi-conducteur ($S_1$-$S_4$), qui comporte au moins une borne de commande ou une grille (G), laquelle est commandée par un pilote ou un pilote de grille (GT), et qui comporte une première borne de puissance ou collecteur (C) et une seconde borne de puissance ou émetteur (E), une diode de roue libre ($D_S$) étant disposée en série par rapport au commutateur de puissance à semi-conducteur ($S_1$-$S_4$), dans lequel en outre :

a) au moins une valeur réelle est déterminée ou approchée pour au moins une variable d'état ($v_c$, $dv_c/dt$, $i_c$, $di_c/dt$) primaire du commutateur de puissance à semi-conducteur ($S_1$, $S_2$), et est ramenée au pilote de grille (GT) et

b) la valeur réelle et une valeur de consigne des variables d'état ($v_c$, $dv_c/dt$, $i_c$, $di_c/dt$) primaires sont utilisées comme grandeurs d'entrée pour générer un signal de réglage ($i_G$, $v_G$) pour la borne de commande (G), **caractérisé en ce que**

c) un gradient du courant de collecteur $di_c/dt$ du commutateur de puissance à semi-conducteur ($S_1$-$S_4$) est réglé dans une phase A, dans laquelle la diode de roue libre ($D_S$) se trouve dans un état conducteur et

d) un gradient de tension collecteur-émetteur $dv_{CE}/dt$ du commutateur de puissance à semi-conducteur ($S_1$-$S_4$) est réglé dans une phase B, dans laquelle la diode de roue libre ($D_S$) se trouve dans un état de blocage.

**2.** Procédé selon la revendication 1, **caractérisé en ce que**

a) lors d'une opération de connexion, les phases sont parcourues dans l'ordre A-B et la phase A est précédée d'au moins une phase A0, dans laquelle la variable d'état ($v_c$, $dv_c/dt$, $i_C$, $di_c/dt$) est amenée par un signal de commande ($i_G$, $v_G$) pour la borne de commande (G) dans une plage de valeurs dans laquelle le gradient du courant de collecteur $di_c/dt$ peut être réglé par le signal de réglage ($i_G$, $v_G$) et

b) en particulier **en ce que**, dans la phase A0, une tension grille-émetteur ($v_G$) est amenée à une valeur supérieure à une tension de seuil (VT).

**3.** Procédé selon l'une des revendications précédentes, **caractérisé en ce que**

a) lors d'une opération de déconnexion, les phases sont parcourues dans l'ordre B-A et la phase B est précédée d'au moins une phase B0, dans laquelle la variable d'état ($v_c$, $dv_c/dt$, $i_c$, $di_c/dt$) est amenée par un signal de commande ($i_G$, $v_G$) pour la borne de commande (G) dans une plage de valeurs dans laquelle le gradient de tension collecteur-émetteur $dv_{ct}/dt$ peut être réglé par le signal de réglage ($i_G$, $v_G$) et

b) en particulier **en ce que**, dans la phase B0, une tension grille-émetteur ($v_G$) est amenée à une valeur inférieure à une valeur limite ($v_T+i_c/g_m$), dans laquelle $v_T$ = la tension de seuil, $i_c$ = le courant de collecteur et $g_m$ = la transconductance du commutateur de puissance à semi-conducteur ($S_1$-$S_4$).

**4.** Procédé selon l'une des revendications précédentes, **caractérisé en ce que**

a) la variable d'état primaire ($v_c$, $dv_c/dt$, $i_c$, $di_c/dt$) du commutateur de puissance à semi-conducteur ($S_1$-$S_4$) est une tension de collecteur ($v_c$), un courant de collecteur ($i_c$) ou un gradient de ces grandeurs ($dv_c/dt$, $di_c/dt$), et/ou

b) le signal de réglage ($i_G$, $v_G$) ou un signal de commande ($i_G$, $v_G$) est un courant de grille ($i_G$) ou une tension de grille ($v_G$), en particulier une tension grille-émetteur ($v_{Ge}$).

**5.** Procédé selon l'une des revendications précédentes, **caractérisé en ce que**, pour augmenter la vitesse de l'opération de commutation transitoire

a) le montant du gradient de courant de collecteur $|di_c/dt|$ est augmenté provisoirement dans la phase A et est réduit vers la fin de la phase A et/ ou

b) le montant du gradient de tension collecteur-émetteur $|dv_{CE}/dt|$ est augmenté provisoirement dans la phase B et réduit vers la fin de la phase B.

**6.** Procédé selon l'une des revendications précédentes, **caractérisé en ce que**, pour améliorer la dynamique et la stabilité du procédé de réglage

a) une valeur réelle est déterminée ou approchée pour au moins une variable d'état ($i_G$, $v_G$, $di_G/dt$, $dv_G/dt$, $dv_{CE}/dt$) secondaire du commutateur de puissance à semi-conducteur ($S_1$, $S_2$), et est ramenée à un niveau de sortie (7a, 7b) de l'amplificateur (7) (7a, 7b) du pilote de grille (GT) et

b) en particulier **en ce que** la variable d'état ($i_G$, $v_G$, $di_G/dt$, $dv_G/dt$, $dv_{CE}/dt$) secondaire est une tension de grille ($v_G$), un courant de grille ($i_G$), une grandeur déduite de cette valeur de préférence par différenciation, ou le gradient de tension collecteur-émetteur $dv_{CE}/dt$.

**7.** Procédé selon l'une des revendications précédentes, **caractérisé en ce que**

a) des valeurs réelles sont déterminées par des valeurs de mesure et/ou des valeurs d'approximation pour au moins une variable d'état ($v_c$, $dv_c/dt$, $i_c$, $di_c/dt$, $i_G$, $v_G$, $di_G/dt$, $dv_G/dt$) primaire et/ou secondaire et/ ou une grandeur déduite de cette variable, et/ ou

b) des valeurs d'approximation pour des valeurs réelles d'une variable d'état ($v_c$, $dv_c/dt$, $i_c$, $di_c/dt$, $i_G$, $v_G$, $di_G/dt$, $dv_G/dt$) sont obtenues à partir de valeurs de mesure des mêmes variables d'état ou d'une autre variable d'état ($v_c$, $dv_c/dt$, $i_c$, $di_c/dt$, $i_G$, $v_G$, $di_G/dt$, $dv_G/dt$), par exemple par différenciation, calcul de moyenne, de préférence formation d'une valeur moyenne de courte durée, extrapolation ou conversion.

c) en particulier **en ce qu'**une valeur d'approximation pour le courant de collecteur ($i_c$) est déterminée à partir d'une tension grille-émetteur ($v_{GE}$, $v_{Ge}$), d'une intégrale par rapport au temps d'un courant de grille ($i_G$) ou d'une intégrale par rapport au temps d'une tension d'induction ($v_{Le}$) au moyen d'une inductance d'émetteur (LE) et,

d) en particulier **en ce qu'**une valeur d'approximation pour une tension grille-émetteur ($v_{GE}$, $v_{ge}$) est déterminée à partir d'une intégrale par rapport au temps d'un courant de grille ($i_G$).

**8.** Procédé selon l'une des revendications précédentes, **caractérisé en ce que**, pour réduire un écart de réglage entre une valeur réelle et la valeur de consigne spécifique d'une variable d'état primaire ($v_c$, $dv_c/dt$, $i_c$, $di_c/dt$)

a) une valeur de consigne modifiée ($V_c^{ref}$, $dv_c^{ref}/dt$, $i_c^{ref}$, $di_c^{ref}/dt$) est prédéfinie sur la base de l'écart de réglage pour au moins une phase A, B, A0, B0 de l'opération de commutation actuelle ou d'une opération de commutation consécutive et

b) en particulier **en ce qu'**une valeur estimative pour l'écart de réglage est déterminée de préférence sur la base d'une amplification de régulateur (kp) du pilote de grille (GT), d'une capacité grille-collecteur ($C_\mu$), d'une transconductance ($g_m$) du commutateur de puissance à semi-conducteur ($S_1$-$S_4$) et d'une inductance de fuite globale ($L_\sigma$).

**9.** Procédé selon l'une des revendications précédentes, **caractérisé en ce que**, pour générer le signal de réglage ($i_G$, $v_G$) pour la borne de commande (G)

a) on utilise comme valeur de consigne une fonction de valeur de consigne ($v_c^{ref}(t)$, $dv_c^{ref}(t)/dt$, $i_c^{ref}(t)$, $di_c^{ref}(t)/dt$) variable dans le temps et/ ou

b) des valeurs de mesure d'une variable d'état primaire et éventuellement d'une variable d'état secondaire ($v_c$, $dv_c/dt$, $i_c$, $di_c/dt$, $i_G$, $v_G$, $di_G/dt$, $dv_G/dt$) sont enregistrées en continu pendant l'opération de commutation transitoire et sont ramenées au pilote de grille (GT).

**10.** Procédé selon l'une des revendications précédentes, **caractérisé en ce que**

a) la variable d'état ($v_c$, $dv_c/dt$, $i_c$, $di_c/dt$) primaire du commutateur de puissance à semi-conducteur ($S_1$-$S_4$) est une tension collecteur-émetteur ($v_{CE}$ ; $v_{Ce}$, $v_{cE}$, $v_{ce}$) ou une tension collecteur-grille ($v_{CG}$ ; $v_{Cg}$, $v_{cG}$, $v_{cg}$) et

b) une variation dans le temps de la fonction de valeur de consigne spécifique de tension ($v_{CE}^{ref}(t)$, $v_{CG}^{ref}(t)$) est prédéfinie de telle sorte que le gradient du courant de collecteur $di_c/dt$ et le gradient de tension collecteur-émetteur $dv_{CE}/dt$ du commutateur de puissance à semi-conducteur ($S_1$-$S_4$) sont réglés respectivement dans la phase A et dans la phase B et

c) en particulier **en ce qu'**une fonction de valeur de consigne de tension ($v_{CE}^{ref}(t)$, $v_{CG}^{ref}(t)$) par endroits linéaire et de préférence trapézoïdale est prédéfinie.

**11.** Procédé selon la revendication 10, **caractérisé en ce que**

a) une variation d'amplitude ($\Delta v_{CE}$, 104) de la fonction de valeur de consigne de tension ($v_{CE}^{ref}(t)$, $v_{CG}^{ref}(t)$) est prédéfinie dans la phase A de façon proportionnelle au gradient du courant de collecteur $di_c/dt$ à commander et
b) une valeur maximale du gradient de la fonction de valeur de consigne de tension ($dv_{CE}^{ref}(t)/dt$, $dv_{CG}^{ref}(t)/dt$, 106) est prédéfinie dans la phase B de façon proportionnelle au gradient de tension collecteur-émetteur $dv_{CE}/dt$ à commander.

**12.** Procédé selon l'une des revendications 10-11, **caractérisé en ce que**

a) un gradient moyen et/ou une variation d'amplitude globale de la fonction de valeur de consigne de tension ($v_{CE}^{ref}(t)$, $v_{CG}^{ref}(t)$) dans la phase B est/sont au moins deux fois plus grande(s) que dans la phase A et/ou
b) dans la phase A, une valeur d'une variation d'amplitude (101-105, 108-109) de la fonction de valeur de consigne de tension ($v_{CE}^{ref}(t)$, $v_{CG}^{ref}(t)$) est adaptée en fonction d'un courant de charge ($i_L$) dans le circuit de puissance (2), d'une forme d'une variation dans le temps du courant de collecteur ($i_c$), d'une température de la diode de roue libre ($D_S$) et/ou d'un comportement à la coupure d'un courant ou d'une tension ($v_{AK}$) sur la diode de roue libre ($D_S$).

**13.** Procédé selon l'une des revendications 10-12, **caractérisé en ce que**

a) pour raccourcir l'opération de connexion dans la phase A, au moins un grand saut d'amplitude (103) et par la suite un saut d'amplitude (105) plus petit et orienté dans le sens contraire de la fonction de valeur de consigne de tension ($v_{CE}^{ref}(t)$, $v_{CG}^{ref}(t)$) sont prédéfinis et/ou
b) pour limiter un courant de grille ($i_G$) nécessaire lors d'une opération de connexion dans la phase B, une valeur du gradient de tension collecteur-émetteur $|dv_{CE}/dt|$ est réglée dans une plage (107) de faibles tensions collecteur-émetteur ($v_{CE}$), par rapport à une plage (106) de tensions collecteur-émetteur ($v_{CE}$) élevée.

**14.** Procédé selon l'une des revendications 10 à 13, **caractérisé en ce que**

a) une phase A0 selon la revendication 2 est implémentée par la spécification d'un petit saut d'amplitude (101) de la fonction de valeur de consigne de tension ($v_{CE}^{ref}(t)$, $v_{CG}^{ref}(t)$) et/ou
b) une phase B0 selon la revendication 3 est initialisée par la spécification d'une valeur minimale de la fonction de valeur de consigne de tension ($v_{CE}^{ref}(t)$, $v_{CG}^{ref}(t)$).

**15.** Procédé selon l'une des revendications 10 à 14, **caractérisé en ce que**

a) lors d'une opération de connexion dans la phase A, au moins deux valeurs réelles, enregistrées à un intervalle de temps défini, du courant de collecteur ($i_c$) sont mesurées ou approchées et une grandeur de correction ($\Delta\Delta v_{CE}$) est calculée à partir d'un écart de réglage par rapport à la valeur de consigne du gradient de courant de collecteur $di_c/dt$ pour déterminer une fonction de valeur de consigne de tension ($v_{CE}^{ref'}(t)$, $v_{CG}^{ref'}(t)$) modifiée et/ou
b) lors d'une opération de déconnexion dans la phase A, une fonction de valeur de consigne de tension ($v_{CE}^{ref'}(t)$, $v_{CG}^{ref'}(t)$) modifiée est prédéfinie avec une valeur ($\Delta\Delta v_{CE}$, 108) réduite temporairement pour réduire un dépassement de la tension collecteur-émetteur ($v_{CE}$).

**16.** Procédé selon l'une des revendications 10-15, **caractérisé en ce que**

a) une première valeur réelle est déterminée et ramenée de façon proportionnelle à la tension collecteur-émetteur ou la tension collecteur-grille ($v_{CE}$, $v_{CG}$) et au moins une seconde valeur réelle est déterminée et ramenée de façon proportionnelle au gradient de tension collecteur-émetteur ou au gradient de tension collecteur-grille ($dv_{CE}/dt$, $dv_{CG}/dt$),
b) à partir de la première valeur réelle et d'une valeur de consigne correspondante, on détermine un premier écart de réglage normé et à partir d'au moins une seconde valeur réelle et d'une valeur de consigne spécifique, on détermine au moins un second écart de réglage normé et
c) on utilise un maximum d'une valeur des écarts de réglage pour générer le signal de réglage ($i_G$, $v_G$).

**17.** Procédé selon l'une des revendications précédentes, **caractérisé en ce que**

a) un instant de séparation ($t_1$, $t_2$) entre les phases A et B est détecté et

b) en particulier **en ce que**, pour déterminer l'instant de séparation ($t_1$, $t_2$), on analyse un critère principal et en option un critère supplémentaire pour une variable d'état primaire et/ou secondaire mesurée ou approchée ($v_c$, $dv_c/dt$, $i_c$, $di_c/dt$, $i_G$, $v_G$, $di_G/dt$, $dv_G/dt$) du commutateur de puissance à semi-conducteur ($S_1$-$S_4$).

**18.** Procédé selon la revendication 17, **caractérisé en ce que**, lors d'une opération de connexion pour déterminer l'instant de séparation ($t_1$, $t_2$), on utilise comme critère principal le fait que

a) $|V_{AK}| > \varepsilon_{AK}$, $V_{AK}$ étant une tension sur la diode de roue libre ($D_S$) et $\varepsilon_{AK}$ étant une première valeur de seuil prédéfinissable et/ ou

b) $|di_c/dt| < \varepsilon_{dic}$, en particulier $|V_{Le}|/L_e < \varepsilon_{dic}$, $v_{Le}$ étant une tension d'induction par rapport à une inductance d'émetteur $L_e$ et $\varepsilon_{dic}$ une seconde valeur de seuil prédéfinissable, en particulier le fait que, lors d'une violation consécutive de ce critère principal, une détection de l'instant de séparation ($t_1$, $t_2$) n'est pas annulée, et/ou

c) $|\Delta v_c| > \varepsilon vC$, $\Delta v_c$ étant une variation d'amplitude de la tension collecteur-émetteur ($V_{CE}$ ; $V_{Ce}$, $V_{cE}$, $V_{ce}$) et $\varepsilon_{vC}$ étant une troisième valeur de seuil prédéfinissable et/ou

d) $|dv_c/dt| > \varepsilon_{dvc}$, $\varepsilon_{dvc}$ étant une quatrième valeur de seuil prédéfinissable et/ou

e) $|i_G| < \varepsilon_{iG}$, $i_G$ étant le courant de grille et $\varepsilon_{iG}$ étant une cinquième valeur de seuil prédéfinissable et/ou

f) $|dv_G/dt| < \varepsilon_{dvG}$, $d_{VG}/dt$ étant un gradient d'une tension grille-émetteur ($V_{GE}$ ; $V_{Ge}$, $V_{gE}$, $V_{ge}$) et $\varepsilon_{dvG}$ étant une sixième valeur de seuil prédéfinissable et/ou

g) $|V_G| < |V_{Gmax}|^*\varepsilon_{vGmax}$, $v_{Gmax}$ étant une valeur maximale de la tension grille-émetteur ($V_{CG}$ ; $V_{Cg}$, $v_{cG}$, $V_{cg}$) et $\varepsilon_{vGmax}$ étant une septième valeur de seuil prédéfinissable et/ou

h) $t_1 > t_M$ ou $t_2 > t_M$, $t_M$ étant une durée maximale à partir du démarrage de l'opération de commutation et/ou

i) une variation d'une valeur réelle d'une variable d'état ($v_c$, $dv_c/d_t$, $i_c$, $di_c/dt$, $i_G$, $v_G$, $di_G/dt$, $dv_G/dt$) étant détectable, en particulier le fait que $|\Delta v_c| > \varepsilon_{vC}^*\varepsilon_1$, $\varepsilon_{vC}$ étant une troisième valeur de seuil prédéfinissable et $\varepsilon_1 < 1$ une constante.

**19.** Procédé selon la revendication 2 et l'une des revendications 17-18, **caractérisé en ce que**

a) une tension $V_{AK}$ sur la diode de roue libre ($D_S$) est approchée selon une équation $V_{AK} = -\delta v_{CE}+V_{AKf}+K^*V_{Le}$ par la mesure ou l'évaluation d'une tension d'induction $V_{Le}$ selon une inductance d'émetteur $L_e$ et une tension de flux $V_{AKf}$ de la diode de roue libre ($D_S$) dans la phase A0, $\delta v_{CE}$ étant une variation d'amplitude de la tension collecteur-émetteur dans la phase A par rapport à la phase A0 et K étant une constante de proportionnalité et

b) en particulier **en ce que** K= -($L_\sigma$-$L_C$)$L_e$, $L_\sigma$ = $L_C$+$L_e$+$L_S$ représentant l'inductance globale d'un circuit de puissance (2), $L_C$ l'inductance de collecteur, $L_e$ l'inductance d'émetteur et $L_S$ l'inductance de fuite du circuit de puissance (2), ou **en ce que** K est une constante de proportionnalité pouvant être prédéfinie selon une valeur estimative pour $V_{AK}$.

**20.** Procédé selon l'une des revendications 17 à 19, **caractérisé en ce que**, comme critère supplémentaire pour la validation du critère principal pour l'instant de séparation ($t_1$, $t_2$), on utilise le fait que

a) $|v_G| > \varepsilon v_G$ avec $\varepsilon v_G > v_T$, $v_G$ étant la tension grille-émetteur ($v_{GE}$ ; $v_{Ge}$, $v_{gE}$, $v_{ge}$), $v_T$ une tension de seuil pour une conductibilité du commutateur de puissance à semi-conducteur ($S_1$-$S_4$) et $\varepsilon_{vG}$ une huitième valeur de seuil prédéfinissable et/ou

b) $|i_c| > \varepsilon_{iC}$, $i_C$ étant un courant collecteur et $\varepsilon_{iC}$ une neuvième valeur de seuil prédéfinissable et/ou

c) $t_1 > t_m$ ou $t_2 > t_m$, $t_m$ étant une durée minimale à partir du déclenchement de l'opération de commutation.

**21.** Procédé selon l'une des revendications précédentes, **caractérisé en ce que**

a) un paramètre de réglage ($k_p$, $c_1$-$c_5$, f, $S_M$, $S_m$) du procédé de réglage est adapté par incréments discrets ou de façon continue sur la base de valeurs mesurées ou de valeurs d'approximation d'une variable d'état ($v_c$, $dv_c/dt$, $i_c$, $di_c/dt$, $i_G$, $v_G$, $di_G/dt$, $dv_G/dt$) primaire et/ou secondaire et/ou sur la base d'une valeur empirique d'un signal de réglage ($i_G$, $v_G$) idéal et

b) en particulier **en ce que** le paramètre de réglage ($k_p$, $S_M$, $S_m$, $c_1$-$c_5$, f) est une amplification de régulateur ($k_p$), une limite ($S_M$) supérieure ou une limite ($S_m$) inférieure pour le signal de réglage ($i_G$, $v_G$) ou un facteur de réaction ($c_1$-$c_5$) ou une fonction de réaction (f) pour la réinjection de la valeur réelle.

**22.** Procédé selon l'une des revendications, **caractérisé en ce qu'**une fonction d'amplification de régulateur ($k_p(t)$) variable dans le temps est prédéfinie ou commandée de telle sorte que

a) une amplification du régulateur ($k_p$) pour le signal de réglage ($i_G$, $v_G$) est choisie grande pendant une opération de connexion transitoire au début de la phase A et est réduite ensuite et/ou choisie petite au début de la phase B et est augmentée ensuite et/ou

b) une amplification du régulateur ($k_p$) pour le signal de réglage ($i_G$, $v_G$) est choisie grande pendant une opération de déconnexion transitoire au début de la phase B et est réduite ensuite et/ou est choisie petite au début de la phase A et est augmentée ensuite.

**23.** Procédé selon la revendication 22, **caractérisé en ce que**

a) la fonction d'amplification de régulateur ($k_p(t)$) est modifiée par paliers dans le cas d'une grande amplification de régulateur ($k_p$) et est modifiée de préférence de façon continue dans le cas d'une faible amplification de régulateur ($k_p$) et/ou

b) l'amplification de régulateur ($k_p$) est choisie maximale dans une phase A0 ou B0 selon l'une des revendications 2 à 3.

**24.** Procédé selon la revendication 21 et l'une des revendications précédentes, **caractérisé en ce que**, pour la limitation des oscillations du signal de réglage ($i_G$, $v_G$)

a) une limite ($S_M$) supérieure et/ou une limite ($S_m$) inférieure pour une valeur du signal de réglage ($|i_G|$, $|v_G|$) est choisie grande au début de la phase A pendant une opération de connexion transitoire et est réduite ensuite et/ou est choisie petite au début de la phase B et est ensuite augmentée et/ ou

b) une limite ($S_M$) supérieure et/ou une limite ($S_m$) inférieure pour une valeur du signal de réglage ($|i_G|$, $|v_G|$) est choisie grande au début de la phase B pendant une opération de déconnexion transitoire et est réduite ensuite et/ou est choisie petite au début de la phase A et est augmentée ensuite et

c) en particulier **en ce que** la limite ($S_M$) supérieure et/ou la limite ($S_m$) inférieure est/sont choisie(s) maximale(s) lors d'une phase A0 ou B0 selon l'une des revendications 2 à 3.

**25.** Procédé selon la revendication 24, **caractérisé en ce que**

a) une courbe dans le temps pour une limite ($S_M$) supérieure et/ou pour une limite ($S_m$) inférieure d'une valeur d'un courant de grille ($|i_G|$) est approchée au moins en partie dans la phase A de façon proportionnelle à $t_A^{-0,5}$ et dans la phase B de façon proportionnelle à $t_B^2$, $t_A$, $t_B$ étant des variables de temps pour les phases A, B, et

b) la limite ($S_M$) supérieure et/ou la limite ($S_m$) inférieure est commandée par un minimum dans la plage d'un instant de séparation ($t_1$, $t_2$) des phases A et B.

**26.** Procédé selon l'une des revendications précédentes, **caractérisé en ce que**

a) une bande de tolérance est prédéfinie pour au moins une variable d'état primaire ($v_c$, $dv_c/dt$, $i_c$, $di_c/dt$), à l'aide d'une fonction de valeur de consigne supérieure et d'une fonction de valeur de consigne inférieure et

b) une valeur réelle des variables d'état ($v_c$, $dv_c/dt$, $i_c$, $di_c/dt$) est maintenue à l'intérieur de la bande de tolérance par un signal de réglage et/ou un signal de commande ($i_G$, $v_G$) pulsé pour la borne de commande (G)

**27.** Procédé selon la revendication 26, **caractérisé en ce que**, lors d'une opération de déconnexion, on passe après la phase A dans une phase C dans laquelle, lors d'un rapprochement d'une tension de collecteur ($v_c$) d'une valeur maximale ($v_{cmax}$) prédéfinissable, une tension de grille ($v_G$) est augmentée par au moins une impulsion de courant de grille ($i_G$) positive et une impulsion de courant de grille ($i_G$) négative pour une durée définie au-dessus d'une valeur de seuil ($v_T$) jusqu'à ce que la tension de collecteur ($v_c$) baisse jusqu'à une valeur minimale ($v_{cmin}$) prédéfinissable.

**28.** Procédé selon l'une des revendications précédentes, **caractérisé en ce que**, pour une opération de connexion ou de déconnexion d'un circuit série de $i=1...n$ commutateurs de puissance à semi-conducteur ($S_1$, $S_2$), la tension collecteur-émetteur ($v_{CE1}$, $v_{CE2}$) ou la tension collecteur-grille est réglée selon l'une des revendications 10 à 16 avec au moins une diode de roue libre ($D_S$) disposée en série sur au moins $n-1$ commutateurs de puissance à semi-conducteur ($S_1$, $S_2$).

**29.** Procédé selon la revendication 28, **caractérisé en ce que**, lors d'une opération de connexion du circuit série pour les commutateurs de puissance à semi-conducteur ($S_1$, $S_2$)

a) les phases A0 sont enclenchées selon la revendication 2 individuellement, en particulier de façon asynchrone et/ ou

b) dans la phase A, une partie principale d'une chute de tension globale induite sur une inductance de fuite du circuit série est attribuée par différents instants de commutation et/ou différentes modifications d'amplitude des fonctions de valeur de consigne de tension ($v_{CE}^{ref}(t)$, $v_{CG}^{ref}(t)$) à un commutateur de puissance à semi-conducteur ($S_2$) individuel ou

c) la phase A est enclenchée à un instant de commutation commun, lorsqu'une valeur réelle du gradient de courant de collecteur $di_c/dt$ et/ou du courant de collecteur ($i_c$) dépasse une valeur limite.

**30.** Procédé pour l'exploitation d'un circuit série de commutateurs de puissance à semi-conducteur ($S_1$, $S_3$, $S_4$) et de diodes de roue libre ($D_{P3}$, $D_{P4}$) disposées parallèlement à ces commutateurs dans deux branches d'un demi-pont d'un onduleur, **caractérisé en ce que**

a) une opération de connexion transitoire de la première branche de pont est réglée par le procédé de réglage selon l'une des revendications précédentes et

b) lors d'une opération de déconnexion simultanée de la seconde branche de pont, des tensions anodes-cathodes ($V_{AK}$) et/ou des puissances de perte des diodes de roue libre ($D_{P3}$, $D_{P4}$) de la seconde branche de pont sont limitées au moins partiellement et en particulier symétrisées, de sorte qu'au moins une diode de roue libre ($D_{P4}$) avec un gradient de tension ($dv_{AK4}/dt$) anodes-cathodes surélevé est identifiée et, dans un mode de réglage, le commutateur de puissance à semi-conducteur ($S_4$) parallèle et spécifique est fermé de façon temporaire et/ou de façon partielle en fonction du procédé de réglage.

**31.** Procédé selon la revendication 30, **caractérisé en ce que**

a) le mode de réglage est enclenché dès que la phase B est détectée dans le procédé de réglage et/ou

b) dans le mode de réglage, un signal de réglage ($i_G$, $v_G$) est prédéfini de telle sorte qu'une valeur du gradient de tension de collecteur $|dv_{C4}/dt|$ du commutateur de puissance à semi-conducteur ($S_4$) spécifique dans la seconde branche de pont ne dépasse pas une valeur limite $\varepsilon_{dv}$, en particulier $\varepsilon_{dv} = N/(n*(1 + E))$ avec N = un montant d'une valeur empirique du gradient de tension de collecteur $|dv_c/dt|$ de la première branche de pont, n = un nombre des diodes de roue libre ($D_{P3}$, $D_{P4}$) de la seconde branche de pont et E = ($dv_c/dt$ - $dv_c^{ref}/dt$) /$dv_c^{ref}/dt$ étant un écart de réglage normalisé du mode de réglage.

**32.** Procédé selon l'une des revendications 30-31, **caractérisé en ce que**

a) le mode de réglage n'est pas appliqué simultanément à toutes les diodes de roue libre ($D_{P3}$, $D_{P4}$) de la seconde branche de pont et/ou

b) pour une possibilité de connexion rapide du commutateur de puissance à semi-conducteur ($S_4$) spécifique dans la seconde branche de pont, une valeur moyenne de sa transconductance ($g_m$) supérieure à zéro est respectée.

**33.** Pilote de grille (GT) pour un commutateur de puissance à semi-conducteur ($S_1$-$S_4$), **caractérisé en ce que** le pilote de grille (GT) présente des moyens pour la mise en oeuvre du procédé selon l'une des revendications 1 à 32.

**34.** Pilote de grille (GT) pour un commutateur de puissance à semi-conducteur ($S_1$-$S_4$), en particulier approprié pour la mise en oeuvre du procédé selon l'une des revendications 1 à 32, comprenant des moyens de mesure et d'analyse (3, 9) pour au moins une variable d'état primaire ($v_c$, $dv_c/dt$, $i_c$, $di_c/dt$) d'un commutateur de puissance à semi-conducteur ($S_1$), un générateur de valeur de consigne (4), un élément de comparaison valeur réelle-valeur de consigne (6) et un amplificateur (7) pour générer un signal de réglage ($i_G$, $v_G$) pour une borne de commande ou une grille (G) du commutateur de puissance à semi-conducteur ($S_1$), **caractérisé en ce que**

a) le générateur de valeur de consigne (4) comporte un premier générateur (41) pour générer une première valeur de consigne ($v_c^{ref}$), avec laquelle dans une phase A, au cours de laquelle une diode de roue libre ($D_S$) montée en série avec le commutateur de puissance à semi-conducteur ($S_1$) est dans un état conducteur, le signal de réglage ($i_G$, $v_G$) est adapté pour le réglage d'un gradient du courant de collecteur $di_c/dt$ du commutateur de puissance à semi-conducteur ($S_1$) et

b) le générateur de valeur de consigne (4) comporte un second générateur (42) pour générer une seconde valeur de consigne ($dv_c^{ref}/dt$), avec laquelle, dans une phase B, dans laquelle la diode de roue libre ($D_S$) est dans un état de blocage, le signal de réglage ($i_G$, $v_G$) est adapté pour le réglage d'un gradient de tension collecteur-émetteur $dv_{CE}/dt$ du commutateur de puissance à semi-conducteur ($S_1$).

**35.** Pilote de grille (GT) selon la revendication 34, **caractérisé en ce que**

a) les moyens de mesure et d'analyse (3, 9) comportent un contrôle de signal (9) et un générateur de valeur réelle (3) pour une tension de collecteur ($v_{CE}$, $v_{CG}$) et un gradient de tension de collecteur ($dv_{CE}/dt$, $dv_{CG}/dt$) du commutateur de puissance à semi-conducteur ($S_1$),
b) le premier générateur (41) est conçu pour générer une variation d'amplitude de tension de collecteur ($v_{CE}^{ref}$, $v_{CG}^{ref}$) et le second générateur (42) pour générer un gradient de tension de collecteur ($dv_{CE}^{ref}/dt$, $dv_{CG}^{ref}/dt$) et
c) en particulier **en ce que** le générateur de valeur de consigne (4) présente des moyens pour calculer toutes les valeurs de consigne ($v_C^{ref}$, $dv_C^{ref}/dt$) à partir d'une fonction de valeur de consigne de tension ($V_{CE}^{ref}(t)$, $V_{CG}^{ref}(t)$) commune et prédéfinissable.

**36.** Pilote de grille (GT) selon l'une des revendications 34-35, **caractérisé en ce que**

a) le générateur de valeur réelle (3) comporte un élément de différenciation (31) pour la formation de gradient de valeurs réelles et un élément de sommation (32) pour l'addition pondérée de valeurs réelles et de gradients de valeurs réelles ou
b) le générateur de valeur réelle (3) et le générateur de valeur de consigne (4) comportent un générateur de valeur extrême (12) pour déterminer un maximum de valeurs d'écarts de réglage normés selon la revendication 16.

**37.** Pilote de grille (GT) selon l'une des revendications 34 à 36, **caractérisé en ce que**

a) le pilote de grille (GT) présente des moyens de détection (5, 10) pour la détection d'un instant de séparation ($t_1$, $t_2$) entre les phases A et B selon l'une des revendications 17 à 20 et
b) en particulier **en ce que** les moyens de détection (5, 10) présentent un contrôle de signal (10) et une unité de calcul (5), l'unité de calcul (5) comportant un commutateur de valeur seuil (51) pour un critère principal selon la revendication 18 et en option un générateur (52) pour un critère supplémentaire et un élément de validation (53) selon la revendication 20.

**38.** Pilote de grille (GT) selon l'une des revendications 34 à 37, **caractérisé en ce que**

a) le pilote de grille (GT) présente un enregistrement de signal (9) pour la ré-imputation de valeurs réelles d'au moins une variable d'état secondaire ($i_G$, $v_G$, $di_G/dt$, $dv_G/dt$, $dv_C/dt$) à au moins un niveau de sortie (7a, 7b) de l'amplificateur (7) et/ou
b) le pilote de grille (GT) présente des moyens pour l'adaptation de paramètres de réglage ($k_p$, $c_1$-$c_5$, f, $S_M$, $S_m$), en particulier une amplification de régulateur ($k_p$), une limite ($S_M$) supérieure ou une limite ($S_m$) inférieure pour le signal de réglage ($i_G$, $v_G$) ou un facteur de réaction ($c_1$-$c_5$) ou une fonction de réaction (f) pour un contrôle de signal (9) d'une variable d'état ($v_c$, $dv_C/dt$, $i_C$, $di_C/dt$, $i_G$, $v_G$, $di_G/dt$, $dv_G/dt$), primaire et/ou secondaire, selon l'une des revendications 21 à 25.

**39.** Pilote de grille (GT) selon l'une des revendications 34 à 38, **caractérisé en ce que** l'amplificateur (7)

a) est un amplificateur de courant (7) pour un courant de grille ($i_G$) et/ou
b) présente plusieurs niveaux de sortie (7a, 7b).

**40.** Pilote de grille (GT) pour un commutateur de puissance à semi-conducteur ($S_1$-$S_4$), en particulier selon l'une des revendications 33 à 39, comprenant un amplificateur (7) avec au moins un niveau de sortie (7a, 7b) pour générer un signal de réglage ($i_G$, $v_G$) pour une borne de commande ou une grille (G) d'un commutateur de puissance à semi-conducteur ($S_1$) **caractérisé en ce que** le niveau de sortie (7a, 7b) de l'amplificateur (7)

a) présente au moins une première source de courant (L) commandable de façon linéaire pour générer de petits courants de grille ($i_G$) avec un faible écart de réglage et une grande stabilité de réglage et
b) présente au moins une seconde source de courant (N) commutable de façon parallèle, contrôlable de façon non linéaire ou par paliers pour générer de grands courants de grille ($i_G$) avec une grande dynamique de réglage.

**41.** Pilote de grille (GT) selon la revendication 40, **caractérisé en ce que**

a) la première source de courant (L) est répartie en plusieurs premières partitions (L1-L4) logiques et/ou physiques et/ou

b) la seconde source de courant (N) est répartie en plusieurs secondes partitions (N1-N4) logiques et/ou physiques et/ou

c) le pilote de grille (GT) présente une commande de structure (11) pour l'activation de la première et/ou de la seconde source de courant (L, N) et/ou de partitions (L1-L4, N1-N4) de la première et/ou de la seconde source de courant (L, N) et

d) en particulier **en ce que** la commande de structure (11) est reliée à un contrôle de signal (9) pour la réinjection d'une valeur réelle d'une variable d'état ($v_c$, $dv_c/dt$ $i_c$, $di_c/dt$, $i_G$, $v_G$, $di_G/dt$, $dv_G/dt$) primaire et/ou secondaire.

**42.** Pilote de grille (GT) selon la revendication 40, **caractérisé en ce que** la commande de structure (11), en particulier pour la mise en oeuvre du procédé selon l'une des revendications 21 à 25, est conçue de telle sorte que

a) au cours de la première phase B ou A d'une opération de commutation, les secondes partitions (N1-N4) peuvent être déconnectées de façon successive et ensuite les premières partitions (L1-L4) peuvent de façon successive être réglées de façon descendante et/ou déconnectées,

b) au cours de la seconde phase B ou A d'une opération de commutation, les premières partitions (L1-L4) peuvent de façon successive être réglées de façon croissante et/ou connectées et ensuite les secondes partitions (N1-N4) peuvent être connectées de façon successive et

c) en particulier **en ce que**, dans les phases A0 et B0 selon les revendications 2-3, toutes les partitions (L1-L4, N1-N4) peuvent être activées.

**43.** Pilote de grille (GT) selon l'une des revendications 41-42, **caractérisé en ce que** la commande de structure (11) est conçue de telle sorte que

a) une variation dans le temps d'une valeur d'un courant de grille ($|i_G|$) est commandée approximativement dans la phase A de façon proportionnelle à $t_A^{-0,5}$ et dans la phase B de façon proportionnelle à $t_B^2$, $t_A$, $t_B$ étant des variables de temps pour les phases A, B,

b) la valeur du courant de grille ($|i_G|$) est commandée dans la plage d'un instant de séparation ($t_1$, $t_2$) des phases A et B par un minimum.

**44.** Pilote de grille (GT) selon la revendication 41, **caractérisé en ce que** la commande de structure (11) est conçue en particulier pour la mise en oeuvre du procédé selon l'une des revendications 26-27 de telle sorte qu'un courant de grille ($i_G$) pulsé peut être généré par la connexion et la déconnexion de secondes et/ou de premières partitions (L1-L4, N1-N4).

**45.** Pilote de grille (GT) selon l'une des revendications 40 à 44, **caractérisé en ce que**

a) la première source de courant (L1-L4) comporte une cascade linéaire d'agencements de niveau de courant de transistors ($T_5$-$T_6$) et/ou

b) la seconde source de courant (N1-N4) comporte un agencement de niveau de transistors ($T_{10}$-$T_{11}$), une grille d'un transistor de sortie ($T_{11}$) de l'agencement de niveau pouvant être commutée entre deux potentiels et/ou

c) un élément de comparaison (6) valeur réelle-valeur de consigne présente selon l'une des revendications 33 à 39 pour l'activation rapide des sources de courant (L, N) un agencement de niveau de courant de transistors ($T_3$, $T_4$) et est réparti en particulier en troisièmes partitions (EO-E3) de plusieurs agencements de niveau de courant.

**46.** Commutateur de puissance à semi-conducteur ($S_1$-$S_4$) avec un pilote de grille (GT) selon l'une des revendications 33 à 45 pour l'activation d'une borne de commande ou d'une grille (G) du commutateur de puissance à semi-conducteur ($S_1$-$S_4$).

**47.** Commutateur de puissance à semi-conducteur ($S_1$-$S_4$) selon la revendication 46, **caractérisé en ce que** le commutateur de puissance à semi-conducteur ($S_1$-$S_4$)

a) est un IGBT, un MOSFET, un BJT ou une combinaison de IGBTs, MOSFETs et/ou BJTs et/ou

b) présente des moyens pour le contrôle de valeurs de mesure de variables d'état ($v_c$, $dv_c/dt$, $i_c$, $di_c/dt$, $i_G$, $v_G$, $di_G/dt$, $dv_G/dt$) primaires et/ou secondaires.

**48.** Agencement de plusieurs commutateurs de puissance à semi-conducteur ($S_1$-$S_4$) selon l'une des revendications 46-47.

**49.** Agencement de plusieurs commutateurs de puissance à semi-conducteur ($S_1$-$S_4$) selon la revendication 48, **caractérisé en ce que**

a) l'agencement est un montage série, un montage parallèle, ou un montage série de montages parallèles et/ou

b) l'agencement est un module de commutateur, en particulier un redresseur, pour la traction, la transmission de courant continu à haute tension, un radio-émetteur, un réchauffement inductif ou un soudage inductif.

Fig. 1

Fig. 2

Fig. 3

Fig. 4

Fig. 5

Fig. 6

Fig. 7

Fig. 8

Fig. 9

24-01-200

39

Fig. 10

**Fig. 11**

**Fig. 12**

**Fig. 13**

**Fig. 14**

**Fig. 15**

**Fig. 16a**

**Fig. 16b**

**Fig. 16c**

**IN DER BESCHREIBUNG AUFGEFÜHRTE DOKUMENTE**

**In der Beschreibung aufgeführte Patentdokumente**

- EP 0797301 A

**In der Beschreibung aufgeführte Nicht-Patentliteratur**

- **H. RÜEDI et al.** Dynamic Gate Controller (DGC) - A new IGBT Gate Unit for High Current/High Voltage Modules. *PCIM'95 (Official Proceedings of the International Power Conversion,* 1995, 241-249